# EUROPEAN PATENT SPECIFICATION

(11) **EP 0 344 497 B1**
(45) Date of publication and mention of the grant of the patent: **14.08.1996**
(21) Application number: 89108635.7
(22) Date of filing: 12.05.1989
(51) Int. Cl.: G06F 17/50, G06F 9/44

(54) **Design procedure supporting method and system**
Verfahren und System zur Unterstützung von Entwurfsverfahren
Méthode et système d'aide à la procédure de conception

(30) Priority: 13.05.1988 JP 114679/88
(43) Date of publication of application: 06.12.1989
(73) Proprietor: HITACHI, LTD., Chiyoda-ku, Tokyo 101 (JP)
(72) Inventor: Nonaka, Shiro, Hitachi-shi (JP); Ishida-Tomotoshi, Katsuta-shi (JP); Kawashima, Yasumasa, Hitachi-shi (JP); Minami, Shunsuke, Hitachi-shi (JP); Nio, Misato, Hitachi-shi (JP)
(74) Representative: Beetz & Partner Patentanwälte

(56) References cited:
- EP-A- 0 218 258
- 5 TH INTERNATIONAL CONFERENCE ON SOFTWARE ENGINEERING 9-12 MARCH 1981 SAN DIEGO IEEE US pages 325 - 332; FUTAMURA ET AL: 'DEVELOPMENT OF COMPUTER PROGRAMS BY PROBLEM ANALYSIS DIAGRAM (PAD)'

## Description

The present invention relates to a design procedure supporting system and method according to the independent claims. The described technique is aided by a computer. More particularly, the invention is concerned with design procedure supporting method and system suited profitably for management of records concerning procedures through which designs have been made, utilization of the design procedure and/or generation thereof.

For managing the records concerning preparation of the design procedures, it is conventionally practiced to structurize or represent the design procedure in the form of a flow of processings, i.e. what types of design processings are executed in what sequence. In this conjunction, it has already been proposed, as discussed, for example, in "Computer Software" published by the Japan Society Of Software Science, Vol. 1, No. 1 (1984), pp. 64-77 to adopt as a method of describing the flow of processings a problem analysis diagram (or PAD in abbreviation), wherein the contents of the descriptions are stored and made use of in a computer to realize the management or control and utilization of the design procedures.

As the similar method for description of the design procedure, there may be mentioned flow charts, NS charts and others.

In the prior art describing methods, description of the design procedure is a main concern for the description of a data processing flow, and expression of the relations among the design data is not easy. Consequently, difficulty is encountered in making decision as to the dependence relation among the design data themselves or between given design data and a given data processing. Further, because the description of the data flow is basically sequential, some artificial sequence relation needs to be provided between those data processings which inherently bear neither dependency relation nor sequential relation to each others, presenting thus another cause for making difficult the decision concerning the presence or absence of the dependence relation.

Additionally, in the case where a plurality of design procedures are available and the design procedure to be actually adopted is selected from the available procedures, there arises a problem that the management of only the design procedure to be actually executed is insufficient and inadequate for examining the other design procedures, particularly when the check or re-examination of the design prosedures is necessitated because of alteration or modification of the design procedure.

An object of the present invention is to solve the problems mentioned above and realize such efficient management or control of the design procedures that they can be easily maintained, altered or modified or applied for practical purposes.

This object is solved in accodance with the features of the independent claims. Dependent claims are directed on preferred embodiments of the invention.

The above object can be achieved by storing, in addition to the sequence in which the design data are actually executed, the names of the design data, the names of the data processings and the information representing the relations between the design data and the data processing in a computer to thereby aid or support the design procedure.

The names of design data and the names of design processings are stored in a computer together with the input/output relation information representing the input/output relations between the design data and the data processings. Accordingly, by providing means for retrieving the name of the data processing from the name of the data processing from the names of the design data and the input/output relation information and means for retrieving the names of the design data from the names of the data processings and the input/output relation information and by using repeatedly both the means mentioned above, it is possible to determine availably the direct and indirect dependence relations among the design data themselves, among the data processings themselves or between the design data and the data processings, whereby influences accompanying the addition, deletion or alteration of the design procedure can easily be examined. Besides, by comparing the dependence relation between the data processings as determined with the sequence of the data processings to be executed actually, possibility of alteration of the data processing sequence as well as possibility of parallel processings can be examined as well.

By storing not only the name of the design data and the processings and the information of the input/output relations therebetween which are relevant to the design procedure to be actually executed but also those relevant to the possible design procedures which may possibly be executed, examination of the influences accompanying the addition, deletion or alteration (modification) of the design procedure as mentioned above can be extended so as to cover both the range of the actually executed design procedures and the range of the possibly executed design procedures.

The names of the design data, the names of the data processings and the information representing the input/ output relations between the design data and the data processing are stored in addition to the sequence of the data processings to be actually executed, wherein there are provided means for retrieving the names of the data processings from the names of the design data and the information representing the input/output relations and means for retrieving the names of the design data from the names of the data processings and the input/output relation information. Accordingly, by using repeatedly both the means mentioned above, there can be determined availably the direct and indirect relations among the design data themselves, among the data processings themselves or between the design data and the data processings, whereby examination of the influences accompanying the addition, deletion or alteration of the design procedure can easily be carried out to great advantage.

Further, by comparing the dependence relations among the determined data processings with the sequence of the data processings to be executed actually, not only the possibility of alteration of the sequence in which the data processings are executed but also the possibility of parallel processings can easily be examined to another advantage.

Because the names of the design data, the names of the data processings and the information representing the input/output relations therebetween are stored independent of the design procedure to be executed actually, the contents of storage can be extended not only to those participating in the design procedure to be actually executed but also to those relevant to the possible design procedures which may possibly be executed. By virtue of this feature of the invention, examination of the influences possibly brought about by deletion, addition or alteration (modification) of the design procedure can be extended to cover not only the range of the design procedures to be actually executed but also the range of the design procedures which may possibly be executed to further advantage.
Fig. 1 is a functional block diagram showing, by way of example, a general arrangement of a computer-aided design procedure supporting system according to an embodiment of the present invention;
Fig. 2 is a flow chart for illustrating operation of the design procedure supporting system shown in Fig. 1;
Fig. 3 shows an exemplary structure of an input/output apparatus of the system shown in Fig. 1;
Figs. 4(a) to 4(e) are views for illustrating an exemplary method of generating the design data names, the data processing name and the input/output relation information;
Figs. 5(a) to 5(f) are views for illustrating, by way of example, a method of altering or modifying the design data names, the data processing names and the input/output relation information;
Figs. 6(a) to 6(c) are views for illustrating an exemplary method of generating a data processing execution sequence;
Fig. 7 is a view for illustrating an exemplary method of storing the design data names, the data processing names and the input/output relation information;
Figs. 8(a) and 8(b) are views for illustrating two methods, respectively, for storing the data processing execution sequence;
Figs. 9(a) to 9(d) show flow charts for illustrating operations of a name retrieving means shown in Fig. 1;
Figs. 10(a) to 10(f) are charts for illustrating operation of a design procedure output means shown in Fig. 1;
Fig. 11 illustrates an exemplary method of storing the results of retrieval in a retrieval result storage means shown in Fig. 1;
Fig. 12 is a block diagram showing a general arrangement of the design procedure supporting system according to an exemplary embodiment of the present invention;
Fig. 13 is a flow chart for illustrating operation of the system shown in Fig. 12;
Figs. 14(a) to 14(e) are views for illustrating a method of selecting the name of the data processing to be executed through an interactive input procedure with a designer;
Figs. 15(a) and 15(b) show, respectively, two examples of the methods of storing the names of the design data having the respective contents determined;
Fig. 16 is a functional block diagram showing a general arrangement of the design procedure supporting system according to another embodiment of the present invention;
Fig. 17 is a flow chart for illustrating the operation of the design procedure supporting system shown in Fig. 16;
Figs. 18(a) to 18(d) are views for illustrating operations of the embodiment shown in Fig. 16;
Figs. 19(a) to 19(e) show a design calculation procedure including a decision processing and performed by the system shown in Fig. 16;
Fig. 20 is a block diagram showing a general arrangement of the design procedure supporting system according to a further embodiment of the present invention;
Fig. 21 is a problem analysis diagram (PAD) for illustrating operation of the design procedure supporting system shown in Fig. 20;
Fig. 22 is a block diagram showing a general arrangement of the design procedure supporting system according to a further embodiment of the present invention;
Fig. 23 is a flow chart for illustrating operation of the system shown in Fig. 22;
Figs. 24(a) to 24(d) are views for illustrating operation of the design procedure supporting system shown in Fig. 22;
Fig. 25(a) to 25(c) show examples of the data processing the content of which is expressed in the form of a hierarchical structure;
Figs. 26(a) and 26(b) show an exemplary method of storing the design data names, the data processing names and the input/output relation information in the the case where the data processing assumes a hierarchical structure;
Fig. 27 is a view for illustrating an application of the design procedure supporting system according to an embodiment of the present invention to a design procedure for a shaft of turbine blades;
Figs. 28(a) to 28(g) show, by way of example, a method of generating the design data names, the data processing names and the input/output relation information in the case of the application shown in Fig. 27;
Fig. 29 shows an exemplary method of storing the design data names, the data processing names and the input/output relation information in the case of the abovementioned application;
Fig. 30(a) to 30(c) show an exemplary method of generating the data processing execution sequence in the application;
Figs. 31(a) and 31(b) show two exemplary methods of storing the data processing execution sequence in the application;
Figs. 32(a) to 32(h) are views for illustrating the operation of the design procedure output means shown in Fig. 1 in the case of the application;
Fig. 33 is a view illustrating a method of storing the results of retrieval in the case of the application;
Figs. 34(a) to 34(c) illustrate an exemplary method of adding newly the data processings to the data processing execution sequence stored already in the case of the application;
Fig. 35 shows an exemplary method of storing the additionally prepared data processing execution sequence;
Figs. 36(a) to 36(c) show a method of modifying or altering by deletion the design data names, the data processing names and the input/output relation information;
Fig. 37(a) to 37(c) show an exemplary method of altering by addition the design data names, the data processing names and the input/output relation inpormation;
Figs. 38(a) to 38(c) show an exemplary case where more detailed contents of a data processing is expressed in terms of design data names, a data processing name and input/output relation information in hierarchical structure;
Figs. 39(a) and 39(b) show another exemplary method of storing the design data names, the data processing names and the input/output relation information in the case where the further detailed contents of a data processing assumes a hierarchical structure;
Figs. 40(a) to 40(e) are views for illustrating a method of implementing a means for selecting the mame of the data processing to be executed through interaction with a designer;
Figs. 41(a) and 41(b) show two exemplary methods of storing the design data names having the respective content determined;
Figs. 42(a) to 42(d) are views for illustrating operation of the embodiment shown in Fig. 22;
Figs. 43(a) to 43(e) are views for illustrating operation involved in the design calculation procedure carried out by the embodiment shown in Fig. 16; and
Figs. 44(a) to 44(k) are views for illustrating operation for the design calculation procedure including the decision processings executed by the embodiment shown in Fig. 16.

Now, the invention will be described in detail in conjunction with preferred or exemplary embodiments thereof by reference to the accompanying drawings.

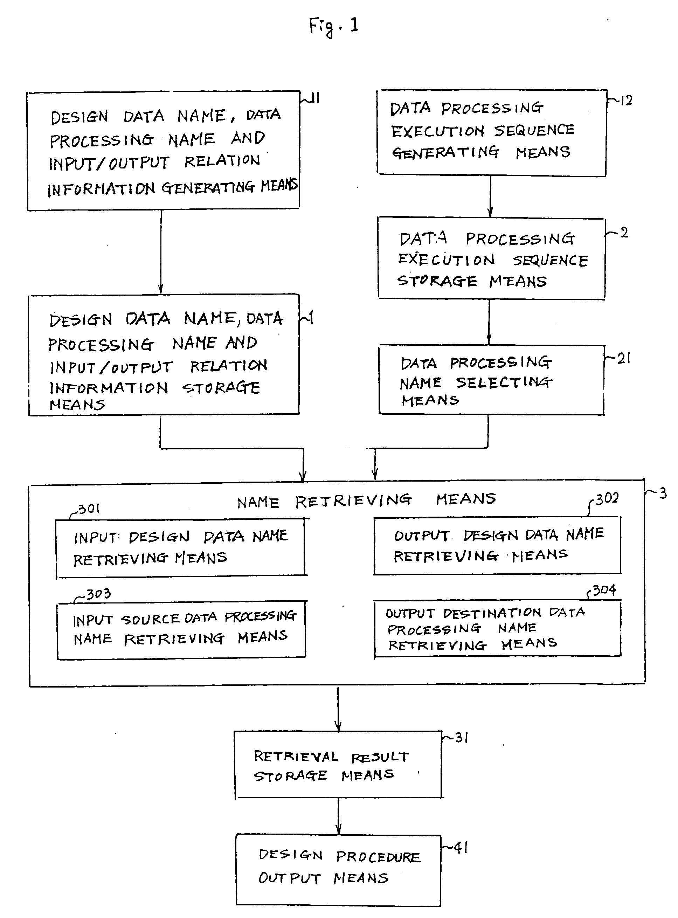

Fig. 1 is a functional block diagram showing a general arrangement of a computer-aided design procedure supporting system according to an exemplary embodiment of the present invention. In Fig. 1, a reference numeral 11 denotes a means or module for generating names of design data, names of data processings and information representing input/output relation therebetween, a numeral 12 denotes a means for generating a data processing execution sequence, a numeral 1 denotes a module or means for storing the design data names, the data processing names and the input/output relation information, a numeral 2 denotes a storage means for storing the data processing execution sequence, a numeral 21 denotes a data processing name selecting module or means, a numeral 3 denotes a name retrieving means, a numeral 31 denotes a retrieval result storing module or means, and a reference numeral 41 denotes a design procedure output module or means. The name retrieval module 3 is composed of an input design data name retrieving means 301, an output design data name retrieving means 302, an input source data processing name retrieving means 303 and an output destination data processing name retrieving means 304.

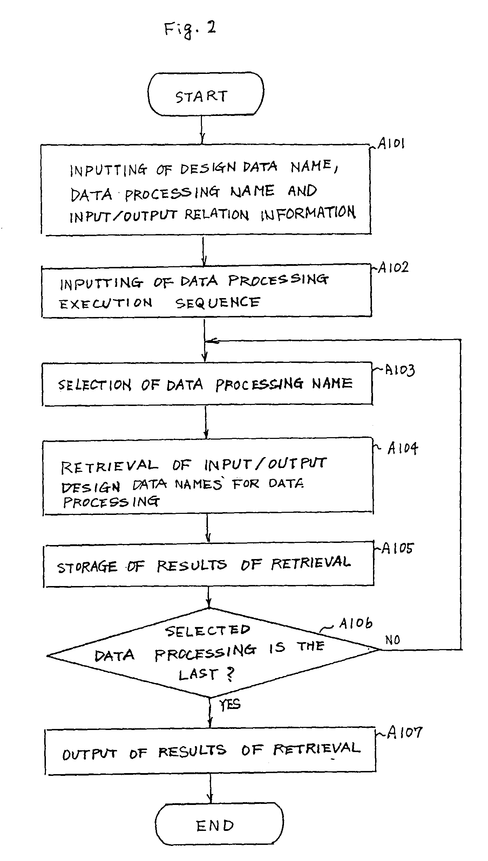

Fig. 2 is a flow chart for illustrating operation of the design procedure supporting system shown in Fig. 1. Referring to Fig. 2, at a step A101, the names of the design data, the names of the data processings and the information representing the input/output relations as generated by the design data name, data processing name and input/output relation information generating means are inputted to the storage module or means 1. Next, at a step A102, the data processing execution sequence generated by the data processing execution sequence generating means 12 is inputted to the storage means 2. Subsequently, at a step A103, the data processing means stored in the data processing execution sequence storage means 2 is selected by the data processing name select means 21. At a step A104, the design data names for the input and the output of the selected data processing stored in the design data name, data processing name and input/output relation storage means 1 are retrieved on the basis of the selected data processing name by the name retrieval means 3. Next, at a step A105, the results of the retrieval are stored in the retrieval result storage means 31. At a step A106, decision is made as to whether or not the data processing name as selected coincides with the name of the last data processing to be executed. If the coincidence is found, the processing proceeds to a step A107. Otherwise, a routine including the steps A103, A104 and A105 is repeated. At the step A107, the results of the retrieval stored in the retrieval result storage means 31 is outputted through the design procedure output means 41.

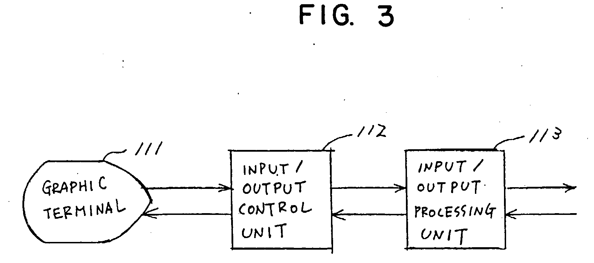

Fig. 3 shows an exemplary structure of an apparatus for implementing the design data name, data processing name and input/output relation information generating means 11, the data processing execution sequence generating means 12 and the design procedure output means 41 mentioned above in conjunction with Fig. 1. Referring to Fig. 3, a reference numeral 111 denotes a graphic terminal including a display means, 122 denotes an input/output control unit and a reference numeral 113 denotes an input/output processing unit. The information inputted through the graphic terminal 111 is supplied to the input/output processing unit 113 by way of the input/output control unit 112 and processed to provide the input information. On the other hand, the output information is processed by the input/output processing unit 113 and outputted to the graphic terminal 111 by way of the input/output control unit 112.

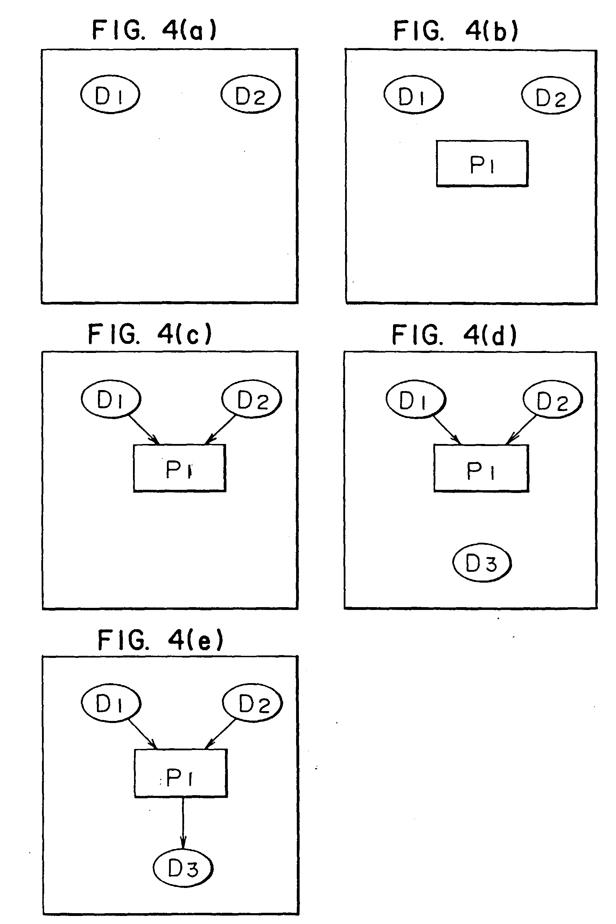

Figs. 4(a) to 4(e) are views for illustrating an exemplary method of generating the design data names, the data processing name and the input/output relation information by means of the design data name, data processing name and input/output relation information generating module 11 shown in Fig. 1. More specifically, Figs. 4(a) to 4(e) show the displays generated on the screen of the graphic terminal 111 shown in Fig. 3. In these graphs representing the network information, reference characters D1, D2 and D3 represent the names of design data, and D1 represents the name of data processing, respectively. In the case of the method illustrated in Figs. 4(a) to 4(e), it is assumed that the design data name D3 is to be outputted through the data processing executed on the input design data of the names D1 and D2. Elucidating a procedure involved in the generating method under consideration, the design data names D1 and D2 are defined and enclosed by ellipses, respectively, as shown in Fig. 4(a), to thereby indicate that the design data of these names constitute the data to be inputted. Subsequently, the data processing name P1 is defined and enclosed by a rectangle, as shown in Fig. 4(b), to thereby indicate that P1 is the name of the data processing to be inputted. Next, the data D1 and P1 as well as the data D2 and P1 are mutually linked by arrows (also referred to as arcs), as shown in Fig. 4(c), to thereby indicate that the design data D1 and D2 are the input data for the data processing P1. In other words, the arrows represent the arcs indicating the input and output of information or data, respectively. Next, the design data name D3 is defined and enclosed by an ellipse, as shown in Fig. 4(d), to indicate that D3 is the name of the design data. Subsequently, the data processing P1 and the design data D3 are linked by an arrow or arc, as shown in Fig. 4(e), to thereby indicate that the design data named D3 is the output resulting from the data processing named P1. The design data name, the data processing name and the input/output relation information thus obtained are stored in the design data name, data processing name and input/output relation information storage means 1 shown in Fig. 1.

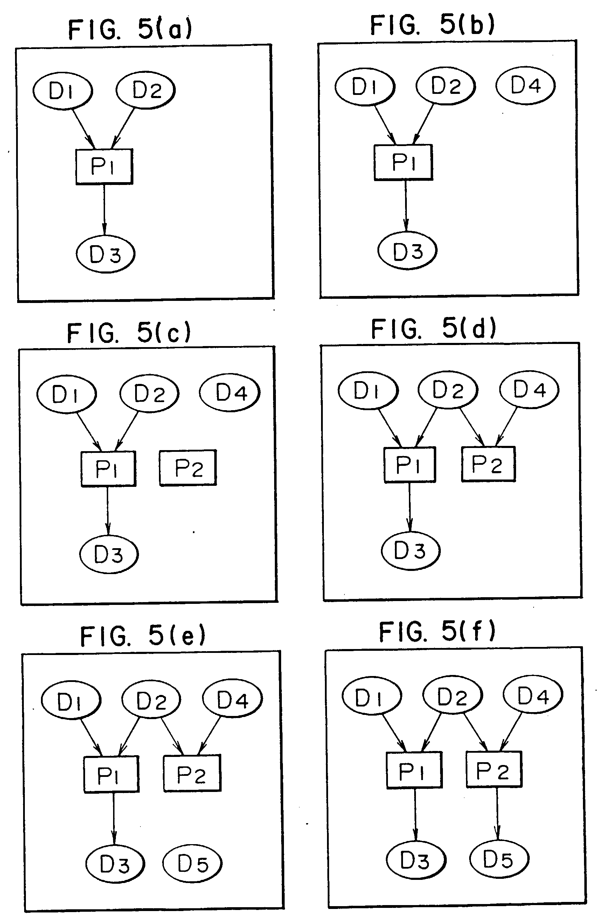

Figs. 5(a) to 5(f) are views for illustrating, by way of example, a method for addition and modification of the design data names, the data processing name and the input/output relation information performed by the design data name, data processing name and input/output relation information generating means 11 shown in Fig. 1. More specifically, Figs. 5(a) to 5(f) show displays generated on the screen of the graphic terminal 111 shown in Fig. 3, wherein D1, D2, D3, D4 and D5 represent the design data names, respectively, while P1 and P2 designate the data processing names, respectively. In the case of the method illustrated in Figs. 5(a) to 5(f), it is assumed that the data processing P2 is supplied with the design data D2 and D4 as the inputs for thereby outputting the design data D5. An exemplary embodiment of the generation method will now be described. Description made in conjunction with Fig. 4(e) applies true to Fig. 5(a). In succession, the design data name D4 is defined and enclosed by an ellipse, as. shown in Fig. 5(b), to thereby indicate that D4 is the name of the design data to be inputted. Next, the data processing named P2 is defined and enclosed by a rectangle, as shown in Fig. 5(c), to thereby indicate that P2 represents the data processing name. Subsequently, D2 and P2 as well as D4 and P2 are linked by arrows or arcs, respectively, as shown in Fig. 5(d), to indicate that the data named D2 and D4 are the inputs to the processing P2. Next, the design data name D5 is defined and enclosed by an ellipse, as shown in Fig. 5(e), to indicate that D5 is the design data name to be inputted. Referring to Fig. 5(f), the processing P2 and the data D5 are linked together by an arrow (arc) to indicate that the data D5 is the output resulting from the processing P2. Thus, the design data names, data processing names and input/output relation information modified by the addition as described above are stored in the design data name, data processing name and input/output relation information storage means 1 shown in Fig. 1.

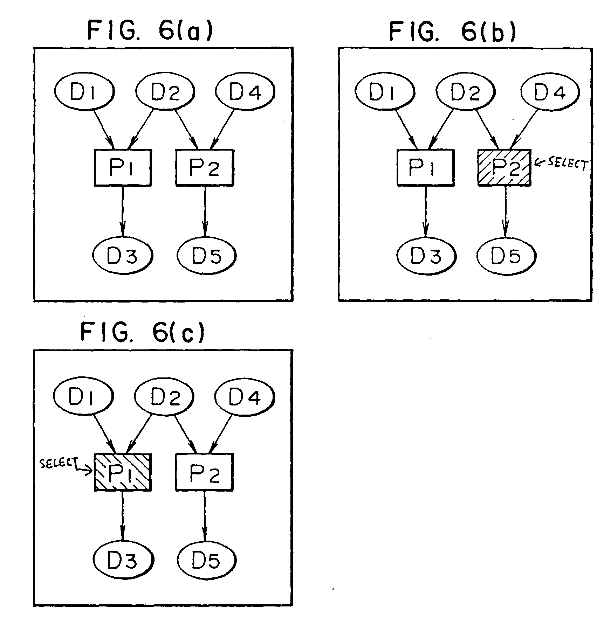

Figs. 6(a) to 6(c) are views for illustrating an exemplary method of generating a data processing execution sequence by the data processing execution sequence generating means 12 shown in Fig. 1. More specifically, Figs. 6(a) to 6(c) show displays generated on the screen of the graphic terminal 111 shown in Fig. 3, wherein D1, D2, D3, D4 and D5 represent the names of the design data, respectively, while P1 and P2 represent the names of the data processing, respectively. It is assumed that such data processing execution sequence that the first data processing is P2 with the second data processing being P1 is to be generated, starting from the state shown in Fig. 5(f). Description will now be made of a procedure for carrying out this generation method. Fig. 6(a) is same as Fig. 5(f). Starting from the state shown in Figs. 6(a) and 5(f), the data processing name P2 is selected, as shown in Fig. 6(b). Subsequently, the data processing name P1 is selected, as shown in Fig. 6(c). The sequence for executing the data processings thus determined is stored in the data processing execution sequence storage means 2. This method is advantageous in that no more than the selection of the data processing names is required for establishing the sequence for executing the data processings, since the data processing names as selected can be inputted in the order of the data processing execution sequence. Alternatively, there may be mentioned a method according to which such data is inputted which indicates where the data processing for the selected name of the data processing is to be executed in the execution sequence. This method is advantageous in that the sequence or order of selecting the data processing names can be determined independent of the data processing execution sequence.

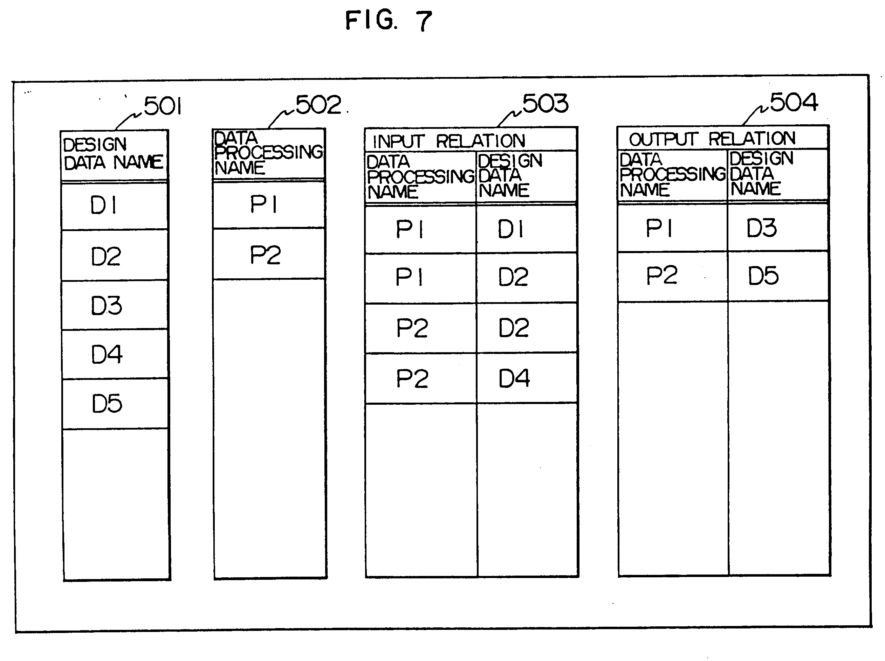

Fig. 7 illustrates an exemplary method of storing the design data names, the data processing name(s) and the input/output relation information in the design data name, data processing name and input/output relation information storing means 1 shown in Fig. 1. Referring to Fig. 7, reference numeral 501 denotes a design data name storing area, 502 denotes a data processing name storing area, 503 denotes an input relation storing area for storing the data processing and the input design data therefor, and a numeral 504 denotes an output relation storing area for storing the data processing and the output design data therefrom. In Fig. 7, reference characters D1, D2, D3, D4 and D5 represent the design data names, respectively, while P1 and P2 represent the data processing names, respectively, on the assumption that the design data names, the data processing names and the input/output relation information in the state shown in Fig. 5(f) are to be stored. The design data names generated by the design data name, data processing name and input/output relation information generating means 11 shown in Fig. 1 are stored in the design data name storing area 501, the data processing name as generated by the means 11 is stored in the data processing name storing area 502, the input relation is stored in the input relation storing area 503 in terms of the data processing name and the design data name bearing the input relation to the former, and finally the output relation is stored in the output relation storing area 504 in terms of the data processing name and the design data name bearing the output relation to the former.

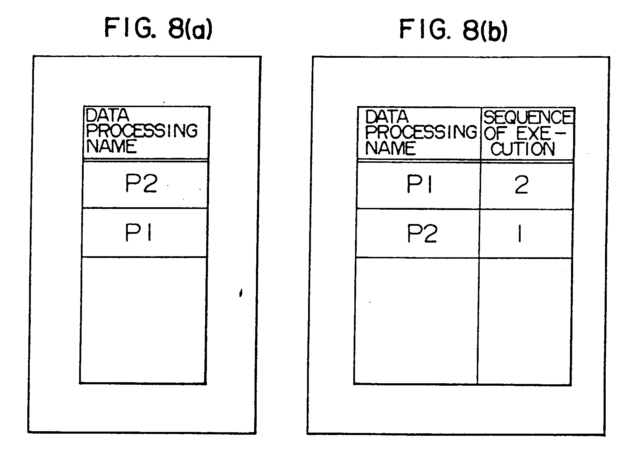

Figs. 8(a) and 8(b) illustrate two methods, respectively, for storing the data processing execution sequence in the data processing execution sequente storage means 2 shown in Fig. 1. In these figures, P1 and P2 designate the data processing names, respectively. In the methods illustrated in these figures, it is assumed that the data processing execution sequence in the state shown in Fig. 6(c) is to be stored. The data processing execution sequence generated by the data processing execution sequence generating means 12 shown in Fig. 1 is stored in terms of the data processing names and the sequence or order in which they are stored in the case of the method illustrated in Fig. 8(a), while the data processing execution sequence is stored in terms of sets of the data processing names and the order or sequence in which the relevant processings are executed in the case of the method illustrated in Fig. 8(b).

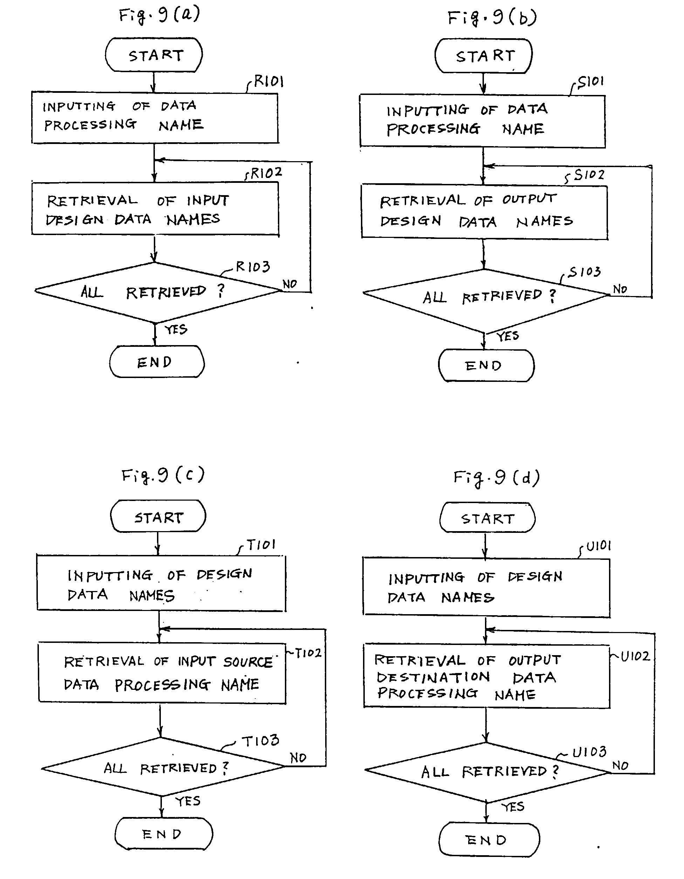

Figs. 9(a) to 9(d) show flow charts for illustrating operations of an exemplary embodiment implementing the name retrieval means 3 shown in Fig. 1. More specifically, Fig. 9(a) shows a procedure for retrieving (searching) the input design data names to be inputted for a particular data processing name, Fig. 9(b) shows a procedure for retrieving the output design data name for the particular data processing name, Fig. 9(c) shows a procedure for retrieving the name of the data processing to be inputted with the design data for a particular design data name, and Fig. 9(d) shows a procedure for retrieving the name of the data processing for generating as the output thereof the design data for the particular design data name. Referring to Fig. 9(a), the particular data processing name is inputted at a step R101. At a step A102, the input design data is retrieved from the input/output relation information stored in the design data name, data processing name and input/output relation information storage means 1 shown in Fig. 1. At a step R103, decision is made as to whether the design data of concern remains or not. So long as the relevant design data remains to be processed, the step R102 is repeated. When the design data is no more present, the processing comes to an end. Referring to Fig. 9(b), at a step S101, a particular data processing name is inputted. At a step S102, the relevant output design data name is retrieved from the input/output relation information stored in the design data name, data processing name and input/output relation information storage means 1 shown in Fig. 1. At a step S103, it is decided whether or not the relevant design data are present. If the data remains, the step S102 is repeated. Otherwise, the processing is terminated. Referring to Fig. 9(c), at a step T101, a particular design data name is inputted. At a step T102, the name of the data processing to be inputted with the design data of the inputted name is retrieved from the input/output relation information stored in the design data name, data processing name and input/output relation information storage means 1 shown in Fig. 1. At a step T103, decision is made as to whether the relevant data processing remains or not. If it remains, the step T102 is repeated. Otherwise, the data processing comes to an end. Referring to Fig. 9(d), at a step U101, a particular design data name is inputted. At a step U102, the name of the data processing for outputting the design data designated by the inputted name is retrieved from the input/output information stored in the design data name, data processing name and input/output relation information storage means 1 shown in Fig. 1. At a step U103, it is decided whether or not the relevant data processing exists or not. When it remains, the step U102 is repeated, while otherwise the processing comes to an end.

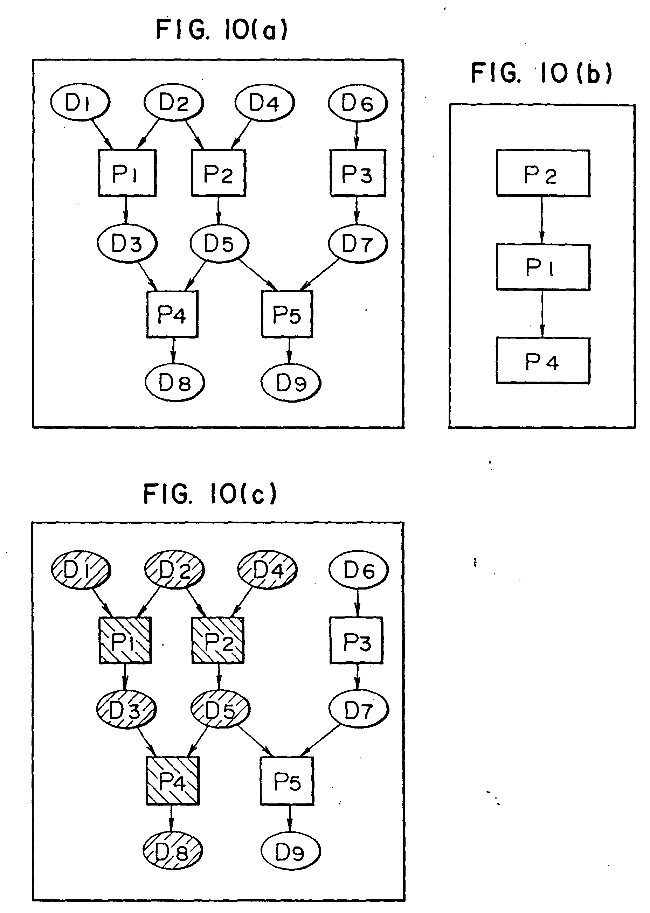

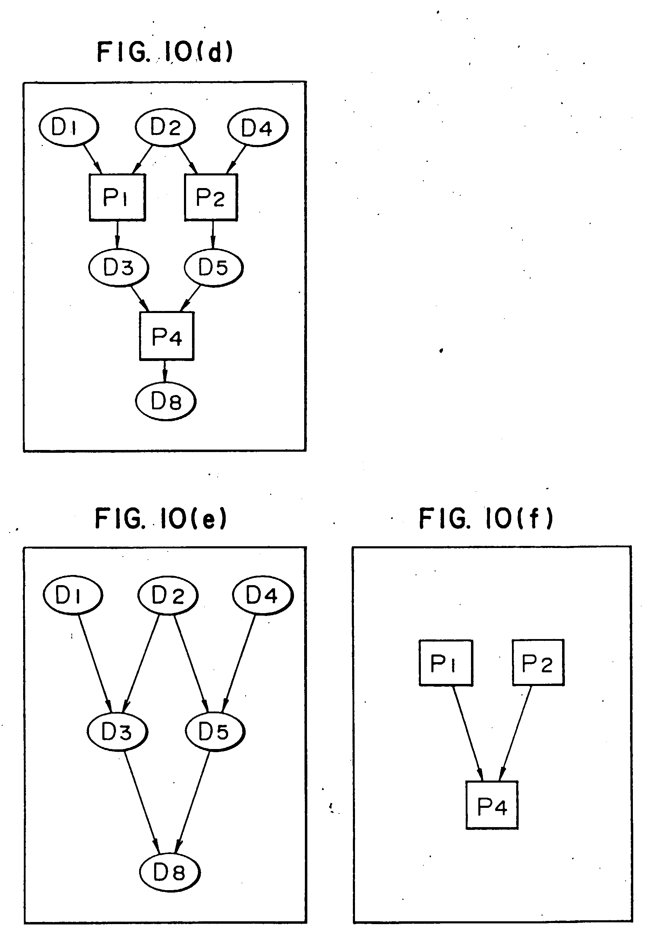

Figs. 10(a) to 10(f) are charts for illustrating operation of the design procedure output means 41 shown in Fig. 1. More particularly, Fig. 10(a) shows a network of the contents stored in the design data name, data processing name and input/output relation information storage means 1, and Fig. 10(b) shows in a chart the contents stored in the data processing execution sequence storage means shown in Fig. 1. In Figs. 10(a) to 10(f), D1 to D9 designate design data names and P1 to P5 designate the data processing names, respectively. Parenthetically, charts shown in Figs. 10(c) to 10(f) show the displays produced on the screen of the graphic terminal 111 shown in Fig. 3 and illustrate examples of the method for outputting those parts which participate in the actual design procedure based on the contents shown in Figs. 10(a) and 10(b). In Fig. 10(c), the design data names, the data processing names and the input/output information are shown in the form of a network configuration, wherein the parts participating in the actual procedure are distinctively indicated by hatching. In practical application, such discrimination may be realized, for example, by correspondingly changing the color for the display. The design procedure output method according to the illustrated embodiment is advantageous in that the positions or locations of those procedures executed actually can be readily recognized. Fig. 10(d) shows in the form of a network a display of only the design data names, the data processing names and the input/output relation information that actually participate in the procedure. This display method is advantageous in that the parts actually participating in the procedure can be expressed in a simplified form to enhance the understandability. Fig. 10(e) corresponds to Fig. 10(d) except that the data processing names are excluded and shows in terms of a network a display only of the design data name and the input/output relation information. This display method is advantageous in that examination of dependence relations among the design data can be facilitated. Fig. 10(f) corresponds to Fig. 10(d) except that the design data names are eliminated and shows in the form of a network a display only of the data processing names and the input/output relation information. The instant display method provides advantage in that the dependence relation among the data processings can easily be examined.

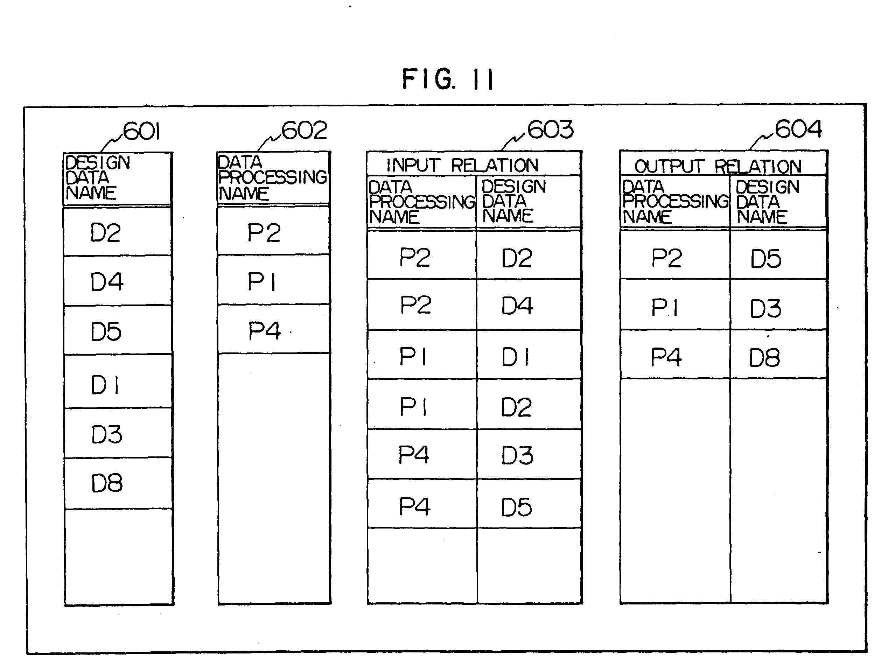

Fig. 11 illustrates an exemplary method of storing the results of retrieval in the retrieval result storage means 31 shown in Fig. 1. Referring to Fig. 11, reference numeral 601 denotes a design data name storing area, 602 denotes a data processing name storing area, 603 denotes an input/output relation storing area for storing a data processing and input design data therefor, and 604 denotes an output relation storing area for storing the data processing and output design data therefrom. In Fig. 11, reference symbols D1, D2, D3, D4, D5 and D8 represent the design data names, respectively, and P1, P2 and P4 represent the data processing names, respectively. In the case of the example illustrated in Fig. 11, it is assumed that the results of the retrieval for those parts which participate in the actual design procedure based on the contents shown in Fig. 10(a) and 10(b) are stored. The design data names retrieved through the name retrieval means 3 shown in Fig. 1 are stored in the design data name storing area 601, the names of the processings employed in carrying out the retrieval are stored in the data processing name storing area 602, the input relation used for the retrieval is stored in an input relation storing area 603 in terms of the data processing name and the design data name which are in the input relation to the former, and the output relation used in the retrieval is stored in an output relation storing area 604 in terms of the data processing name and the design data name which are in the output relation to the former.

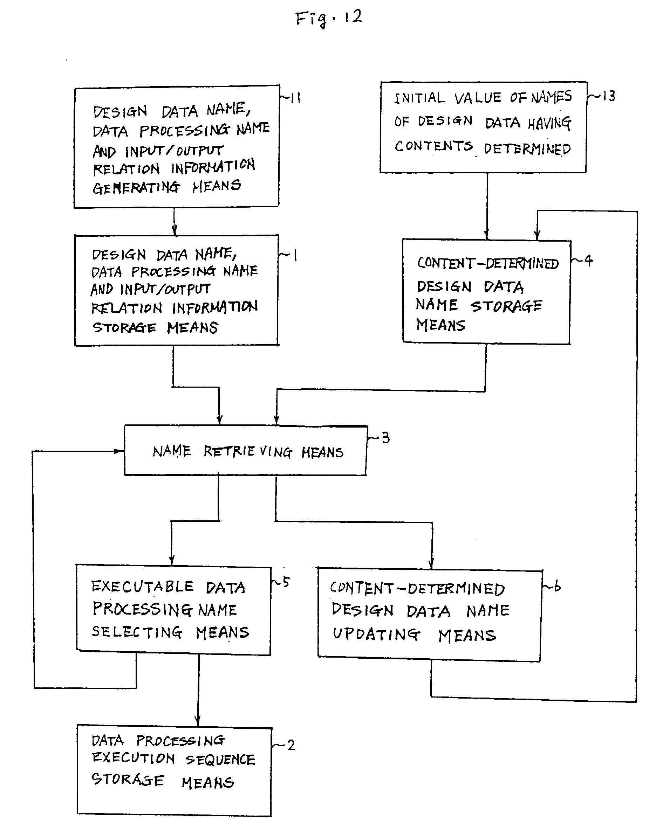

Fig. 12 is a block diagram showing an exemplary arrangement of the design procedure supporting system. Referring to Fig. 12, a reference numeral 11 denotes a design data name, data processing name and input/output relation information generating means, 13 denotes initial values of names of the design data whose contents have been determined, 1 denotes a design data name, data processing name and input/output relation information storage means, 4 denotes a means for storing the names of the design data of which contents have been determined, 3 denotes a name retrieving means, 5 denotes a means for selecting the name of the data processing to be executed, 2 denotes a data processing execution sequence storage means, and a numeral 6 denotes a means for updating the name of the design data of which contents have been determined.

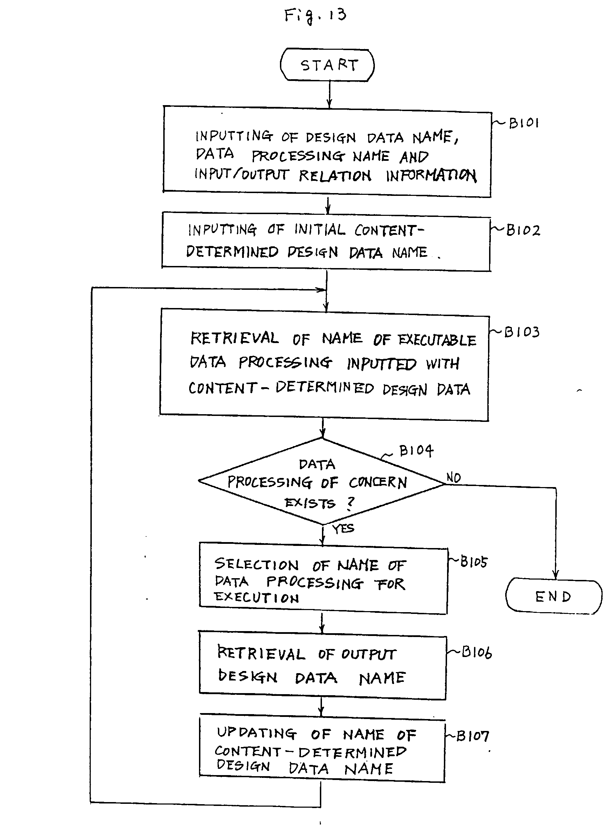

Fig. 13 is a flow chart for illustrating operation of the system shown in Fig. 12. Referring to Fig. 13 the design data means, the data processing name(s) and the input/output relation relevant information generated by the design data name, data processing name and input/output relation information generating means 11 shown in Fig. 13 are stored in the storage means 1 at a step B101. At a step B102, the initial values 13 of the design data names for which the contents have been determined are inputted to the content-determined design data name storage means 4. At a step B103, the names of the executable data processings for which all the input design data have been determined in respect to the contents are retrieved from the data processing names stored in the design data name, data processing name and input/output relation information storage means 1 with the and of the name retrieving means 3 on the basis of the content-determined design data names stored in the content-determined design data name storage means 4. At a step B104, decision is made as to whether the data processing of concern has been retrieved at the step B103. Unless the data processing of concern is available, the processing comes to an end. Otherwise, the processing proceeds to a step B105 where the name of the data a processing to be actually executed is selected from the names of the executable data processings retrieved by the executable data processing name selecting means 5, wherein the selected data processing name is stored in the data processing execution sequence storage means 2. At a step B106, the name of the design data which constitutes the output of the data processing stored in the design data name, data processing name and input/output relation information storage means 1 and selected by the name retrieving means 3 on the basis of the selected data processing name. At a step B107, the design data name retrieved by the content-determined design data name updating means 6 is stored in the content-determined design data name storage means 4 as the design data name having the contents determined. The processing then goes back to the step B103, whereon the routine including the steps B103 to B107 is repeated.

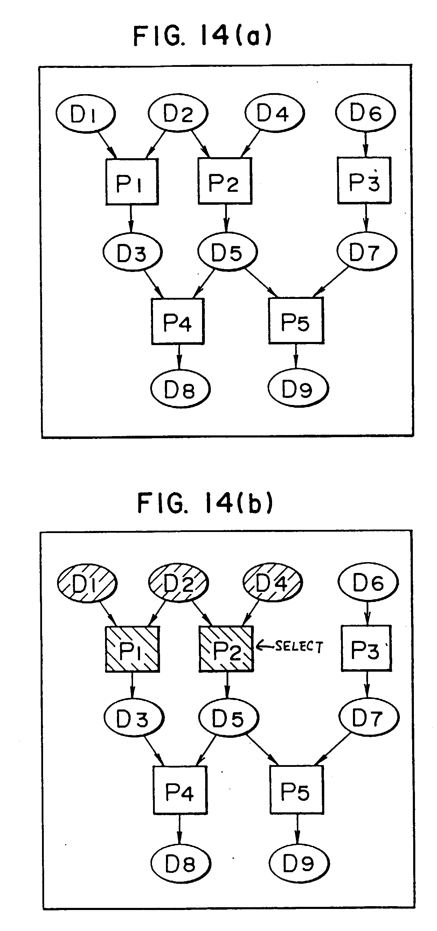

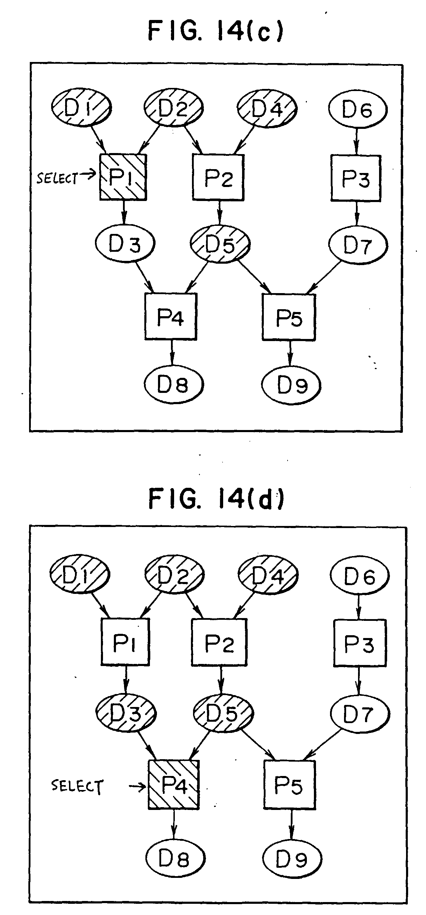

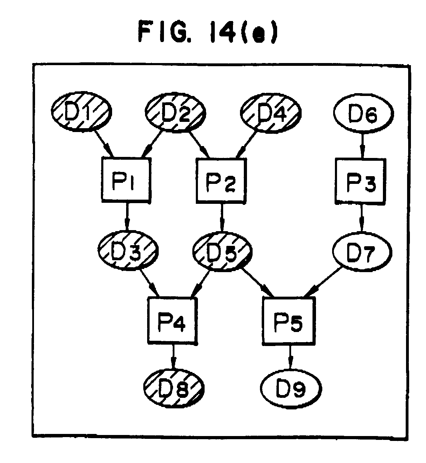

Figs. 14(a) to 14(e) illustrate a method of implementing the means 5 for selecting the name of the data processing to be executed shown in Fig. 12 through interactive input procedure with a designer. More specifically, Figs. 14(a) to 14(e) are views showing displays generated on the screen of the graphic terminal 111 shown in Fig. 3, wherein D1 to D9 designate the names of design data and P1 to P5 designate the names of data processings, respectively. The network information shown in Fig. 14(a) is stored in the design data name, data processing name and input/output relation information storage means. It is assumed that D1, D2 and D4 designate the names of the design data the initial contents or values of which have already been determined. A procedure of selection will be elucidated below. Fig. 14(a) shows the initial state before the names of the design data having the contents determined are inputted. In the state shown in Fig. 14(b), the names D1, D2 and D4 of the design data having the respective initial contents determined are inputted with the names P1 and P2 of the executable data processings being discriminatively displayed by hatching the objects to be retrieved. The design data whose contents have been determined are also distinctively displayed, as indicated by hatching. Starting from this state, the name P2 of the data processing to be actually executed is selected. In Fig. 14(c), the name P5 of the design data having the content determined by executing the data processing named P2 is added and displayed discriminatively. At this stage, the name P2 of the data processing which has been executed is excluded from the set of the executable data processing names. The executable data processing name is only P1. Accordingly, P1 is selected as the name of the data processing to be actually executed. In Fig. 14(d), there is additionally displayed distinctively the name D3 of the design data having the content determined as the result of execution of the data processing named P1 together with the retrieved name P4 of the executable data processing indicated discriminatively by hatching. Since the data processing named P1 has already been executed, this name P1 is excluded from the set of the executable data processing names. Thus, at this time, the name of the executable data processing is only P4. Accordingly, P4 is selected as the name of the data processing to be actually executed. In the display shown in Fig. 14(e), there is additionally displayed distinctively the name D8 of the design data whose content has been determined by executing the data processing named P4. The data processing name P4 is excluded from the set of names of the executable data processings, since the former has already been executed. At this time point, there is present no names of the executable data processings. Accordingly, this series of processings comes to an end. In the state where the whole processings have been completed, the sequence of executions of the data processings stored in the data processing execution sequence storage means 2 is in the order of P2, P1 and P4. In the foregoing description of the illustrated example, it has been assumed that the names of the data processings to be executed are selected through interaction with the designer. It should however be appreciated that such selection may be programmed as a procedure adapted to be automatically executed. By way of example, by adopting the existing sequence in which the procedure under consideration is stored in the data processing execution sequence storage means 2, it is possible to find out error in the existing sequence by making decision as to whether the names of the data processings selected in accordance with the existing sequence are included in the set of the names of the executable data processings.

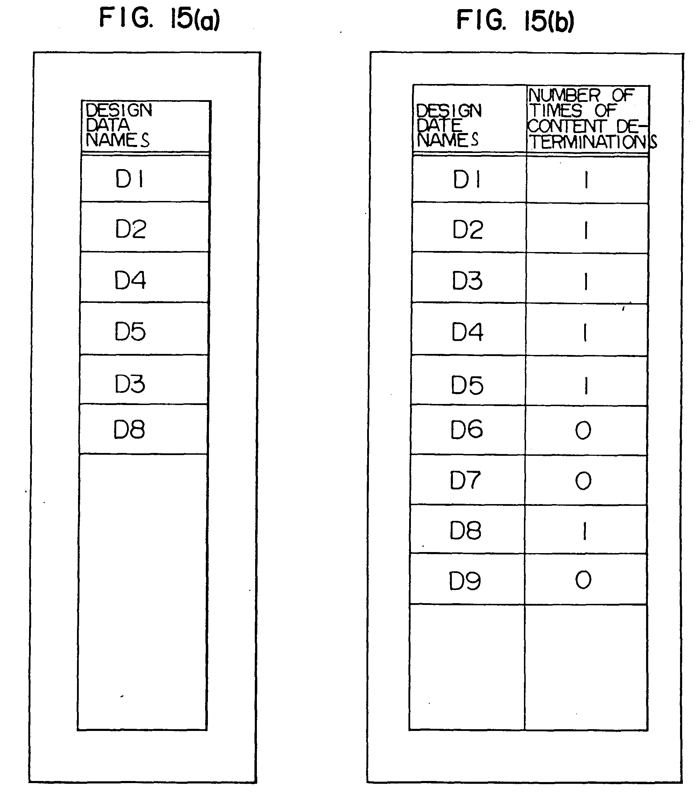

Figs. 15(a) and 15(b) show two methods of storing the names of the design data having the respective contents determined in the content-determined design data name storage means 4 shown in Fig. 12. In Figs. 15(a) and 15(b), D1 to D9 designate the names of the design data, and it is assumed that the names of the content-determined design data at the stage shown in Fig. 14(e). In the case of the example illustrated in Fig. 15(a), only the names of the content-determined design data are stored, while in the case of the method illustrated in Fig. 15(b), all the design data names and the numbers of times the contents of the design data have been determined are shown in pairs. Accordingly, the names of the design data whose contents have been determined more than once, inclusive, identify the names of the content-determined design data.

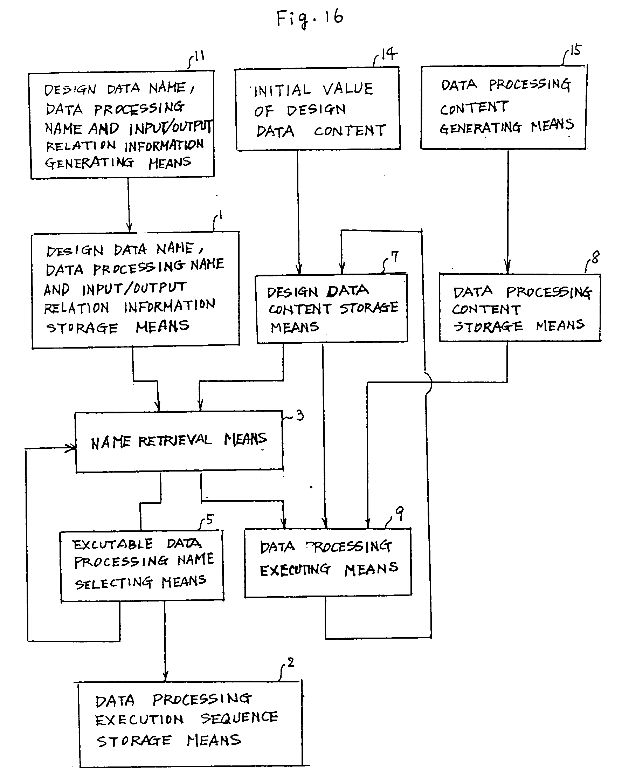

Fig. 16 is a functional block diagram showing a general arrangement of a design procedure supporting system according to another embodiment of the present invention. In Fig. 16, a reference numeral 11 denotes means for generating the design data names, data processing names and the input/output relation information, 14 denotes initial values of contents of the design data, 15 denotes a means for generating the contents of the data processings, 1 denotes a module or means for storing the design data names, the data processing names and the input/output relation information, 7 denotes a means for storing the contents of the deign data, 8 denotes a data processing content storage means, 3 denotes a name retrieving means, 5 denotes a means for selecting the names of the data processings to be executed, 2 denotes a data processing execution sequence storing means and a reference numeral 9 denotes a means for executing the data processings.

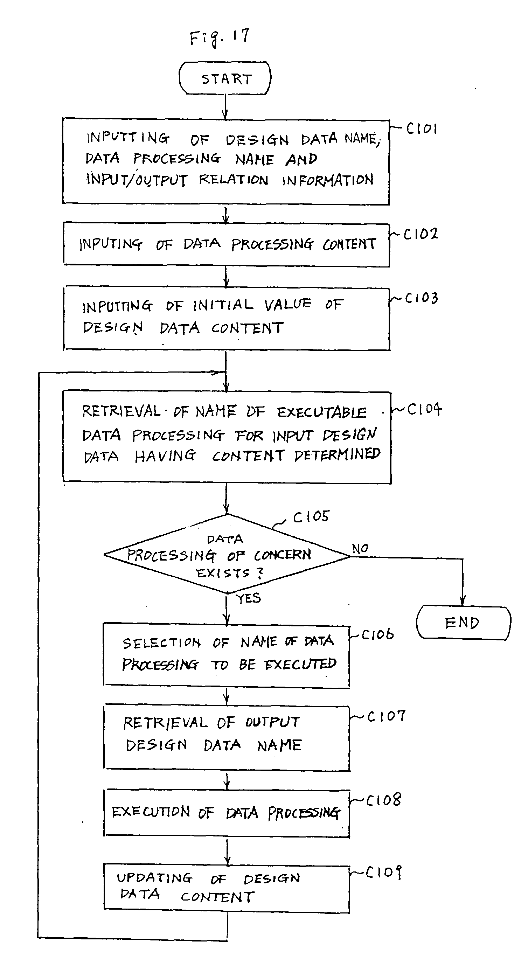

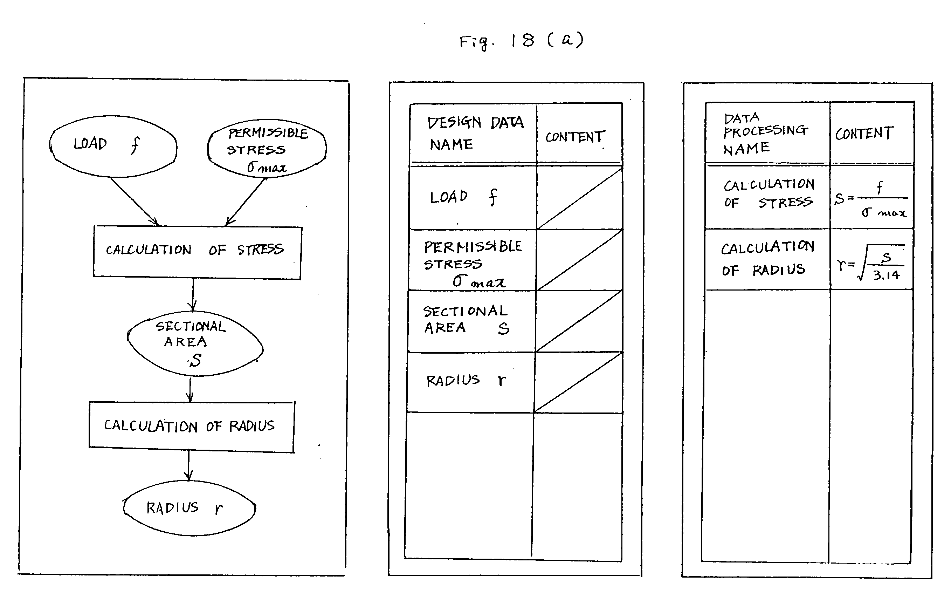

Fig. 17 is a flow chart for illustrating the operation of the design procedure supporting system shown in Fig. 16. Referring to Fig. 17, at a step C101, the names of the data processings and the information of input/output relations as generated by the design data name, data processing name and input/output relation information generating means 11 are inputted to the memory or storage module 1. At a step C102, the contents of the data processings generated by the data processing content generating means 15 is stored in the data processing content storage means 8. At a step C103, the initial value of the design data content is inputted to the design data content storage means 7. At a step C104, the name of the data processing stored in the design data name, data processing stored in the design data name, data processing name and input/output relation information storage means 1 for which the content of the input design data has already been determined and which can thus be executed is retrieved by the name retrieving means 3 on the basis of the design data name stored in the design data content storage means 7. At a step C105, decision is made as to the data processing of concern has been retrieved or not. When the data processing of concern is absent, the procedure comes to an end. Otherwise, a step C106 is executed. At the step C106, the name of the data processing which is to be actually executed is selected from the names of the executable data processings retrieved by the executable data processing name selecting means to be stored in the data processing execution sequence storage means 2. At a step C107, the name of the design data constituting the output of the data processing selected from those stored in the design data name, data processing name and input/output relation information storage means is retrieved by the name retrieving means 3 on the basis of the selected data processing names. At a step C108, the data processing is executed by the data processing executing means 9. At a step C109, the content resulting from the execution of the data processing is stored in the design data content storage means 7 as content of the retrieved design data name. The procedure then goes back to the step C104, whereon the routine of the steps C104 to C109 is repeated.

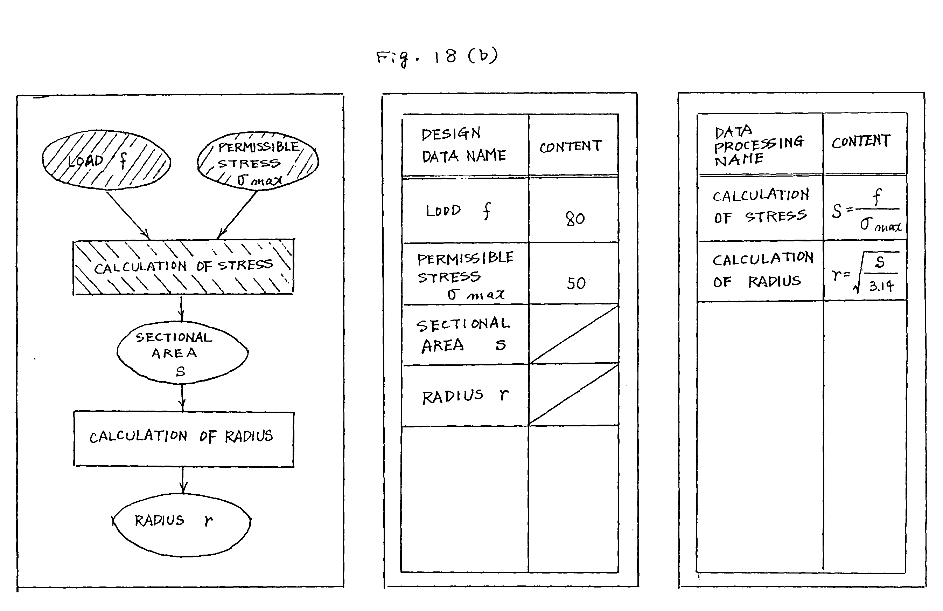

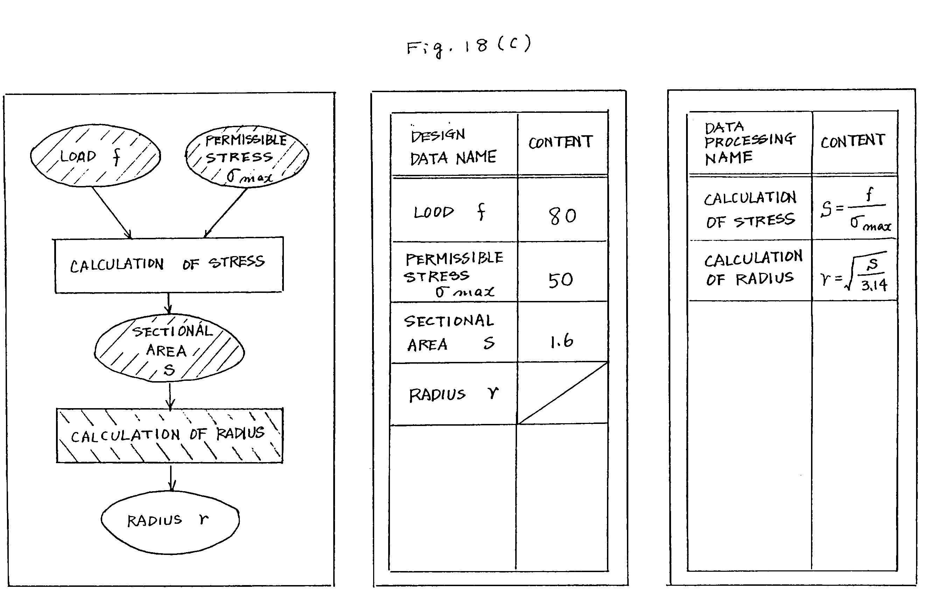

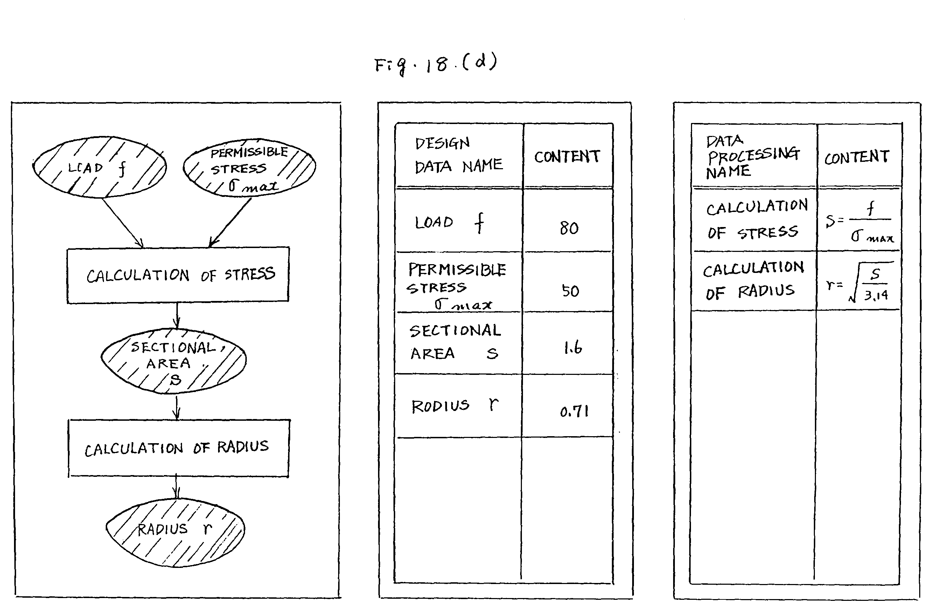

Figs. 18(a) to 18(d) show, by way of an example, a calculation process in the design procedure according to the embodiment shown in Fig. 16. More specifically, Figs. 18(a) to 18(d) are views showing displays generated on the screen of the graphic terminals shown in Fig. 3 together with the contents of the design data content storage means 7 shown in Fig. 16 and those of the data processing content storage means 8 shown in Fig. 16, respectively. In Figs. 18(a) to 18(d), the name enclosed by an ellipse designate the name of the design data, while the name enclosed by a rectangle designates the name of the data processing. In the case of the illustrative example shown in Figs. 18(a) to 18(d), design calculation of the radius of a shaft based on evaluation of stress is supposed, wherein a sectional area of the shaft is calculated in consideration of a load which the shaft is to bear and permissible stress, being followed by calculation of the radius from the sectional area. In Fig. 18(a), there is shown in the state in which the design data names, the data processing names and the input/output relation information have been inputted with the contents of the data processings also having been inputted. Referring to Fig. 18(b), the initial values of the contents of the design data are inputted, as the result of which the calculation of stress equivalent to the data processing is rendered executable. Referring to Fig. 18(c), the calculation of stress is executed by the data processing executing means 9 to thereby determine the content of the design data, i.e. the sectional area in this illustrative case. As the result of this, the radius calculation equivalent to the data processing can be executed. Referring to Fig. 18(d), the radius calculation is performed by the data processing execution means 9, whereby the content of the design data, i.e. the radius is determined, whereon the design procedure comes to an end.

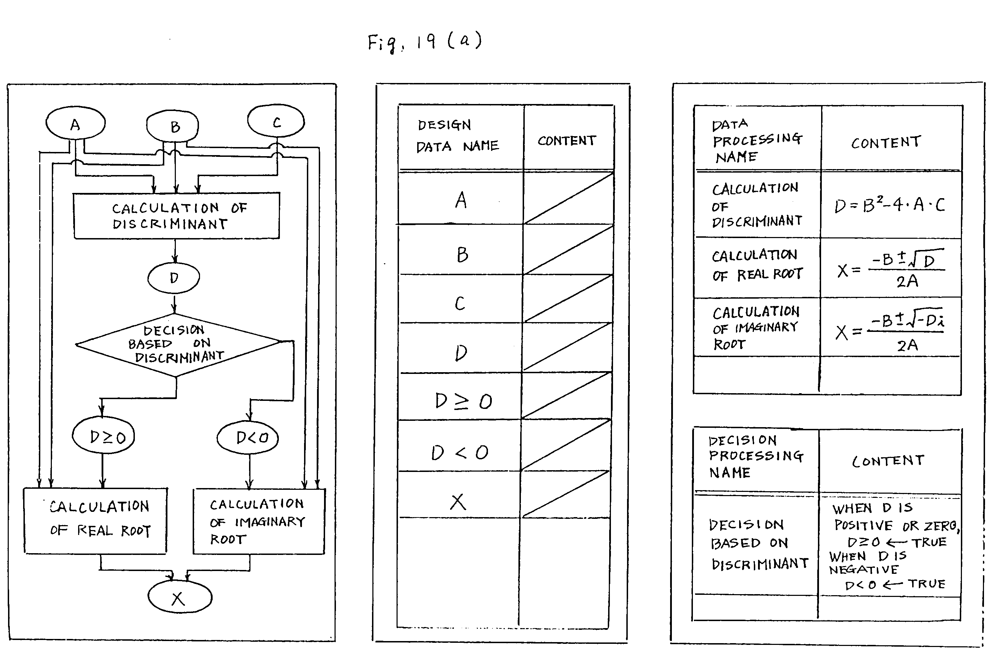

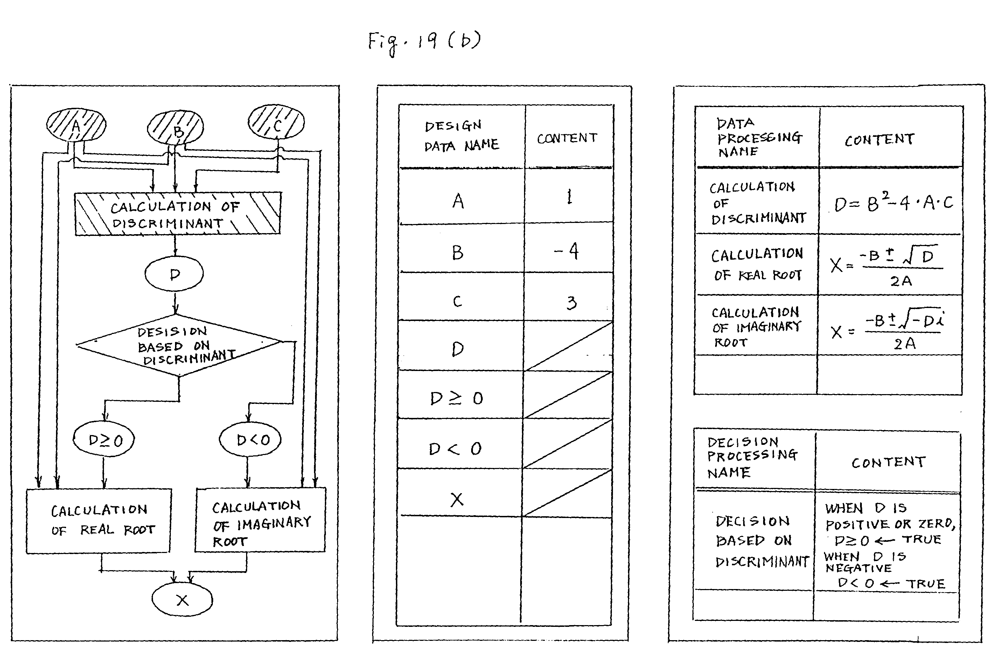

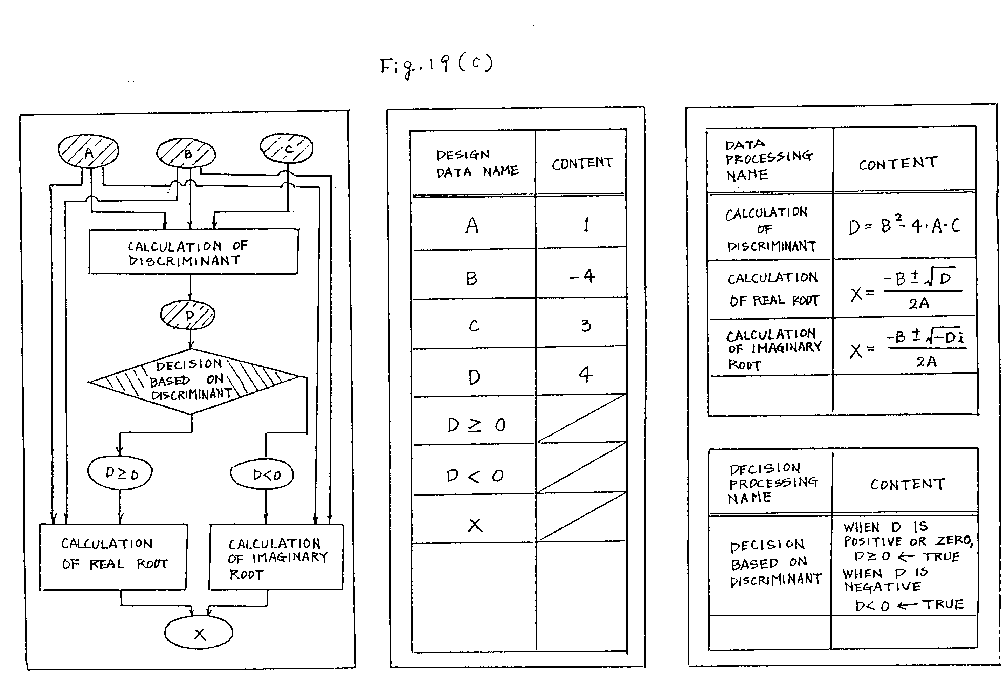

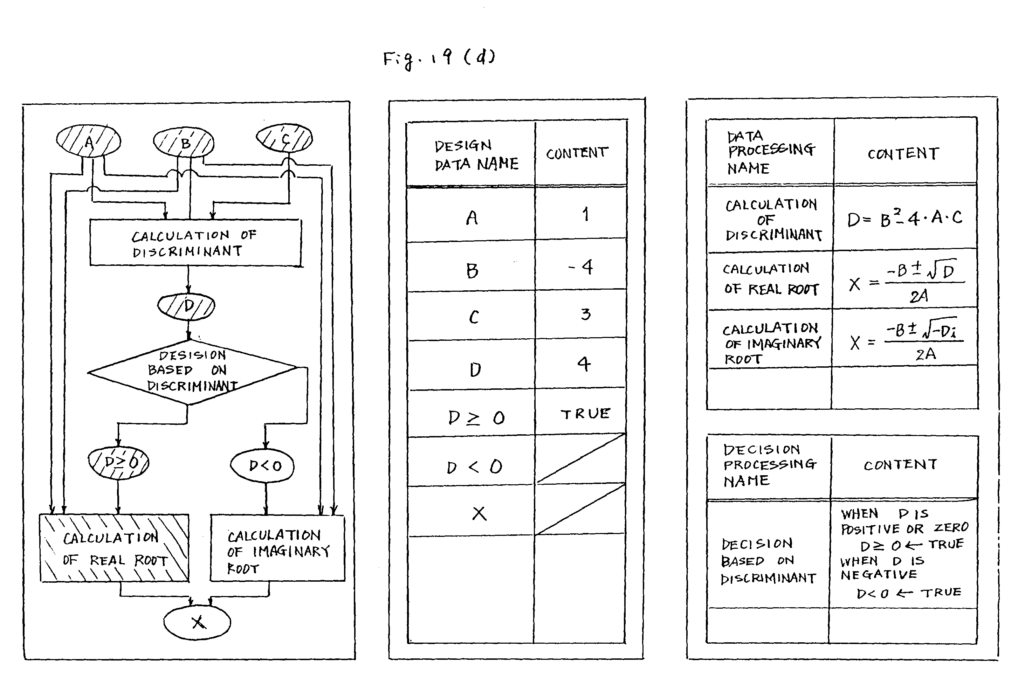

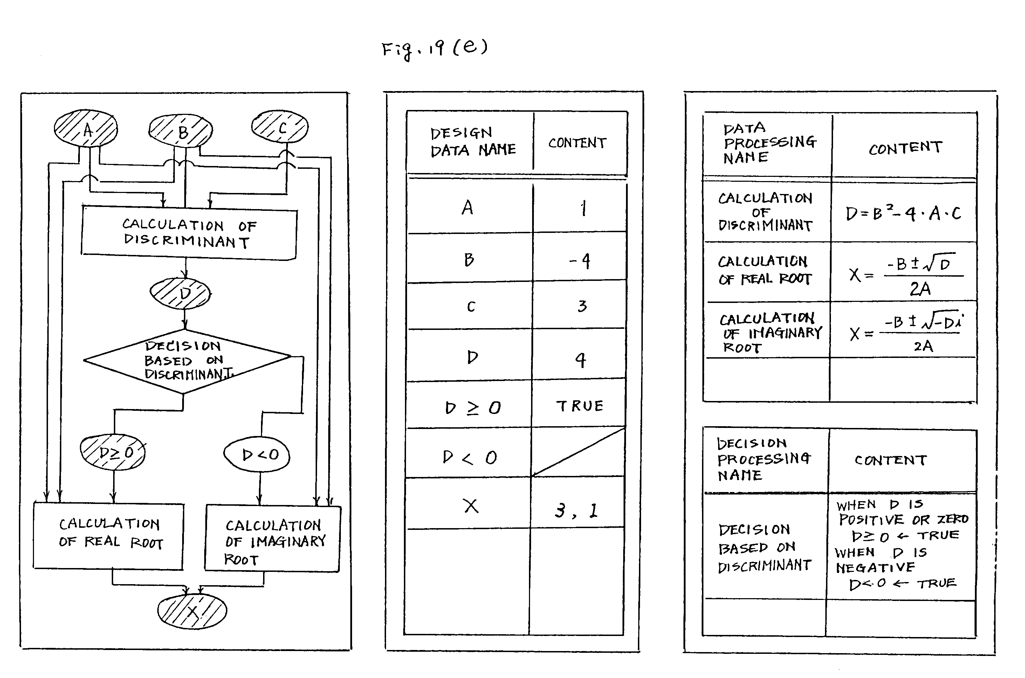

Figs. 19(a) to 19(e) show, by way of example only, a design calculation procedure including a decision processing performed by the embodiment shown in Fig. 16. More specifically, Figs. 19(a) to 19(e) show displays on the screen if the graphic terminal shown in Fig. 3 together with the contents of the design data content storage means 7 shown in Fig. 16 and those of the data processing content storage means 8 shown in the same figure. In Figs. 19(a) to 19(c), the name shown as enclosed by an ellipse identifies the name of the design data, the name enclosed by a rectangle identifies the name of the data processing, and the name shown as enclosed by a rectangle identifies the name of the decision processing. In the case of the example illustrated in Figs. 19(a) to 19(e), it is assumed that in connection with calculation for determining root of a quadratic equation, a discriminant is determined from the coefficients of the quadratic equation, wherein the real root is calculated when the discriminant is positive or zero while the imaginary root is determined when the latter is negative. Referring to Fig. 19(a), the design data names, the data processing names and the input/output relation information are inputted together with the contents of the data processings. In the state shown in Fig. 19(b), the initial values of the design data contents are inputted, resulting in that the data processing, i.e. the determination of the discriminant is made executable. In the state shown in Fig. 19(c), calculation for determining the discriminant is executed by the data processing executing means 9, whereby the content of the discriminant D which is the design data is determined, making it possible to execute the discriminant-based decision which corresponds to the decision processing. Referring to Fig. 19(d), the discriminant-based decision is executed by the data processing executing means 9. Since the discriminant D is positive, the content of the design data corresponding to D ≧ 0 is determined, whereby the calculation of the real root corresponding to the data processing can be executed. In the state shown in Fig. 19(e), calculation for determining the real root is performed by the data processing executing means 9, whereby the content of the root X which is the design data is determined. The design procedure processing then comes to an end. Since the result of the decision processing is expressed explicitly in the case of the illustrated example, there can be obtained advantage that the decision as to executability of the data processing can be made only on the basis of the decision data.

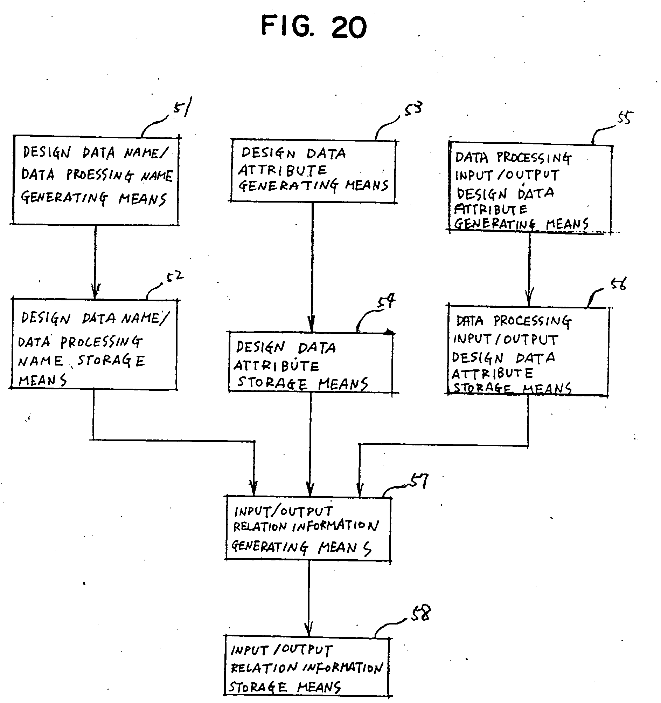

Fig. 20 is a block diagram showing a design procedure supporting system according to a further embodiment of the present invention. In Fig. 20, a reference numeral 51 denotes a design data name and data processing name generating means, 52 denotes a design data name and data processing name storing means, 53 denotes a design data attribute generating means, 54 denotes a design data attribute storing means, 55 denotes a means for generating design data attributes required by input/output design data for the data processing, 56 denotes a means for storing the design data attributes for the data processing, 57 denotes an input/output relation information generating means, and a numeral 58 denotes an input/output relation information generating means.

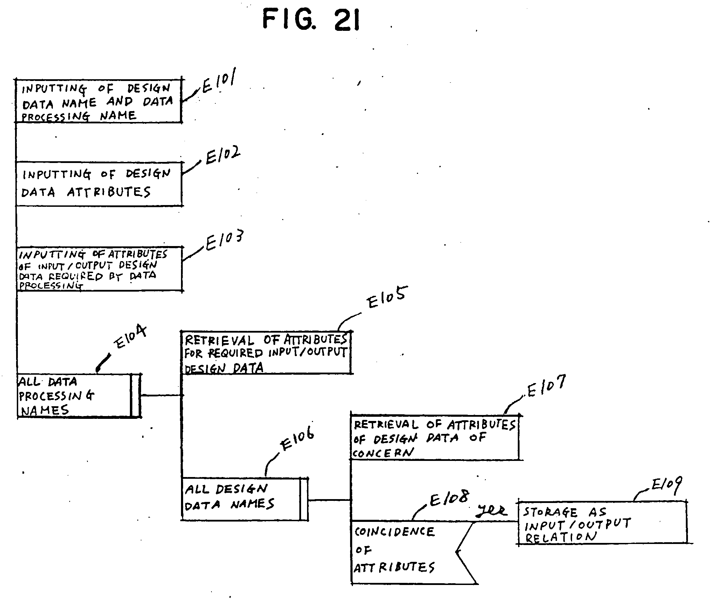

Fig. 21 is a problem analysis diagram (referred to as PAD in abbreviation) for illustrating operation of the design procedure supporting system shown in Fig. 20. In Fig. 21, at a step E101, the design data names and the data processing name(s) generated by the design data name and data processing name generating means 51 shown in Fig. 20 are inputted to the storage means 52. At a step E103, the input/output design data attributes required by the input/output design data for the data processing and generated by the design data attribute generating means 55 are inputted to the storage means 56. Then, the procedure processing proceeds to a step E104 where steps E105 to E109 are repeated for all the data processing names stored in the design data name and data processing name storage means 52. At the step E105, the design data attributes required by the input/output data for the data processing are retrieved from the data processing input/output design data attribute storage means 56. Next, at the step E106, a routine composed of the steps E107 to E109 is repeated for all the design data names stored in the design data name and data processing name storage means 52. At the step 107, the design data attributes are retrieved from the design data attribute storage means 54. At the step E108, the input/output design data attributes required by the data processing are compared with the design data attributes. When coincidence is resulted, the procedure proceeds to the step E109. Otherwise, the step E106 is regained. At the step E109, the design data names and the data processing name to which the former bear the input/output relations are stored in the input/output relation information storage means 58.

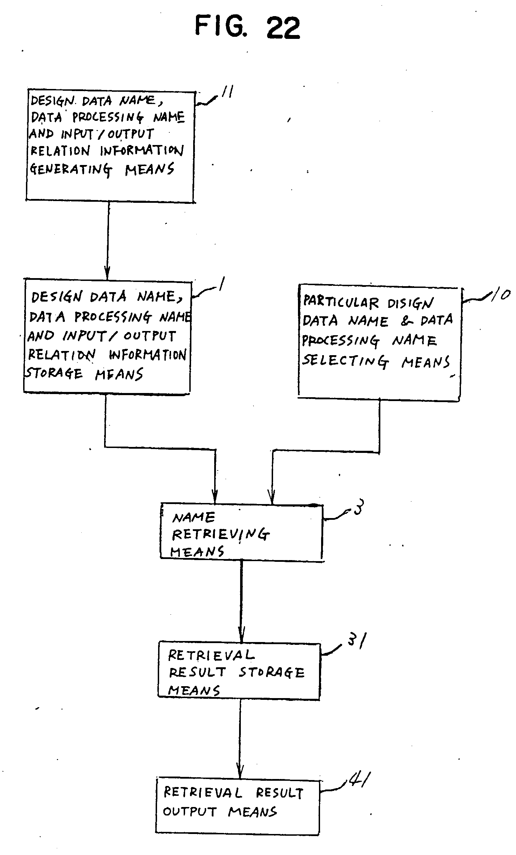

Fig. 22 is a block diagram showing an arrangement of design procedure supporting system according to a further embodiment of the present invention. In Fig. 22, a reference numeral 11 denotes a design data name, data processing name and input/output relation information generating means, 1 denotes a design data name, data processing name and input/output relation information storage means, 10 denotes a specific design data name or data processing name selecting means, 3 denotes a name retrieving means, 31 denotes a storage means for storing the results of the retrieval, and a numeral 41 denotes an output means for outputting the results of retrieval.

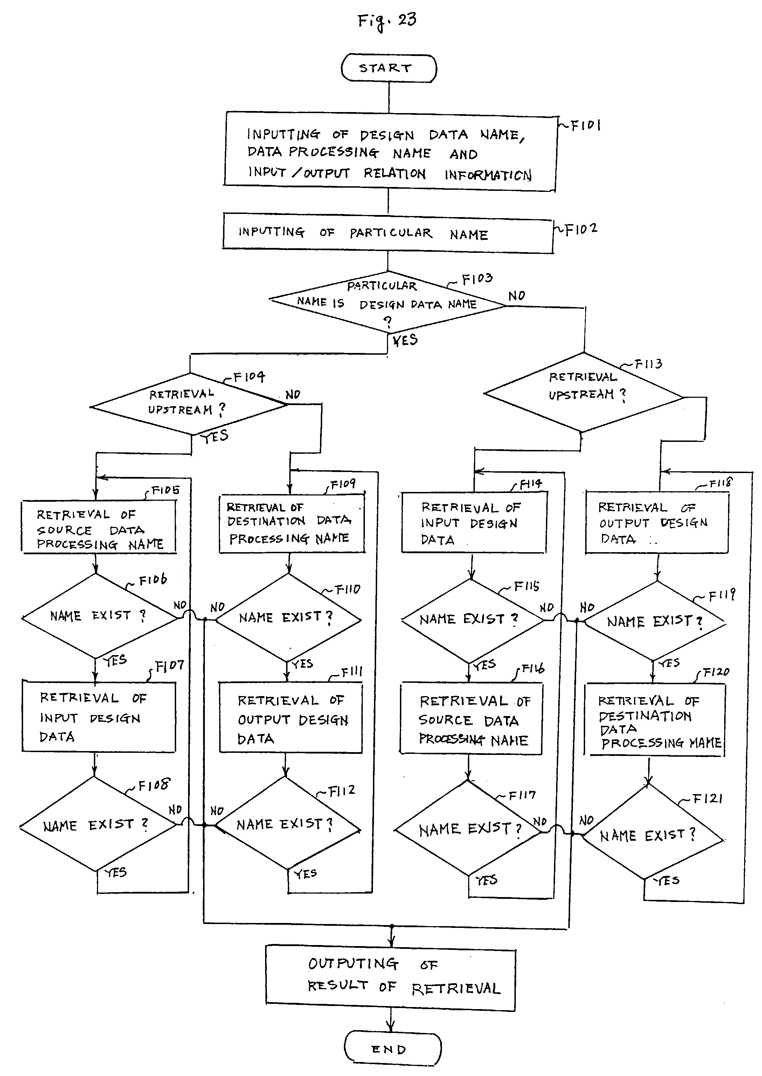

Fig. 23 is a flow chart for illustrating operation of the system shown in Fig. 22. Referring to Fig. 23, at a step F101, the design data names, the data processing name(s) and the input/output relation information generated by the design data name, data processing name and input/output relation information generating means 11 are inputted to the storage means 1. At a step F102, the specific or particular design data name or data processing name is inputted through the particular specific design data name or data processing name selecting means. At a step F103, decision is made as to whether the inputted name is a design data name or a data processing name. When it is decided that the inputted name is the design data name, the procedure proceeds to a step F104. On the other hand, when the inputted name is decided to be the data processing name, the procedure proceeds to a step F113. At the step F104, decision is made as to whether the upstream data processing name required for determining the specific design data of concern is to be retrieved (searched) or the downstream data processing name susceptible to the influence of the specific design data is to be retrieved. When the retrieval for the upstream data processing is decided, the procedure proceeds to a step F105, while it proceeds to a step F109 when the retrieval for the downstream data processing is decided. At the step F105, the name of the output source data processing in which the specific design data originates is retrieved. At a step F106, it is decided whether the data processing name of concern could be retrieved or not. When retrieved, the procedure proceeds to a step F122. At the step F107, the input design data name is retrieved on the basis of the data processing name by the name retrieving means 3. At the step F106, decision is made as to whether the design data name could be retrieved or not. When the result of this decision is affirmative (YES), the steps F105 to F108 are repeated. Otherwise, the procedure proceeds to the step F122. At a step F109, the name of the output destination data processing is retrieved on the basis of the design data name by the name retrieving means 3. At a step 110, it is decided whether the data processing name of concern could be retrieved or not. If affirmative (YES), the procedure proceeds to a step F122. At a step F111, the output design data name is retrieval (searched) by the name retrieving means with the aid of the data processing name. At a step F112, it is decided whether the design data name could be retrieved. If the answer of the decision step F112 is affirmative, execution of the steps F109 to F122 is repeated. If otherwise, the procedure proceeds to the step F122. At a step F113, decision is made as to whether the upstream design data required for executing the specific data processing of concern is to be retrieved (or searched) or the downstream design data susceptible to the influence of the specific data processing of concern is to be retrieved. When it is decided that the upstream design data is to be retrieved, the procedure proceeds to a step F114, while it proceeds to a processing step F118, if otherwise. At the step F114, the input design data name is retrieved by the name retrieving means 3 on the basis of the data processing name. At a step F115, decision is made as to whether or not the design data name could be retrieved. When the result of decision at the step F115 is affirmative, the procedure proceeds to the step F122. At a step F116, the name of the output source data processing in which the input design data originates is retrieved by the name retrieving means on the basis of the design data name. At a step F117, it is decided whether the data processing name of concern could be retrieved or not. When the answer of this decision step F117 is affirmative, execution of the steps F114 to F117 is executed. If otherwise, the procedure proceeds to the step F122. At a step F118, the output design data name is retrieved on the basis of the data processing name by the name retrieving means 3. At a step F119, it is decided whether the design data name could be retrieved or not. When the result of this decision step is affirmative, the procedure proceeds to the step F122. At a step F120, the name of the input data processing originating in the input source data processing originating in the input source data processing is retrieved on the basis of the design data name by the name retrieving means 3. At a step F121, decision is made as to whether the data processing name could be retrieved or not. If affirmative, execution of the steps F118 to F121 is repeated. Otherwise, the procedure proceeds to the step F122 where the results of the retrieval stored in the retrieval result storing means 31 are outputted through the retrieval result output means 41.

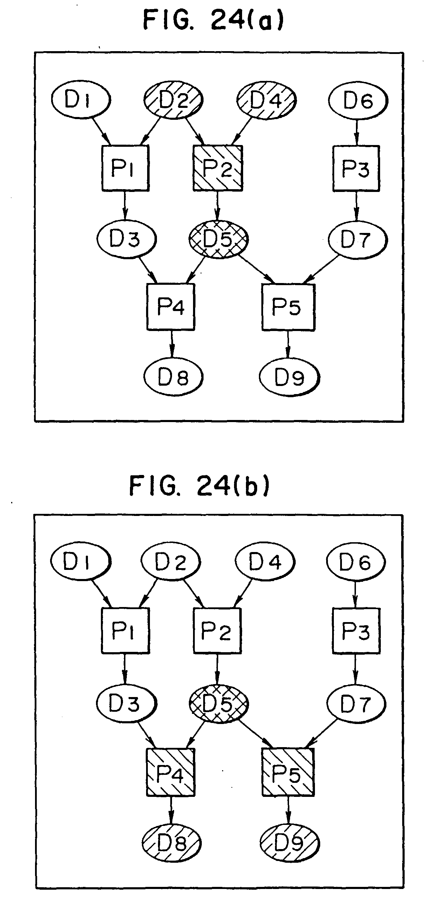

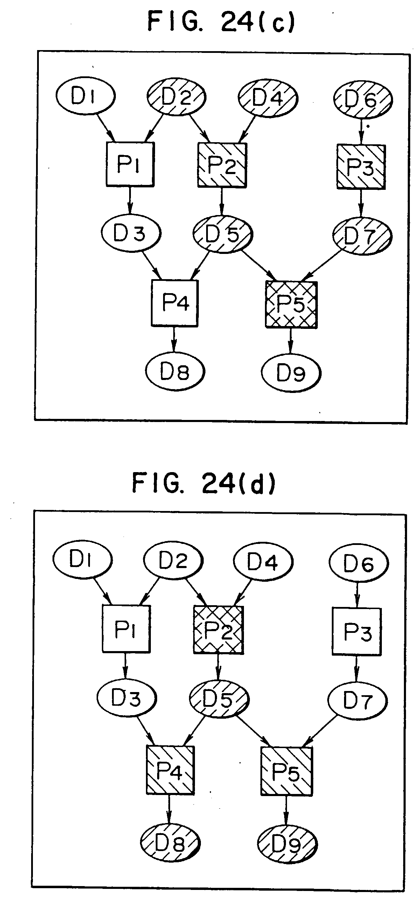

Figs. 24(a) to 24(d) are views for illustrating operation of the design procedure supporting system shown in Fig. 22. More specifically, Figs. 24(a) to 24(d) show displays generated on the screen of the graphic terminal shown in Fig. 3, wherein reference characters D1 to D9 designated the design data names whole P1 to P5 designate the data processing names, respectively. Referring to Fig. 24(a), there are shown the selection of the design data name 5 together with the design data names D2 and D3 and the data processing name P2 resulting from the retrieval of the upstream data processing required for determining the design data name as performed in accordance with the procedure described above by reference to Fig. 23. The retrieved names are distinctively identified by hatching. In Fig. 24(b), there are shown the selection of the design data name D5 together with the design data names D8 and D9 and the data processing names P4 and P5 resulting from the retrieval of the downstream data processings susceptible to the influence of the design data as performed in accordance with the procedure shown in Fig. 23. The retrieved names are discriminatively displayed, as indicated by hatching. Fig. 24(c) shows the selection of the data processing name D5 together with the design data names D2, D4, D5, D6 and D7 and the data processing names P2 and P3 resulting from the retrieval of the upstream data processings required for executing the data processing as performed in accordance with the procedure illustrated in Fig. 23. The retrieved names are indicated discriminatively by hatching. Fig. 24(d) shows the selection of the data processing name P2 together with the design data names D5, D8 and D9 and the data processing names P4 and P5 which result from the retrieval of the downstream items susceptible to the influence of the data processing. The retrieved names are identified discriminatively, as indicated by hatching.

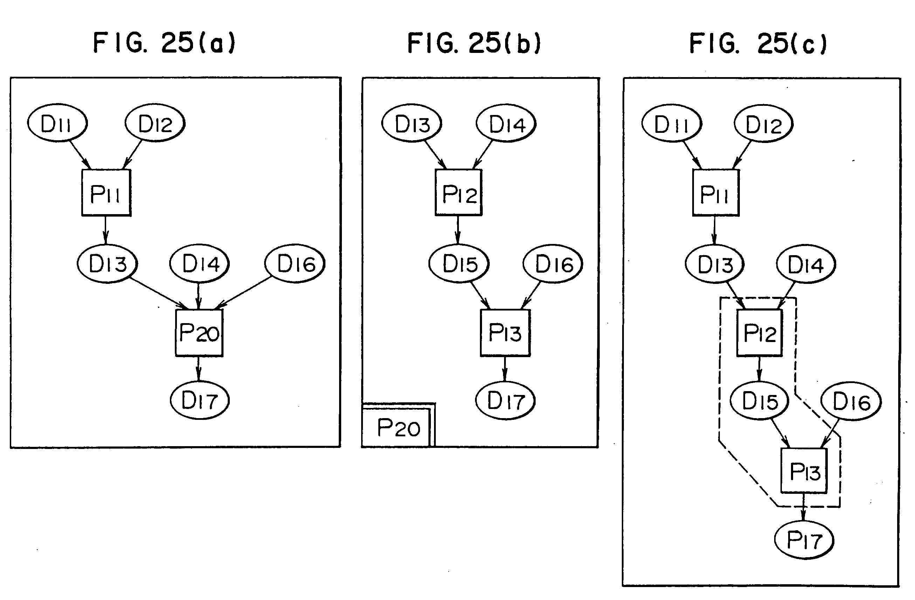

Fig. 25(a) to 25(c) show examples of more detailed contents of the data processing performed by the system shown in Fig. 1, which data processing is expressed by the design data name, the data processing name and the input/output relation information in the form of a hierarchical structure. More specifically, Figs. 25(a) to 25(e) show displays generated on the graphic terminal shown in Fig. 3, wherein D11 to D17 represent the design data name while P11 to P13 and P20 represent the data processing names, respectively. Referring to Figs. 25(a) to 25(c), the more detailed content of the data processing named P20 is expressed in terms of the data processing names P12 to P13 and the input/output relation information. More specifically, Fig. 25(a) shows the result of expressing the data processing named P20 regarded as one data processing in the form of a network of the design data name, the data processing names and the input/output information. Fig. 25(b) shows the result of expressing the more detailed content of the data processing named P20 in the form of a network of the design data names, the data processing names and the input/output relation information. At will be appreciated from three illustrated examples, the network expression for the global content and the network expression for the detailed content can be selectively employed by making use of the hierarchical structure. Fig. 25(c) shows the result of development and consolidation of the detailed content of the data processing named P20 shown in Fig. 25(b) within the network shown in Fig. 25(a). A portion enclosed by a broken line block corresponds to the detailed content of the data processing named P20.

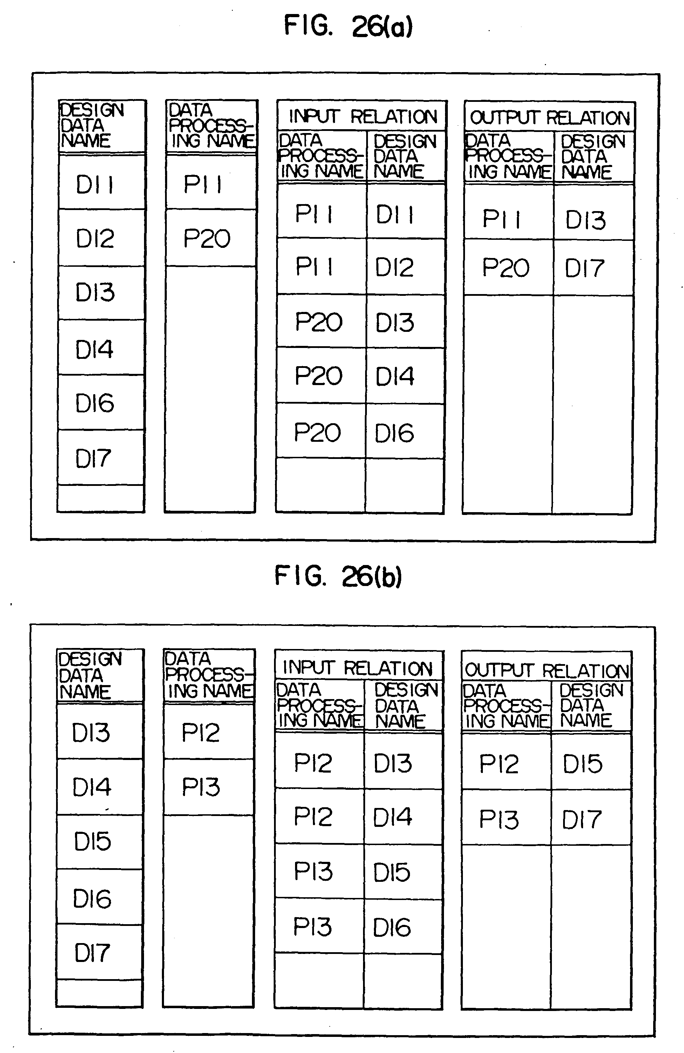

Figs. 26(a) and 26(b) show an exemplary method of storing the design data names, the data processing names and the input/output relation information in the design data name, data processing names and input/output relation information storage means shown in Fig. 1 in the case where more detailed content of the data processing is expressed by design data name data processing names and input/output relation information in a hierarchical structure. In Figs. 26(a) and 26(b), reference symbols D11 to D17 represent the design data names and P11 to P13 and P20 represent the data processing names. Fig. 26(a) shows the result of the storage of the design data names, the data processing names and the input/output relation information in the state shown in Fig. 25(a). Fig. 26(b) shows the result of the storage of them in the state shown in Fig. 25(b). As will be seen from the illustrated example, the network information of the hierarchical structure can be stored by storing a plurality of design data names, data processing names and input/output relation information and establishing correspondences by using pointers, for example, from the data processing names. The corresponding design data names shown in Figs. 26(a) and 26(b) need not necessarily be made mutually coincident, when the means for establishing the correspondence relations is provided.

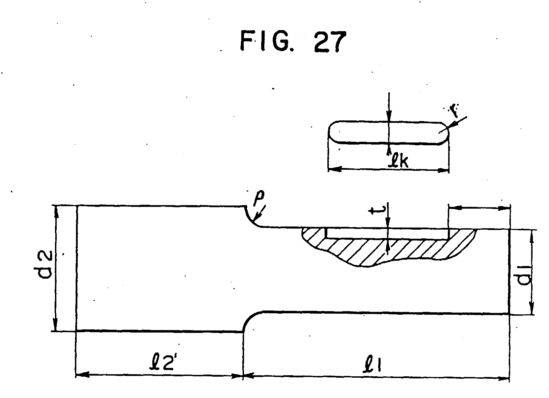

Next, referring to Fig. 27, an application of the design procedure supporting system according to an embodiment of the present invention will be elucidated by taking as example a design procedure for a shaft of turbine blades typified by a stepped shaft having key ways formed therein on the assumption that main sizes or dimensions such as shaft diameter and others are to be designed so that the maximum main stress or maximum shaving stress may not exceed a permissible level when the shaft is subjected to a bending moment and a torsional (twisting moment).

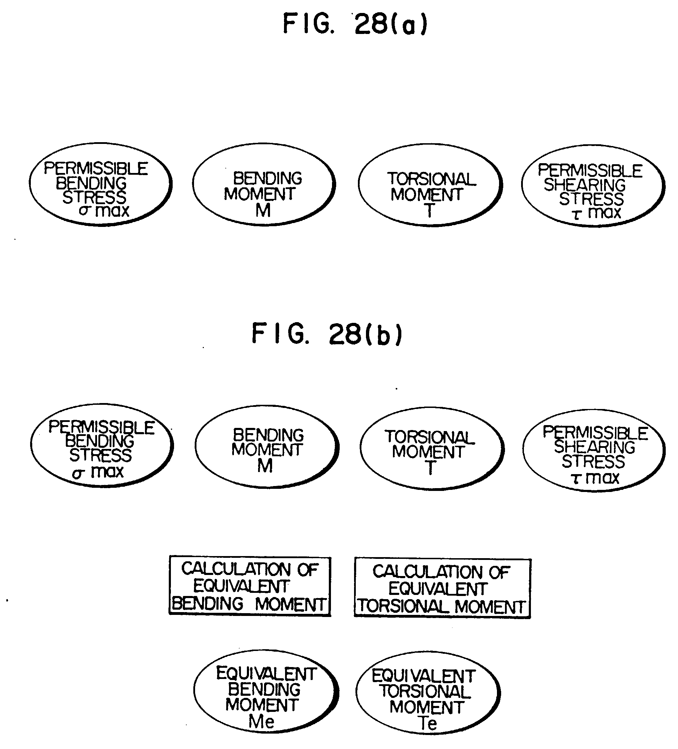

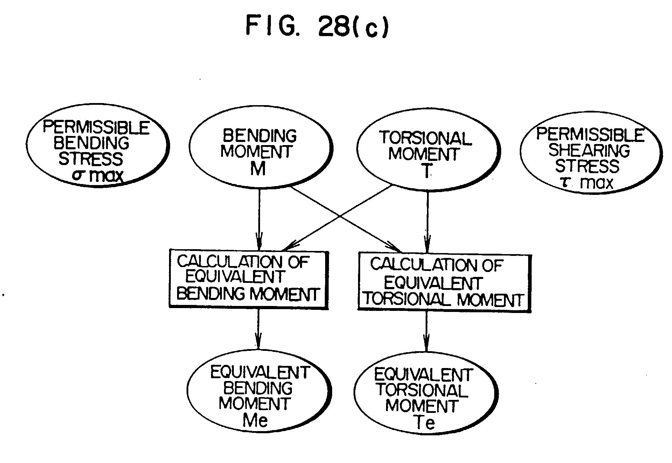

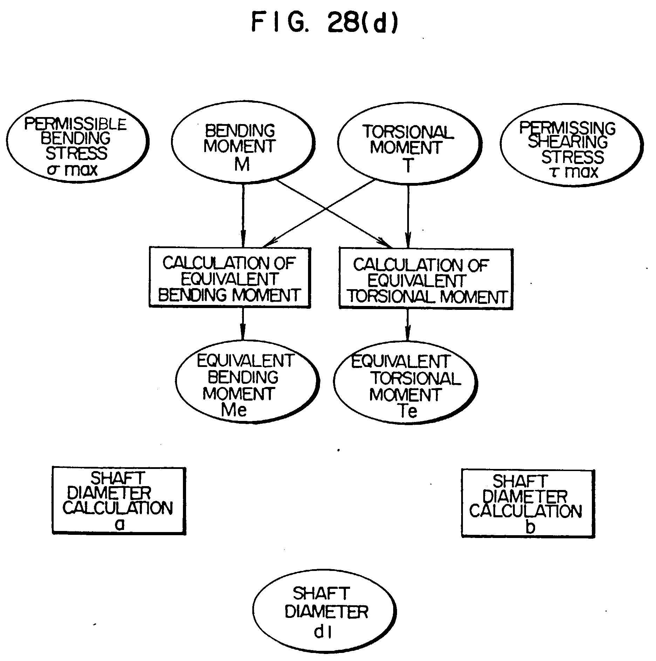

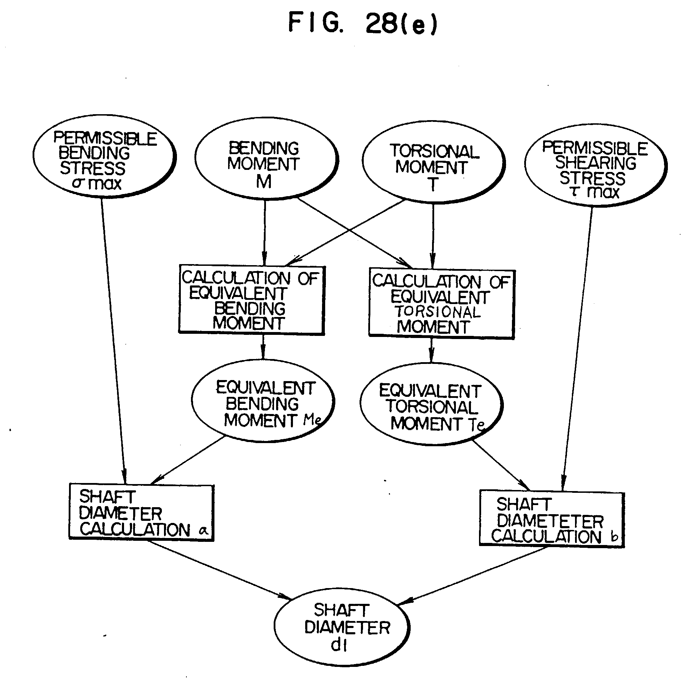

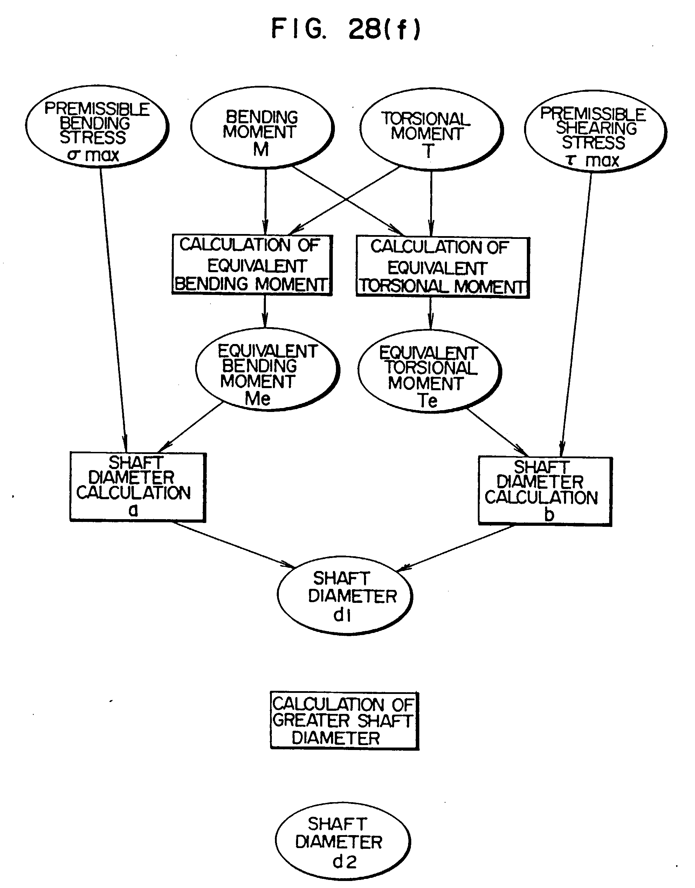

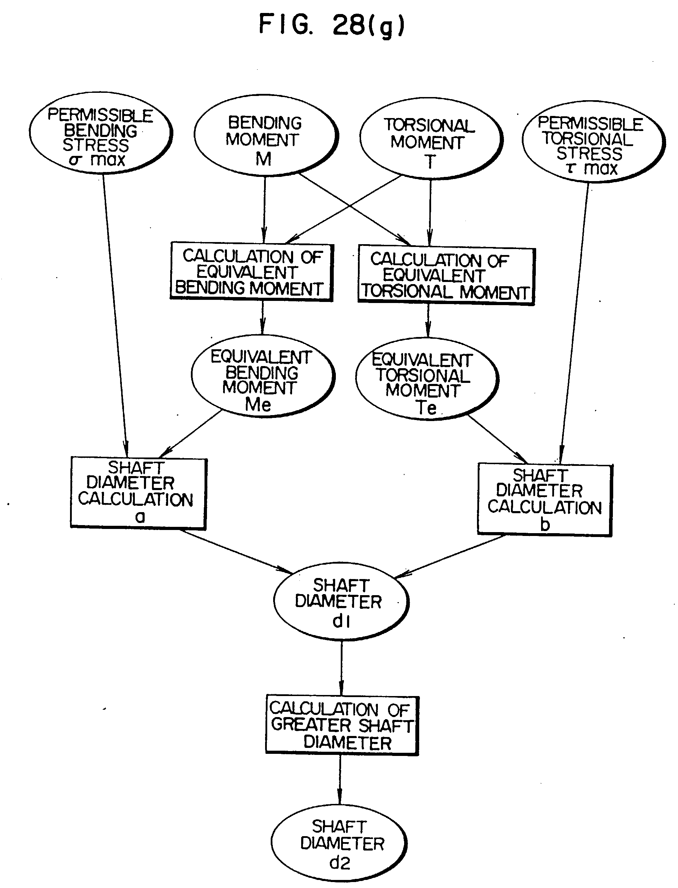

Figs. 28(a) to 28(g) show, by way of example, a method of generating design data names, data processing names and input/output relation information by the design data name, data processing name and input/output relation information generating means 11 shown in Figs. 1. More specifically, Figs. 28(a) to 28(g) show displays generated on the screen of the graphic terminal 111 shown in Fig. 3, respectively, on the assumption that a stepped shaft having no key way is to be designed, wherein two shaft diameters are ultimately outputted in response to the inputting of a bending moment, a torsional (twisting) moment, a permissible bending stress and a permissible shearing stress. It is further assumed that the ratio if the two shaft diameters is constant. More specifically, referring to Fig. 28(a), the bending moment, the torsional moment, the permissible bending stress and the permissible shearing stress as inputted are defined and enclosed by ellipses, respectively, to thereby indicate that these inputs are the design data names, respectively. Referring to Fig. 28(b), equivalent bending moment and torsional (twisting) moment calculated from the bending moment and the torsional moment are defined and enclosed by ellipses, respectively, to thereby input the indication that these equivalent moments are the design data names, respectively, while the equivalent bending moment calculation and the equivalent torsional moment calculation for calculating these design data are enclosed by rectangles, respectively, to thereby input the indication that these calculations represent the data processing names, respectively. Referring to Fig. 28(c), the bending moment and the torsional moment are linked to the equivalent bending moment calculation and the equivalent torsional moment calculation by arrows or arcs, respectively, to thereby input the indication that the inputs to the equivalent bending moment calculation and the equivalent torsional moment calculation are the bending moment and the torsional moment, respectively, while the equivalent bending moment calculation and the equivalent bending moment are linked together by an arrow with the equivalent torsional moment calculation and the equivalent torsional moment being linked by an arrow, to thereby indicate that the outputs of the calculations mentioned above are represented by the equivalent bending moment and the equivalent torsional moment, respectively. The shaft diameter can be calculated from the equivalent bending moment and the permissible bending stress in the case of a shaft of a fragile material, while the shaft diameter can be calculated from the equivalent torsional moment and the permissible shearing stress. Accordingly, the shaft diameters are defined and enclosed by ellipses to input the indication that they represent the design data names, while shaft diameter calculations a and b for calculating the shaft diameters are defined and enclosed by rectangles, respectively, to thereby input the indication that these calculations a and b represent the data processing names, as shown in Fig. 28(d). Referring to Fig. 28(e), the permissible stress and the equivalent bending moment are linked to the shaft diameter calculation a by arrows while the permissible stress and the equivalent torsional moment are linked to the shaft diameter calculation b by arrows, to thereby input the indication that the inputs to these calculations and b are represented, respectively, by the permissible stress and the equivalent bending moment on one hand and the permissible stress and the equivalent torsional moment on the other hand. Further, the shaft diameter calculations a and b are linked to the shaft diameter, to thereby indicate that the output of these calculations a and b are the shaft diameter. Referring to Fig. 28(f), the other shaft diameter d2 which can be calculated from the shaft diameter d1 thus determined and the grater shaft diameter calculation for determining the grater diameter d2 are defined and enclosed by an ellipse and a rectangle, respectively, to input the indication that they represents the design data name and the data processing name, respectively. Referring to Fig. 28(g), the shaft diameter d1 and the greater shaft diameter calculation are linked together by an arrow to indicate that the shaft diameter d1 is the input to the greater shaft diameter calculation processings while the greater shaft diameter calculation and the shaft diameter d2 are linked together by an arrow to indicate that the output of the greater shaft diameter calculation processing is the shaft diameter d2. As the result, the design data names, the data processing names and the input/output relation information are stored in the design data name, data processing name and input/output relation information storage means 1 shown in Fig. 1.

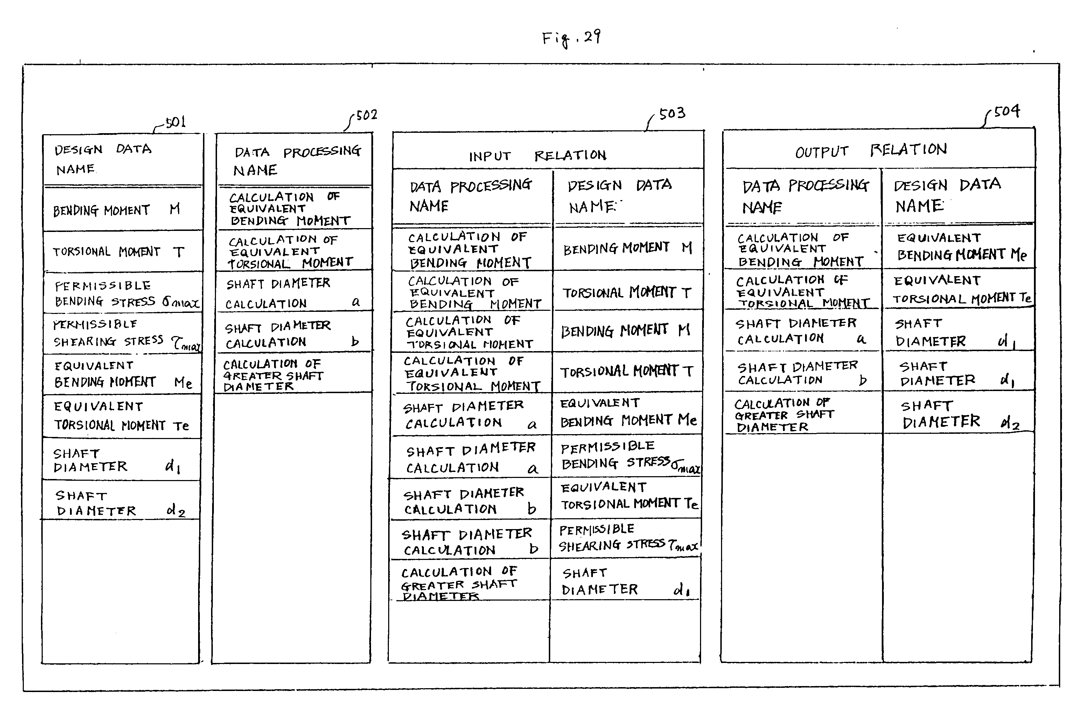

Fig. 29 shows an exemplary method of storing the design data names, the data processing names and the input/output relation information in the design data name, data processing name and input/output relation information storage means 1 shown in Fig. 1. Referring to Fig. 29, a reference numeral 501 denotes a design data name storing area, 502 denotes a data processing name storing area, 503 denotes an input relation information storing area for storing the data processing and the input design data therefor, and 504 denotes an output relation information storing area for storing the data processings and the output design data resulting therefrom. In the case of the example shown in Fig. 29, it is assumed that the design data names, the data processing names and the input/output relation information in the state illustrated in Fig. 28(g) are stored. The design data names generated by the design data name, data processing name and input/output relation information generating means 11 are stored in the design name storing area 501, the data processing names similarly generated are stored in the data processing name storing area 502, the input relations are stored in the input relation storing area 503 in teams of the data processing name and the design data names being input relation to the former, and finally the output relations are stored in the output relation storing area 504 in the form of the data processing name and the design data name bearing output relation to the former.

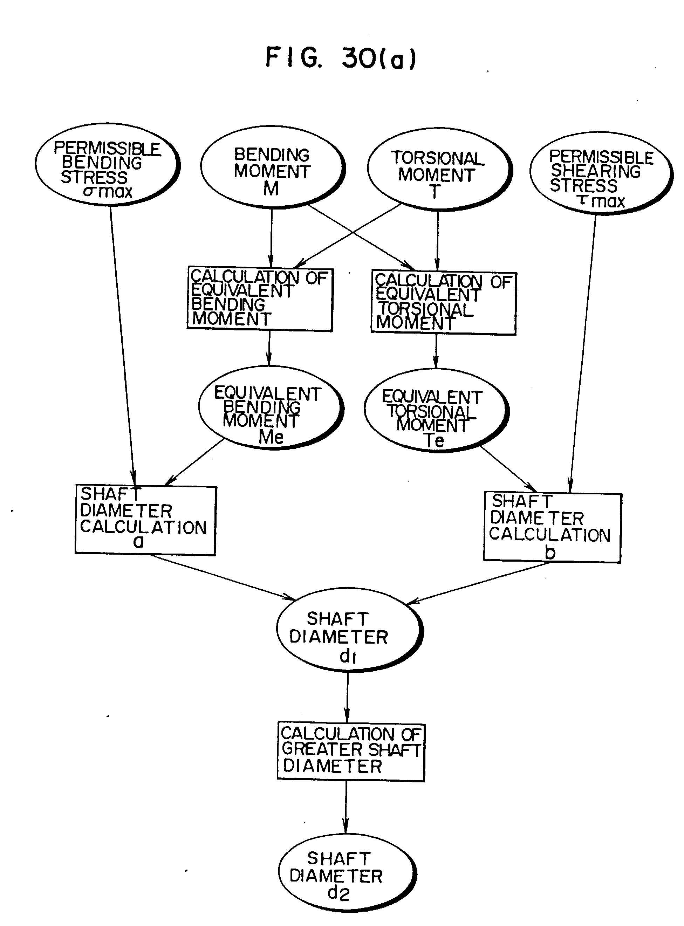

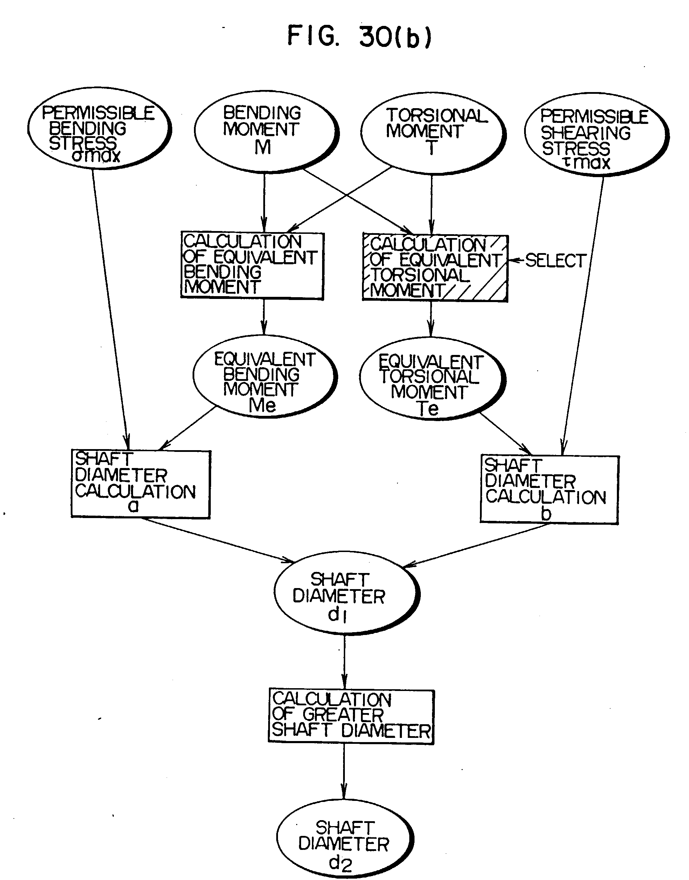

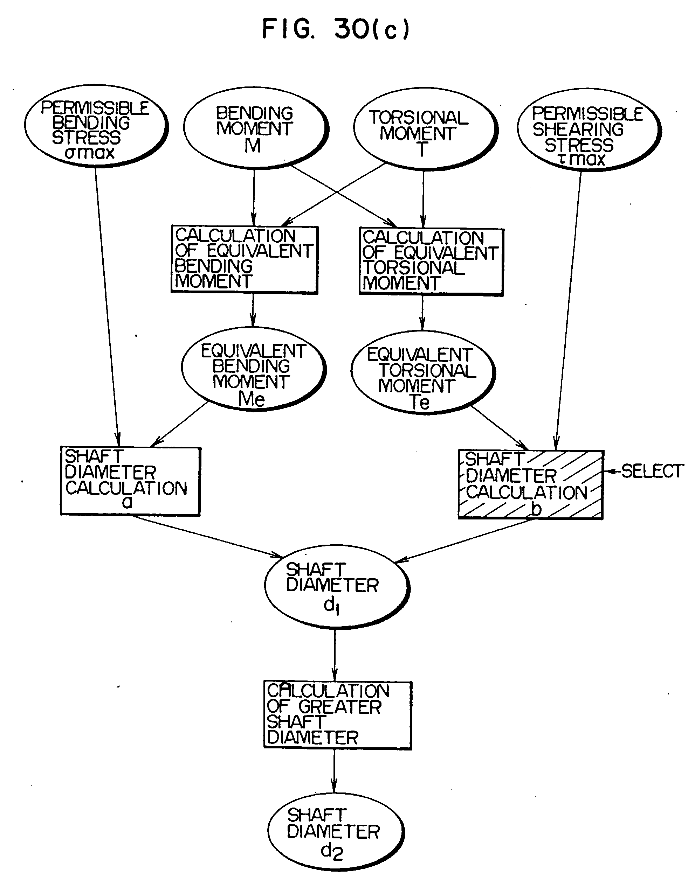

Fig. 30(a) to 30(c) show an exemplary method of generating the data processing execution sequence by the data processing execution sequence generating means 12 shown in Fig. 1. More specifically, Figs. 30(a) to 30(c) show, respectively, displays on the screen of the graphic terminal 111 shown in Fig. 3, on the assumption that the invention is applied to the design procedure for designing a stepless shaft formed of a ductile material on the basis of the state shown in Fig. 28(g). More specifically, generation of such a data processing execution sequence is assumed that the first data processing is calculation of an equivalent torsional moment and the second data processing is calculation of a shaft diameter. Now, description is turned to a procedure for generating this sequence. It will be noted that Fig. 30(a) is same as Fig. 28(g). Referring to Fig. 30(b), the equivalent torsional moment calculation is selected as the data processing name. Referring to Fig. 30(c), the shaft diameter calculation b is selected as the data processing name. Consequently, the data processing execution sequence of this order is stored in the data processing execution sequence storage means 2 shown in Fig. 1. The instant method is advantageous in that the selection only of the data processing names is sufficient for thus storage since the data processing execution sequence can be inputted as the order of selecting the data processing names described above by reference to Figs. 30(b) and 30(c). In this conjunction, there may be conceived another method according to which indication of where the data processing whose name is selected is to be executed in the sequence of concern is inputted. This method is advantageous in that the data processing name selecting order can be determined independent of the data processing execution sequence.

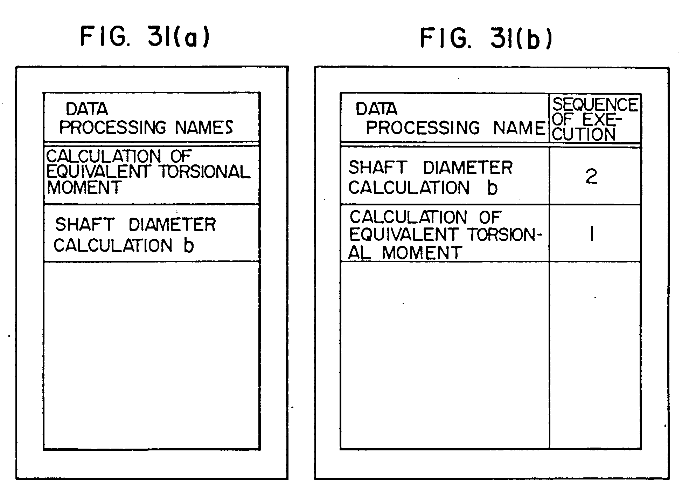

Figs. 31(a) and 31(b) show two exemplary methods of storing the data processing execution sequence in the data processing execution sequence storage means 2 shown in Fig. 1 on the assumption that the data processing execution sequence in the state illustrated in Fig. 30(c) is to be stored. The data processing execution sequence generated by the data processing execution sequence generating means 12 is stored in terms of the means if the data processings and the order in while they are stored according to the method illustrated in Fig. 31(a), while according to the method illustrated in Fig. 31, the sequence of concern is stored in terms of pairs of the names of the data processings and the numbered order in which they are to be executed.

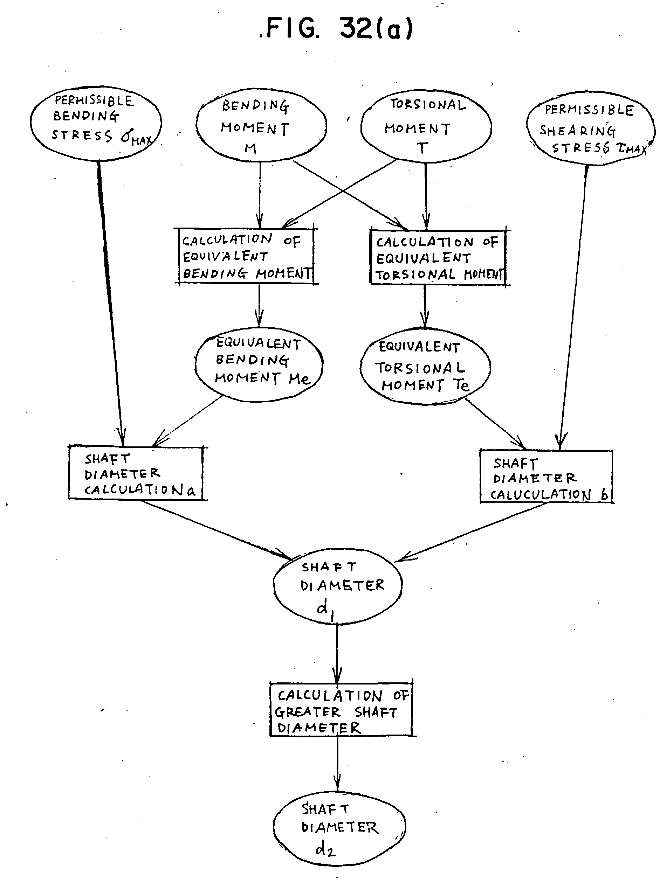

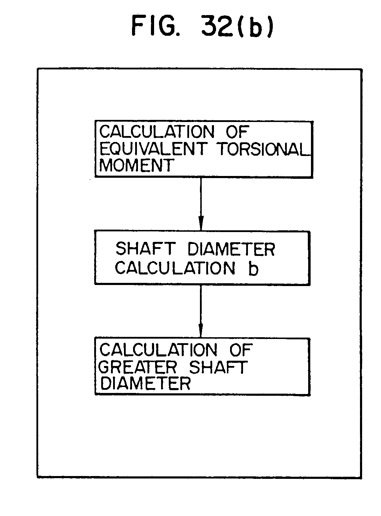

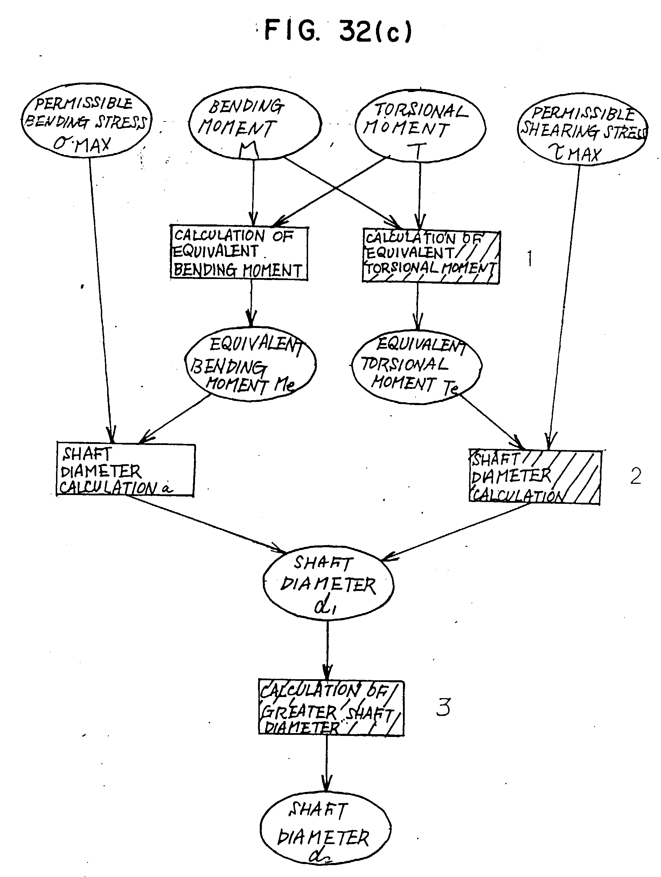

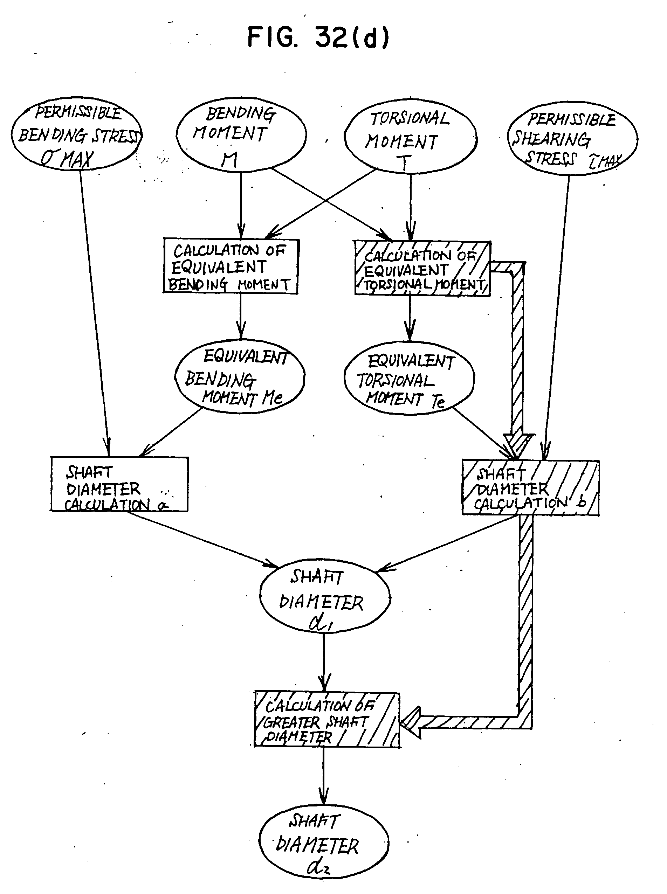

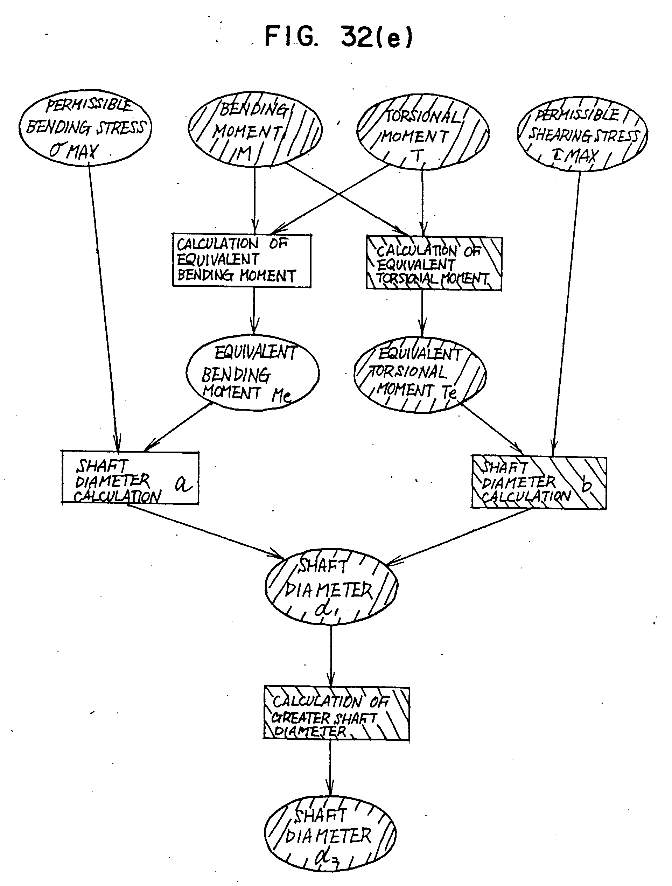

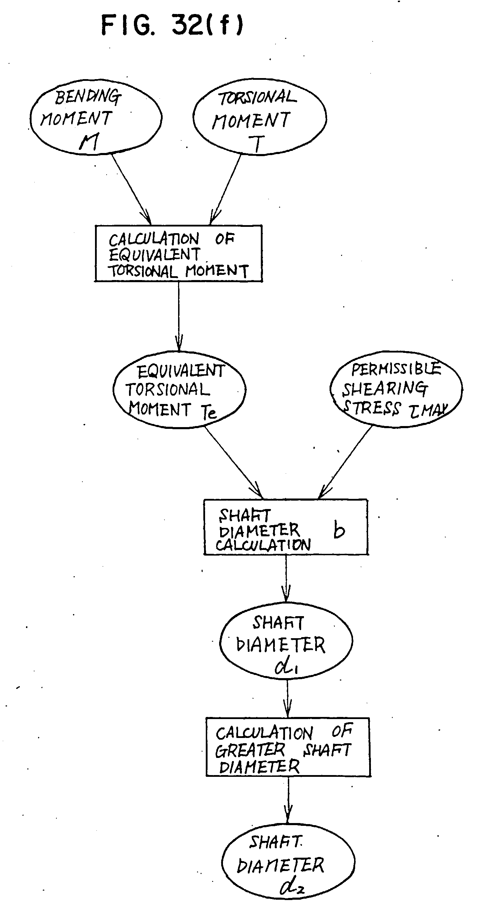

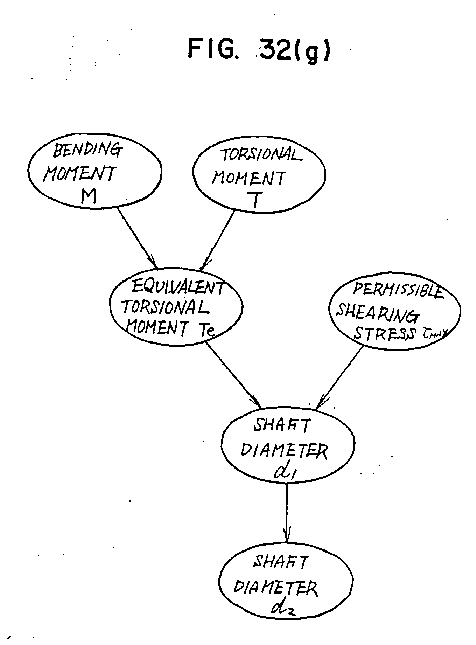

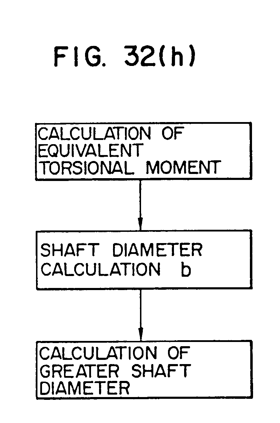

Figs. 32(a) to 32(h) are to illustrate the operation of the design procedure output means 41 shown in Fig. 1. More specifically, Fig. 31(a) shows in terms of a network expression the contents stored in the design data name, data processing name and input/output relation information storage means 1, and Fig. 32(b) illustrates in the form of flow chart expression the contents stored in the data processing execution sequence storage means 2. Fig. 32(c) to 32(h) show displays on the screen of the graphic terminal 11 shown in Fig. 3 and illustrate examples of a method of those parts which participate in the actual design procedure based on the contents shown in Fig. 32(a) and 32(b). In more concrete, Figs. 32(a) and 32(b) show a design procedure for a stepped shaft made of a ductile material. Fig. 32(c) shows a network of the design data names, the data processing names and the input/output relation information, wherein the actual data processing execution sequence is indicted by attaching the corresponding numbers to the data processing names. Fig. 32(d) shows a network of the design data names, the data processing names and the input/output relation information, wherein the actual data processing execution sequence is indicated by arrows attached to the data processings. Fig. 32(e) shows a network of the design data names, the data processing names and the input/output information, wherein the parts participating in the actual procedure are discriminatively by hatchings. Such discrimination may be implemented by resorting to the use of colors, changes of density or flashing. The instant embodiment of the invention is advantageous in that the positions or locations of the parts participating actually in the procedure can readily be understood against the background of the whole network structure. Fig. 32(f) shows a network constituted only by the design data names, data processing names and the input/output relation information that participate in the actual procedure. This embodiment is advantageous in that the participating parts can be expressed simply to enhance the understandability of the actual procedure. In Fig. 32(g), only the design data names and the input/output relation information shown in Fig. 32(f) except for the dot processing names are displayed in the form of a network. Thus display method advantageously facilitates the examination concerning the dependence relation among the design data. Fig. 32(h) shows a display of the data processing names and the input/output relation information shown in Fig. 32(f) except for the design data names in the form of a network. This display method is advantageous in that examination on the dependence relations among the data processings can be facilitated.

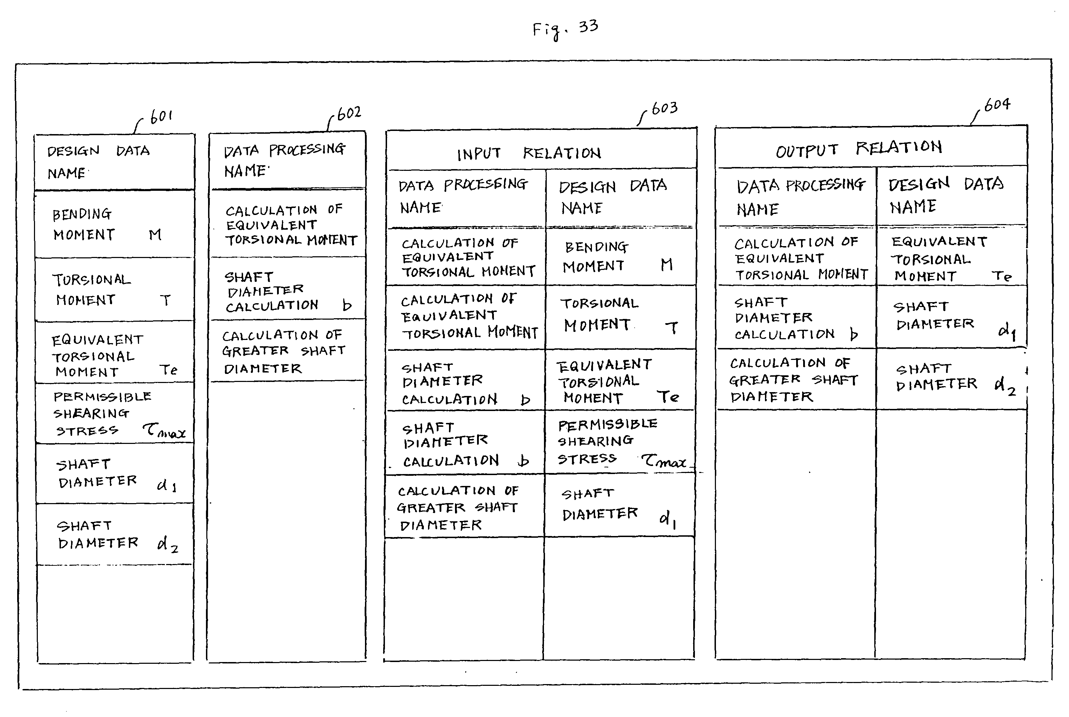

Fig. 33 is a view illustrating a method of storing the results of retrieval in the retrieval result storage means 31. In Fig. 32, a reference numeral 601 denotes a design data name storing area, 602 denotes a data processing name storing area, 603 denotes an input relation storing area for storing the data processings and the input design data therefor, and 604 denotes an output relation storing area for storing the data processings and the output design data resulting from execution of the processings. In the case of the example illustrated in Fig. 33, it is assumed that the results of retrieval of the parts partaking in the actual design procedure based on the contents shown in Figs. 32(a) and 32(b) are stored. The design data names retrieved by the name retrieving means 3 shown in Fig. 1 are stored in the design data name storing area 601. The data processing names used for the retrieval are stored in the data processing name storing area 602. The input relations made use of in the retrieval are stored in the input relation storing area 603 in the form of the data processing names and the design data names bearing the input relation to the former. The output relations utilized in the retrieval are stored in the output relation storing area 604 in the form of the data processing names and the design data names having the output relation thereto.

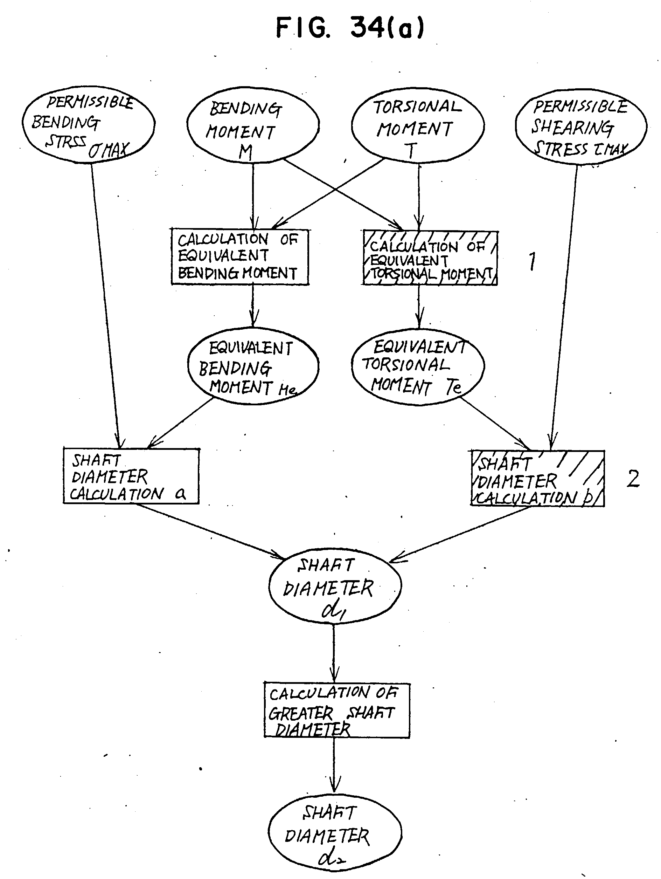

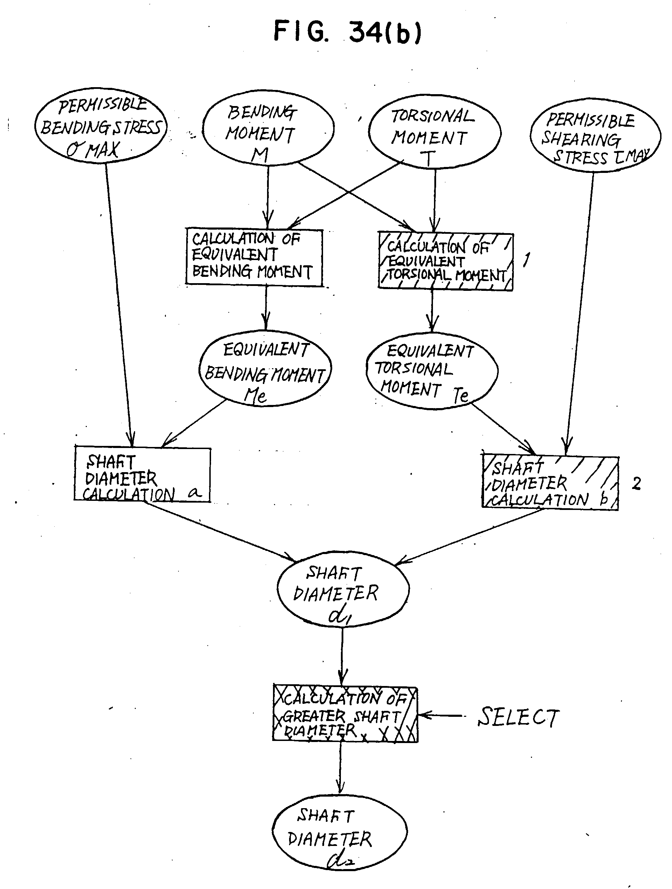

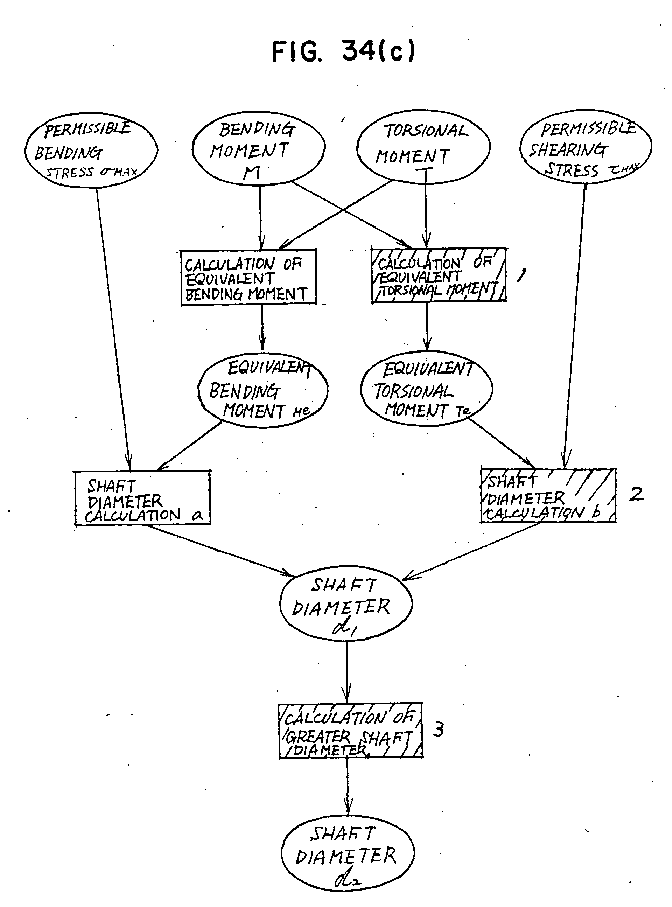

Figs. 34(a) to 34(c) illustrate an exemplary method of adding newly data processing(s) to the data processing execution sequence stored already. In conjunction with Fig. 32, preparation of the design means for the stepped shaft by making use of the design procedure for the (stepless) shaft made of a ductile material, wherein the greater shaft diameter calculations are added to the data processing execution sequence for the stepless shaft in the order of the sequence. Fig. 34(a) shows a design procedure of a (stepless) shaft made of a ductile material. In Fig. 34(b), there is illustrated a method of selecting the greater shaft diameter calculation which is the data processing. In correspondence with this selection, the design procedure for the (stepless) shaft of a ductile material shown in Fig. 34(a) is retrieved by the retrieving means, wherein on the basis of the decision that the added data processing must succeeds to the shaft diameter calculation a in the execution sequence, the data processing execution sequence shown in Fig. 34(c) is automatically derived. If the added data processing can not be definitely determined in respect to the location in the sequence, it may be determined through interaction with the designer or automatically by consulting predetermined criteria for decision. For dealing with the case in which data processings are to be newly added, the instant method is advantageous when compared with the method shown in Fig. 3 according to the sequence or order of all the data processings are determined, since the former is more susceptible to the facilitated manipulation.

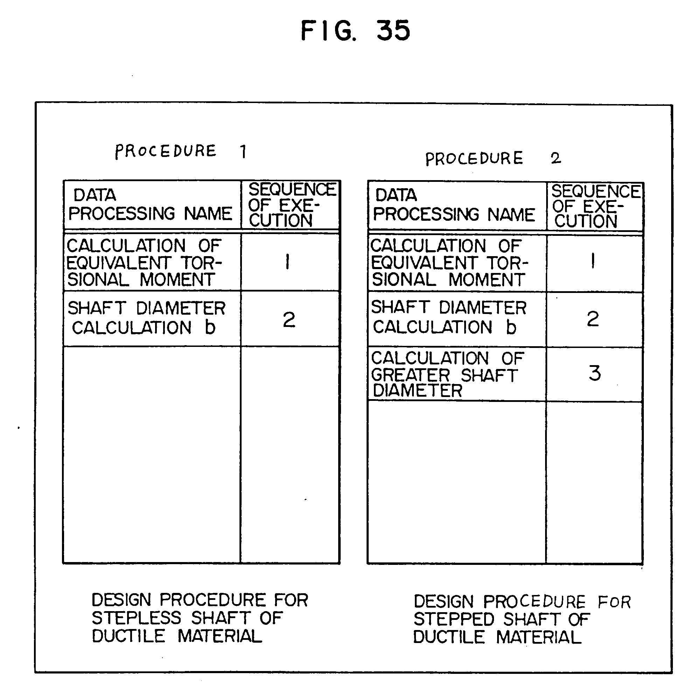

Fig. 35 shows an exemplary method of storing the additionally prepared data processing execution sequence (Fig. 34) for the stepped shaft together with the data processing execution sequence for the stepless shaft data processing execution sequence. This storage method is advantageous in that the memory capacity can be reduced by establishing correspondences between a set of the design data name, data processing name and the input/output relation information and the executions of plural different data processings in sequence. Further advantage may be seen in that generalization of the design data name, the data processing name and the input/output relation information can be easily realized.

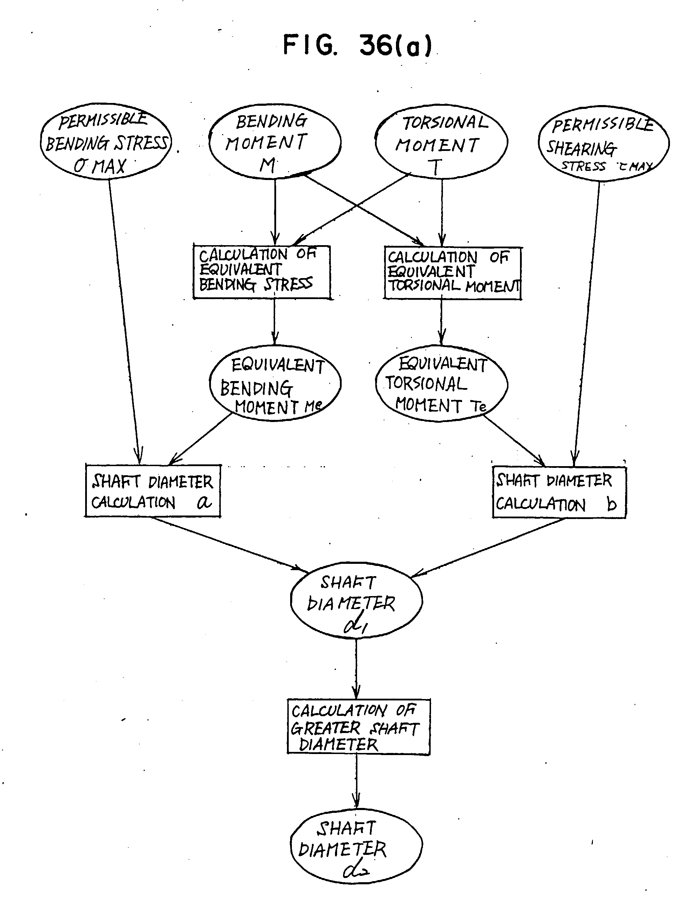

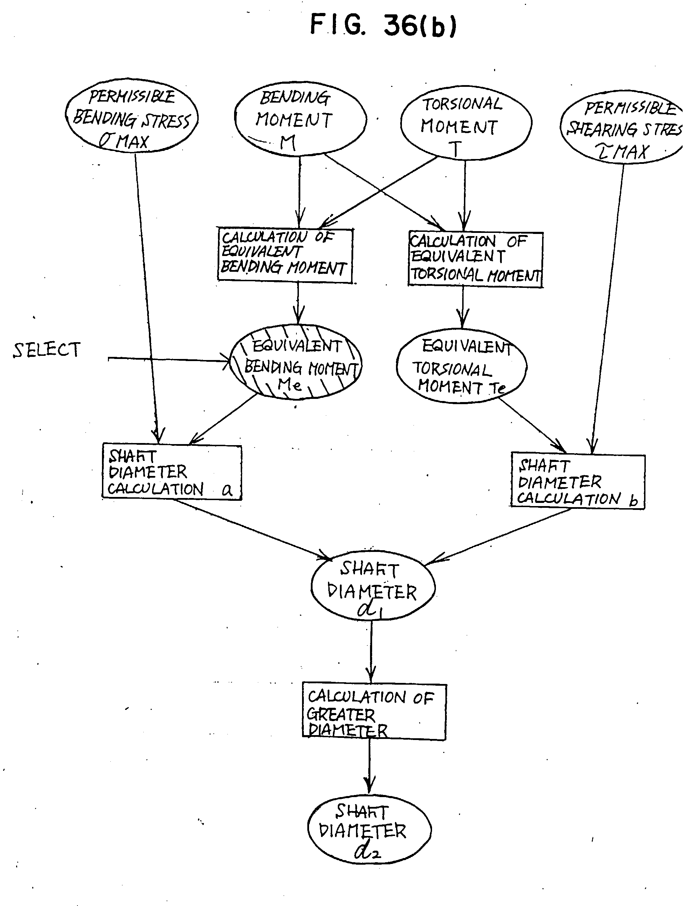

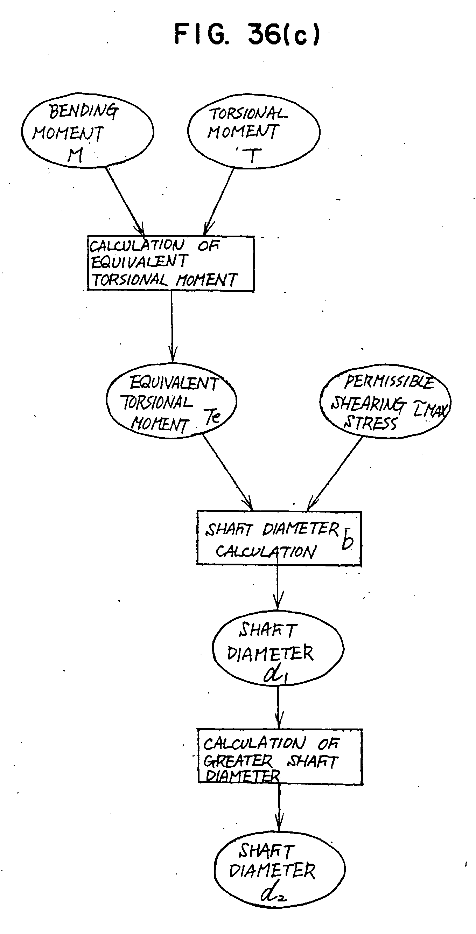

Figs. 36(a) to 36(c) show a method of modifying or altering by deletion the design data names, the data processing names and the input/output relation information by the design data name, data processing name and input/output relation information generating means 11 shown in Fig. 1. More specifically, Figs. 36(a) to 36(c) show displays generated on the screen of the graphic terminal 111 shown in Fig. 3 for the case where the design procedure for the shaft of a fragile or brittle material is deleted from the state shown in Fig. 28(g) for the reason that such practical application is scarcely conceivable. By taking as an example the deletion of the equivalent bending moment related only to the fragile material, a method of deletion will be explained below. There is no difference between Fig. 36(a) and Fig. 28(g). In the state shown in Fig. 36(b), the equivalent bending moment to be deleted is selected. When the equivalent bending moment to be deleted is selected, all the data processings (i.e. equivalent bending moment calculation in the case of the illustrated example) and all the data processing having the inputs supplied with the equivalent bending moment (i.e. the shaft diameter calculation in the case of the illustrated example) are retrieved by following the input/output relations to thereby decide whether deletion should be made or not. More specifically, in conjunction with the equivalent bending moment calculation, it is checked whether there is other output than the equivalent bending moment which is subject to be deleted. When there exist the other output, the associated equivalent bending moment calculation is excluded from the deletion. Otherwise, the calculation is subjected to the deletion. In the case of the illustrated example, any other output is absent. Accordingly, it is decided that the equivalent bending moment calculation is to be deleted. On the other hand, in the case of the shaft diameter calculation a, the input thereto is subject to be deleted and thus selected for deletion automatically. Subsequently, by following up the input/output relation between the equivalent bending moment calculation and the shaft diameter calculation a newly added as the objectives for deletion, decision as to the deletion is made. More specifically, in the case of the equivalent bending moment calculation, the bending moment and the torsional (twisting) moment which are the inputs to this calculation have to be considered. However, since both of these design data (i.e. the bending and torsional moments) also constitute the inputs to the other data processing (i.e. equivalent torsional moment calculation), they are excluded from the deletion. On the other hand, in the case of the shaft diameter calculation a, the permissible bending stress which is the other input to the shaft diameter calculation a than the equivalent bending moment and the shaft diameter which is the output of the calculation a have to be taken into account. In this case, the permissible bending stress constitutes no input to other data processing and is thus subjected to the deletion. In contrast, the shaft diameter constitutes the input to other data processing (i.e. shaft diameter calculation b) and is thus excluded from the deletion. Next, by following the input/output relation of the permissible bending stress newly added as the objective for the deletion, decision as to further deletion is performed. Since the permissible bending stress has no data processing for the outputting thereof, the whole deletion processing comes to an end. As the result, there can be obtained the design data names, the data processing names and the input/output relation information from which those partaking in the design procedure for the shaft of a fragile material is deleted, as is shown in Fig. 36(c).

When the design data names, the data processing names and the input/output relation information are altered or deleted in this manner, the data processing execution sequence prepared in correspondence to the design data names, the data processing names and the input/output relation information is also subject to the alteration. By way of example, when the equivalent bending moment calculation and the shaft diameter calculation a are deleted as in the case of the illustrated example described above, the execution sequence including these data processing is deleted as well. In the case of the example illustrated in Fig. 35, since none of the execution sequence including both the equivalent bending moment calculation and the shaft diameter calculation a, there is no execution sequence to be deleted.

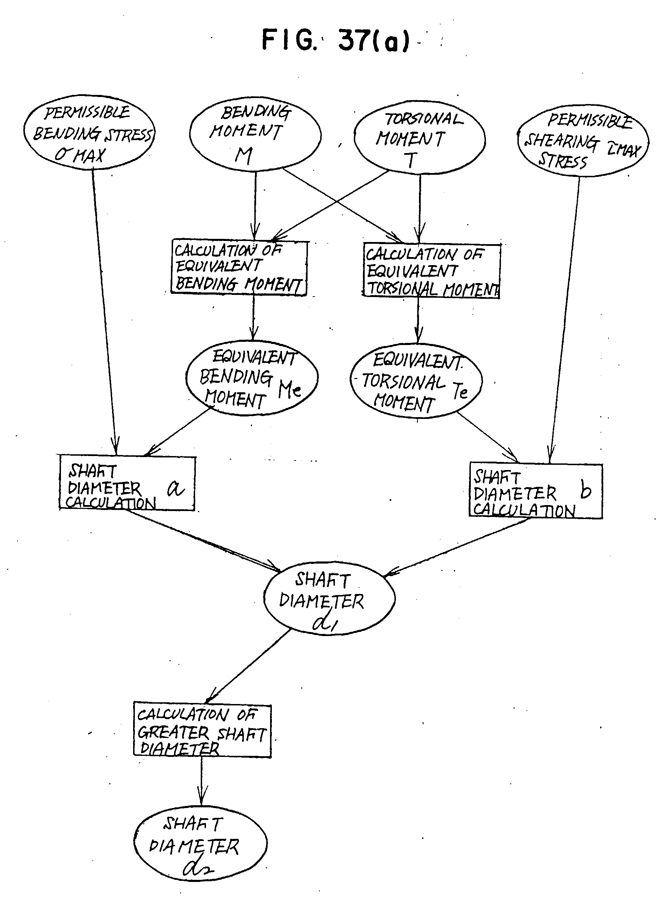

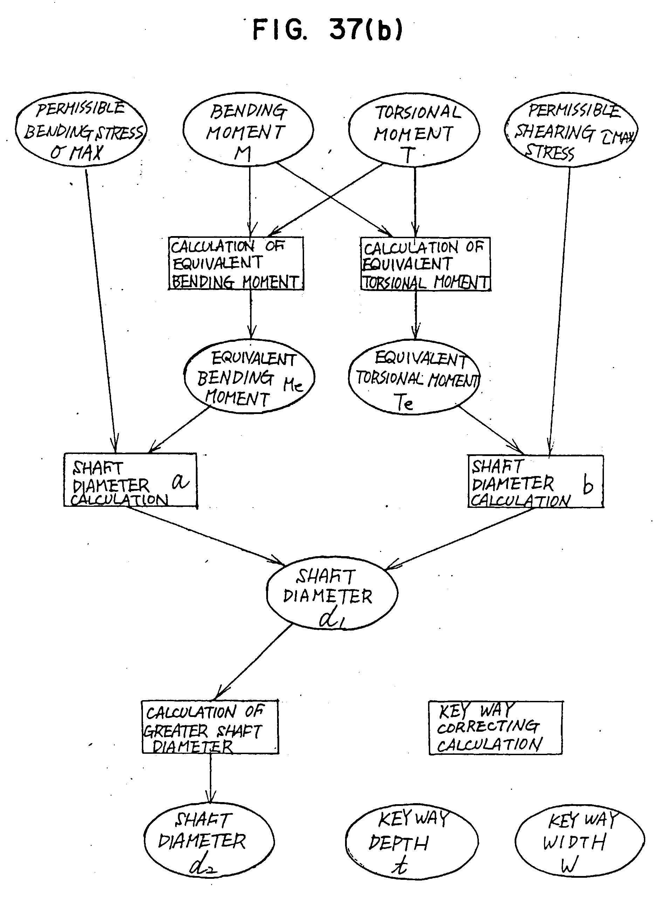

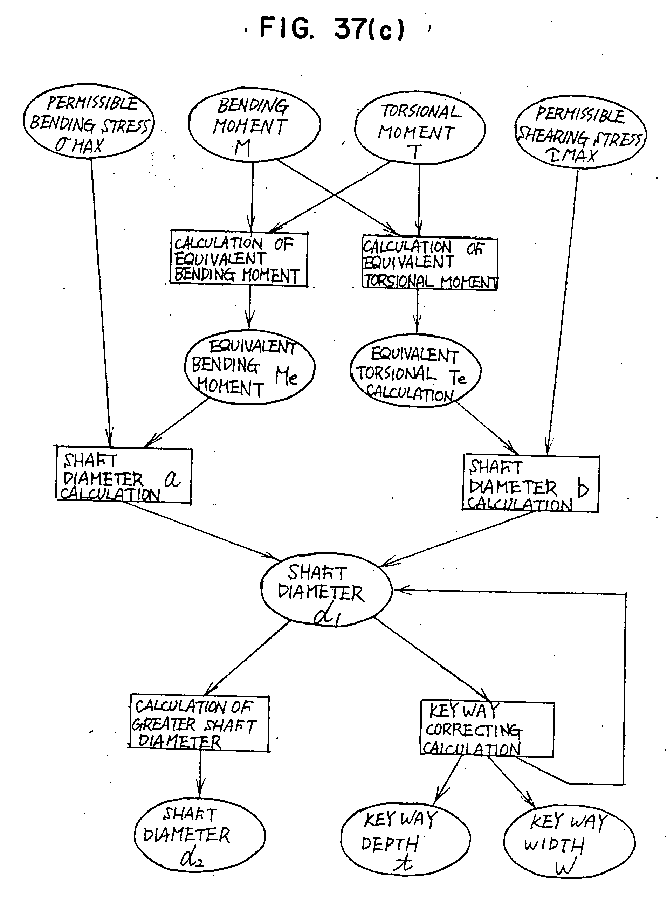

Fig. 37(a) to 37(c) show an exemplary method of altering by addition the design data names, the data processing names and the input/output relation information by the design data name, data processing name and input/output relation information generating means 11 shown in Fig. 11. The contents shown in Fig. 37(a) to 37(c) are displayed on the graphic terminal 111 shown in Fig. 3. According to the instant method, a design procedure concerning a key way is added to the state illustrated in Fig. 28(g). More specifically, configuration of the key way is determined on the basis of the shaft diameter calculated through the shaft diameter calculation processing and additionally the diameter of the shaft is corrected. There is no difference in the contents between Fig. 37(a) and Fig. 28(g). In the state shown in Fig. 37(b), a key way correcting calculation is defined and enclosed by a rectangle to thereby input the indication that the key way correcting calculation is a data processing name. A key way depth and a key way width which are the outputs of the key way correcting calculation processing are defined and enclosed by respective ellipses to thereby input the indication that the key way depth and the key way width are design data names, respectively. In the state shown in Fig. 37(c), the shaft diameter and the key way correcting calculation are linked together by an arrow to input the indication that the shaft diameter is an input to the key way correcting calculation, while the key way correcting calculation is linked with the key way depth, the key way width and the shaft diameter by respective arrows (arcs) to input the indication that the key way depth, the key way width and the shaft diameter are outputs of the key way correcting calculation. It is to be noted that in the case of the instant example, the shaft diameter constitutes both the input and output design data of the key way correcting calculation. As the result, the design data name, the data processing names and the input/output relation information thus altered through addition are stored in the design data name, data processing and input/output relation information storage means 1 shown in Fig. 1. When additional input/output relation is newly generated between the data processings due to the addition mentioned above, the execution sequence of the data processings prepared in correspondence to the design data names, the data processing names and the input/output relation information before the addition described above is also subjected to alteration. In the case of the illustrated example, however, no new input/output relation is generated between the data processings before the addition, there arises no necessity of alteration of the execution sequence.

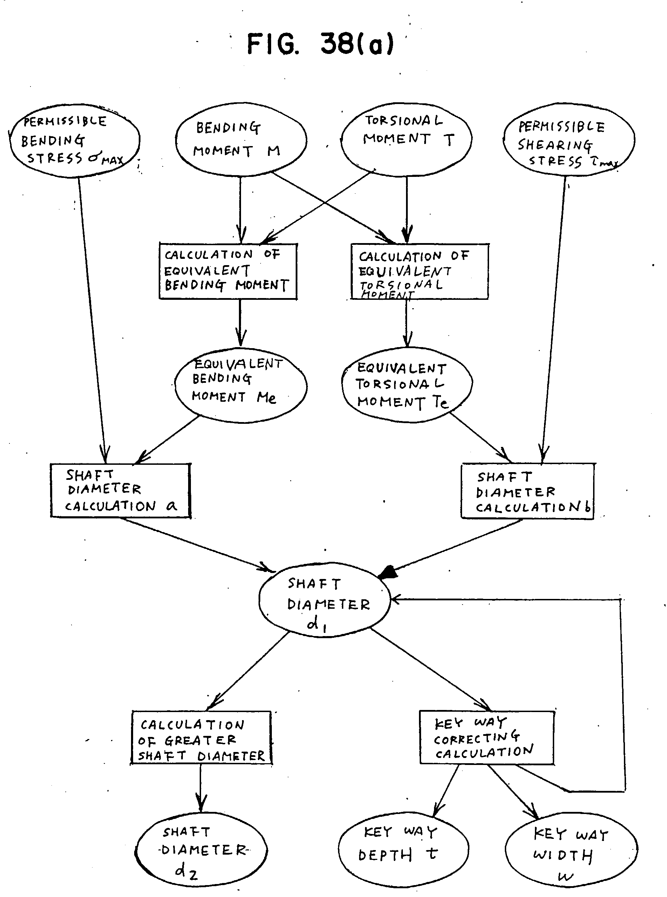

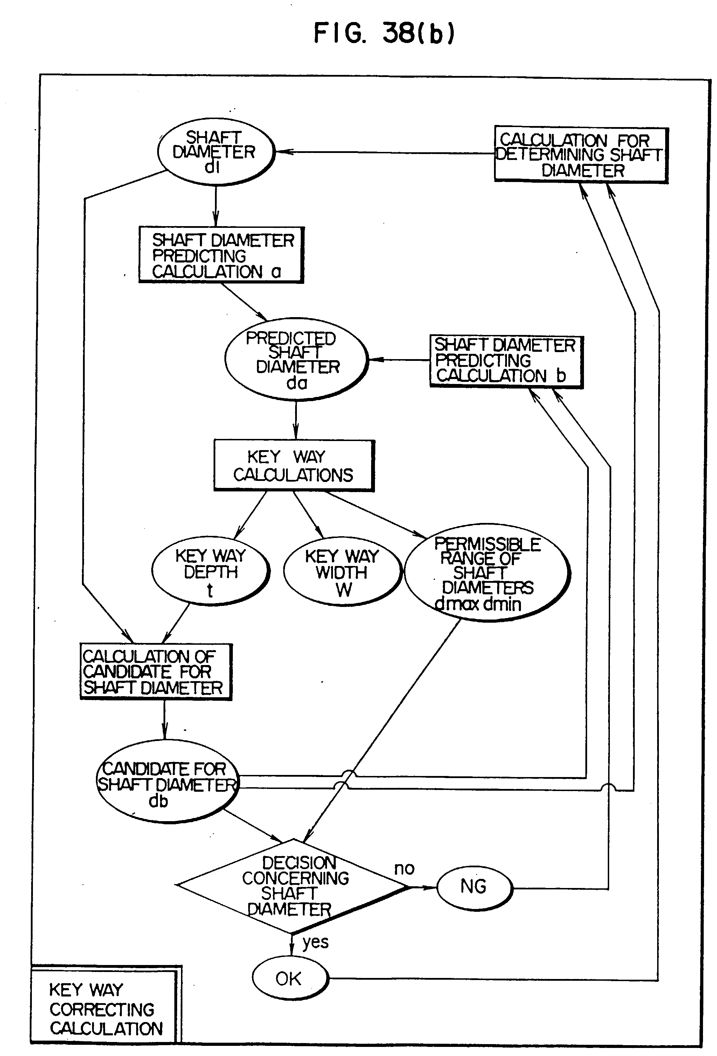

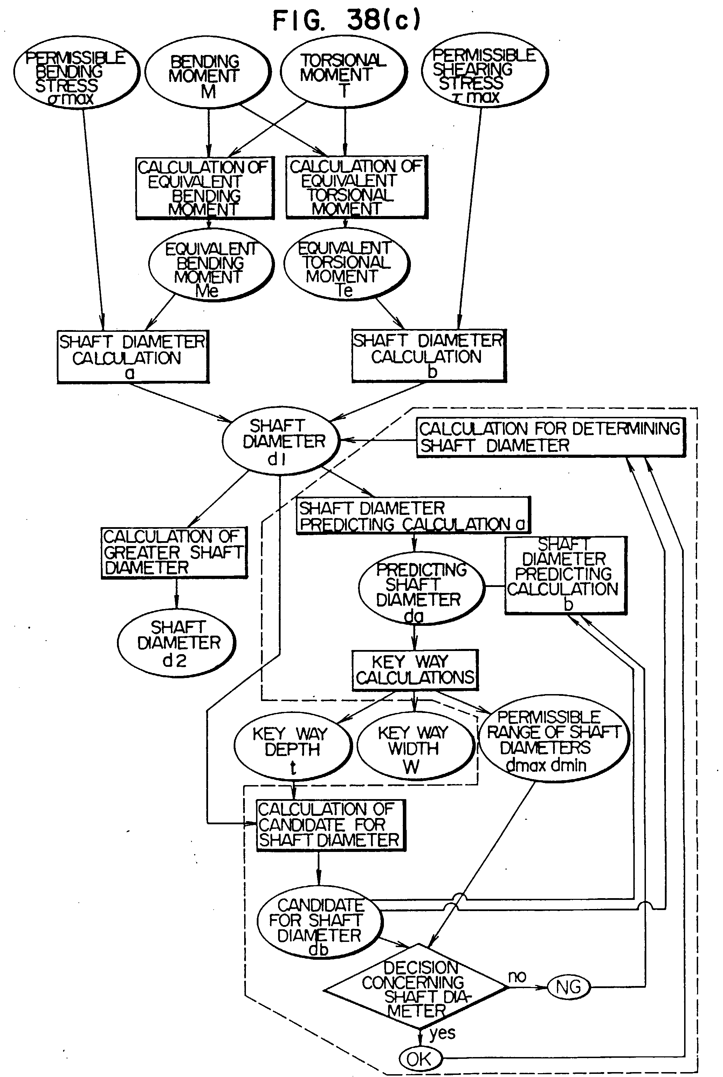

Figs. 38(a) to 38(c) show an exemplary case where more detailed contents of a data processing is expressed in terms of design data names, a data processing name and input/output relation information in a hierarchical structure in the embodiment shown in Fig. 1. More specifically, Figs. 38(a) to 38(c) show in what manner the detailed content of the key way correcting calculation added as described above by reference to Fig. 37 is expressed. The concrete contents of the added calculation includes prediction of the diameter of the shaft with the key way on the basis of the shaft diameter d1 without the key way and determination of the key way depth and the key way width as well as the range of the applicable shaft diameters with reference to the standards. It is decided whether a candidate for the shaft diameter corresponding to the addition of the key way depth to the diameter d1 of the shaft in which no consideration is paid to the key way is within the range of the applicable shaft diameters or not. If the result of the above decision is affirmative (OK), the candidate is selected as the shaft diameter. Otherwise, the above decision is repeated until a candidate for the shaft diameter falling within the range of the predicted values is found. In the state shown in Fig. 38(a), the key way correcting calculation is regarded as one of the data processing, wherein the design data names, the data processing name and the input/output relation information are expressed in a network structure, as in the case of Fig. 37(c). In the state shown in Fig. 38(b), further detailed contents of the data processing "key way correcting calculation" is expressed in the form of a network including the design data names, the data processing name and the input/output relation information. Due to the expression in the hierarchical structure as in the case of the instant example, the network expression for the global contents and the network expression for the detailed contents can be used discriminatively from each other. In the state shown in Fig. 38(c), the detailed contents of the data processing "key way correcting calculation" shown in Fig. 38(b) is developed and consolidated in the network shown in Fig. 38(a). portion enclosed by a broken line corresponds to the detailed content of the key way correcting calculation.

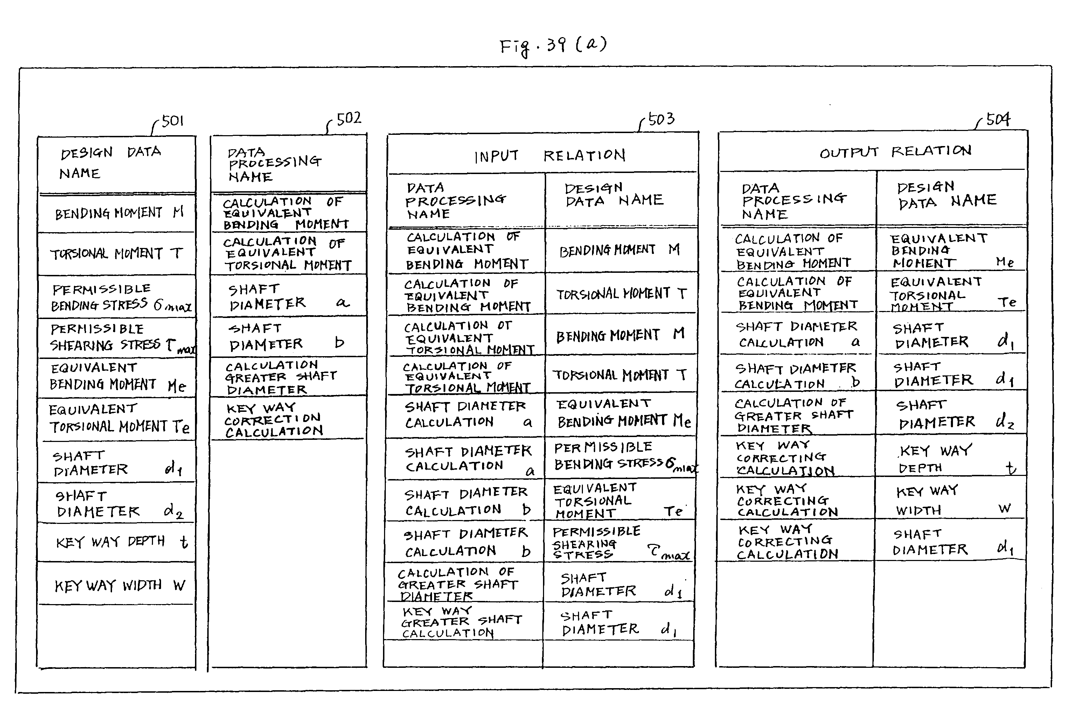

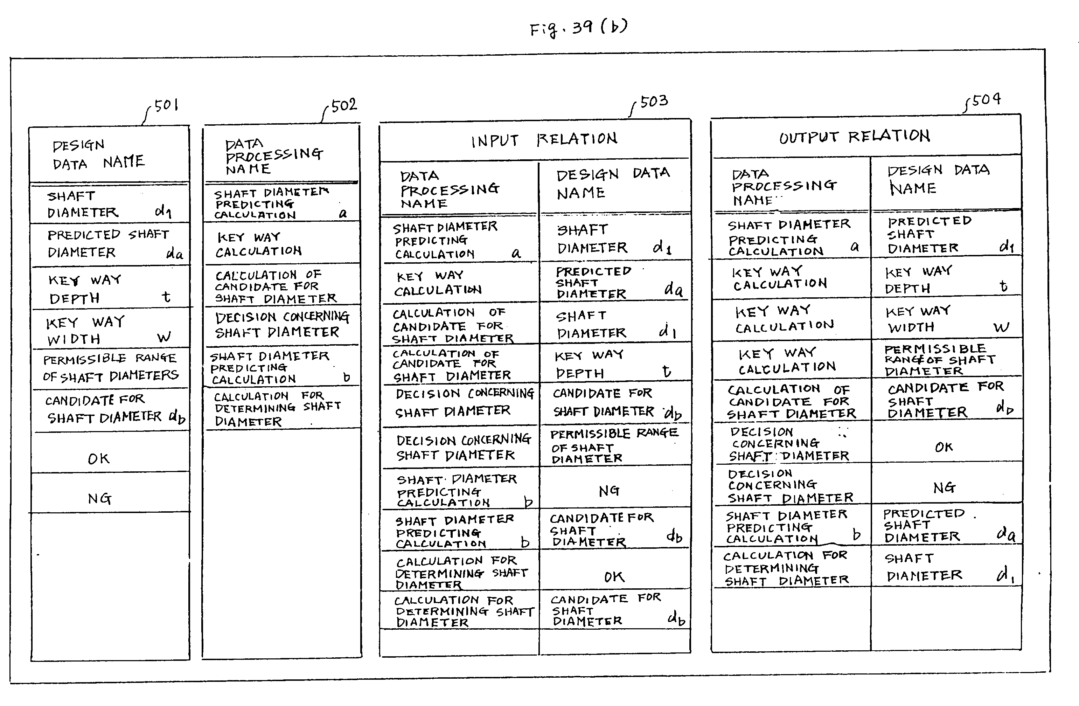

Fig. 39(a) and 39(b) show an exemplary method of storing the design data names, the data processing names and the input/output relation information in the design data names, the data processing name and the input/output relation information storage means 1 shown in Fig. 1 in the case where the further detailed contents of a data processing assumes a hierarchical structure expressed by the design data names, the data processing names and the input/output relation information. More specifically, Figs. 39(a) and 39(b) show the results of the design data names, the data processing names and the input/output relation information in the states shown in Figs. 38(a) and 38(b), respectively. As will be seen from Figs. 39(a) and 39(b), it is possible to store the network information by storing pluralities of the design data names, the data processing names and the input/output relation information and establishing the correspondence by using pointers, for example, from the data names. It should however be mentioned that the corresponding design data names shown in Figs. 39(a) and 39(b), respectively, need not necessarily be made to coincide with each other.

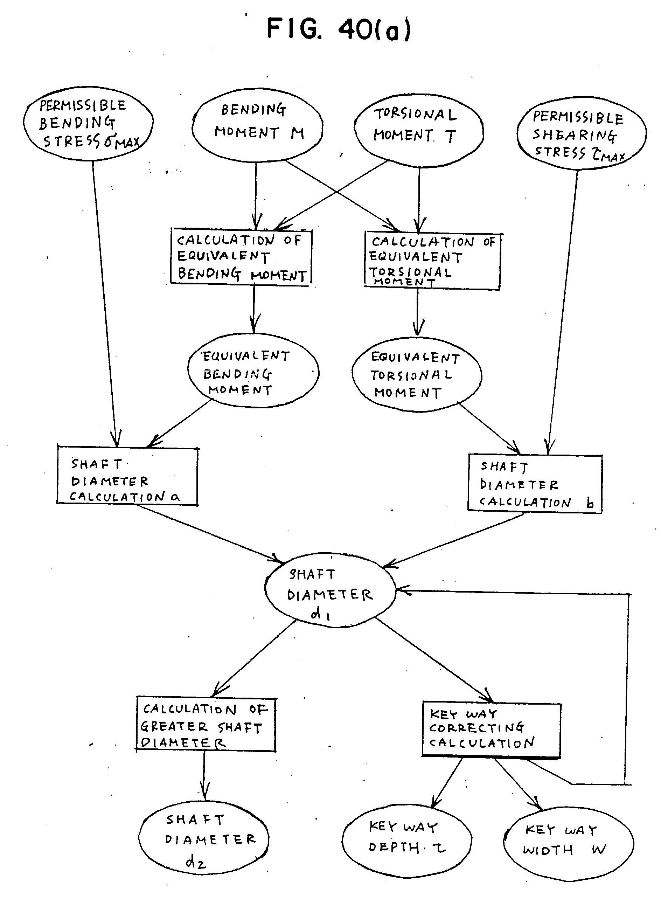

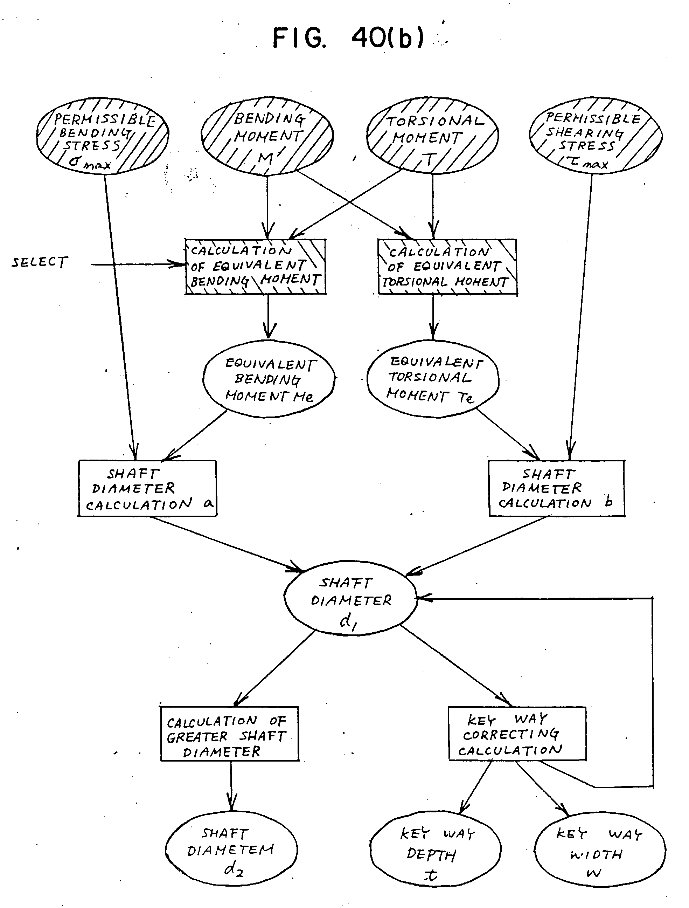

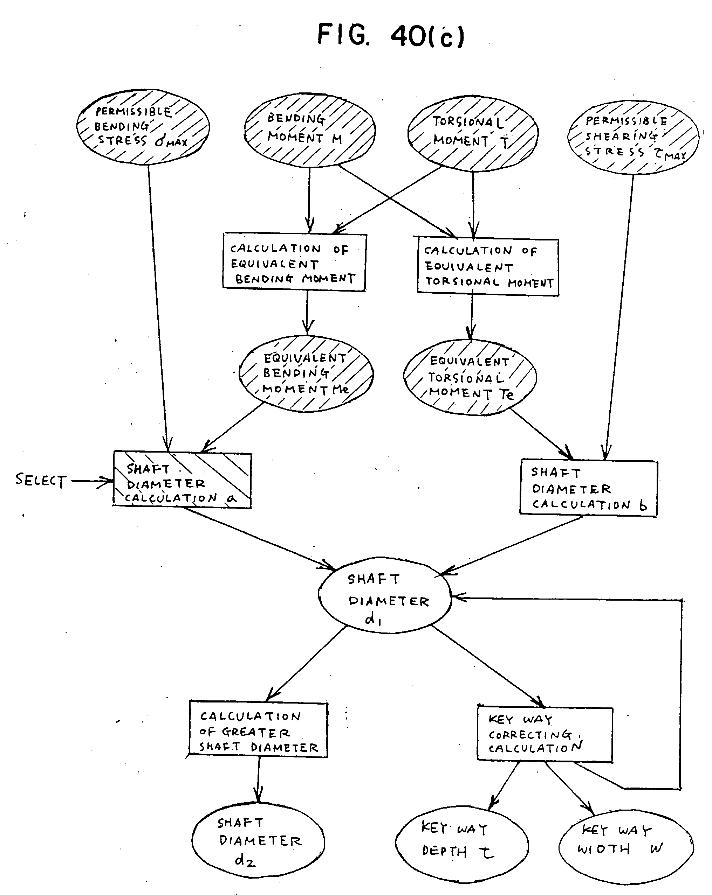

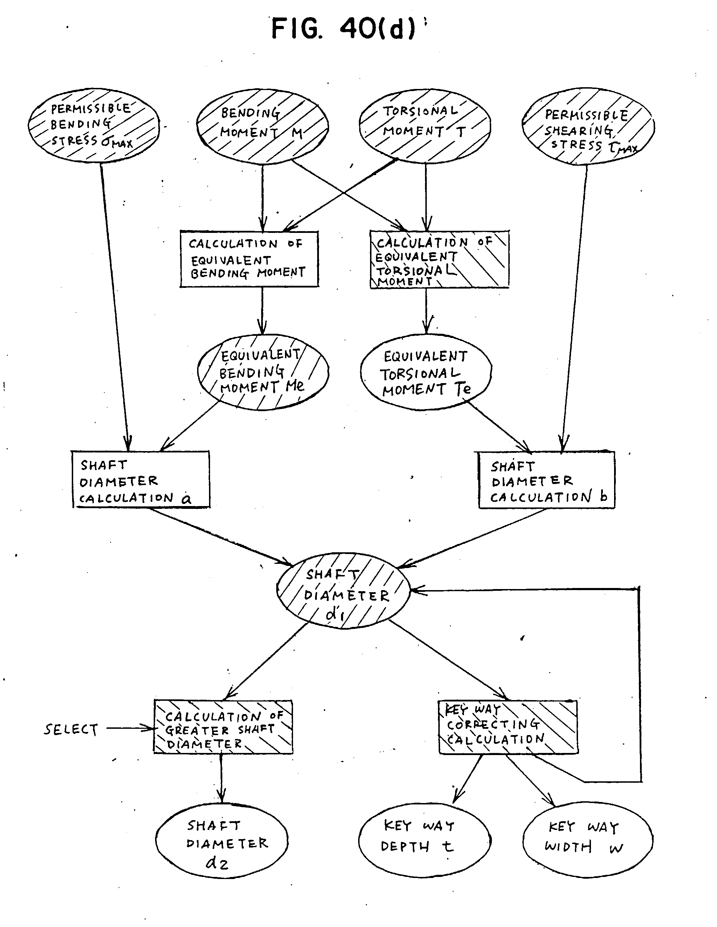

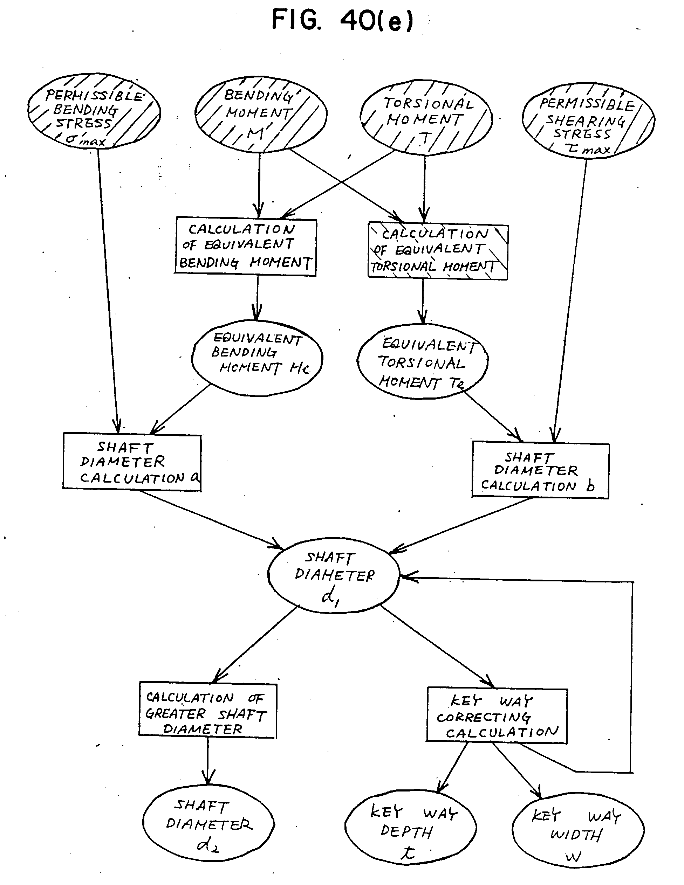

Figs. 40(a) to 40(e) are views for illustrating a method of implementing the executable data processing name selecting means 5 shown in Fig. 12 through interactive (dialogical) inputting with the designer on the assumption that the network information illustrated in Fig. 38(a) is stored in the design data names, the data processing name and the input/output relation information storing means, wherein the bending moment, the torsional (twisting) moment, the permissible bending stress and the permissible shearing stress represent, respectively, the design data names having the respective initial contents determined. Fig. 40(a) illustrates the initial state before the design data having the contents determined are inputted, as in the case of Fig. 38(a). In the state illustrated in Fig. 40(b), there are inputted the design data name "bending moment", "torsional moment", "permissible bending stress" and "permissible shearing stress" the initial contents of which have already been determined, while the executable data processings "equivalent bending moment calculation" and "equivalent torsional moment calculation" have been retrieved and designated distinctively by hatching. It will additionally be seen that the design data names having the respective contents determined are also designated discriminatively by hatching. Since the design data required for the design of the shaft formed of a fragile material is the equivalent bending moment, there is selected the bending moment calculation as the data processing to be actually executed. In the state shown in Fig. 40(c), the design data "equivalent bending moment" whose content has been determined as the result of execution of the equivalent bending moment calculation is added and displayed distinctively, while the executable data processing "shaft diameter calculation a" is retrieved and displayed distinctively by hatching. Since the equivalent bending moment calculation has been executed at this stage or level, this processing name is excluded from the set of the executable data processing names. Thus, at this stage, the executable data processing names are the equivalent torsional moment calculation and the shaft diameter calculation a, respectively. As the data processing name to be actually executed, there is selected the shaft diameter calculation a for the design of a shaft of a fragile material. In the state illustrated in Fig. 40(d), the design data "shaft diameter d1" having the content determined as the result of execution of the shaft diameter calculation a is added and displayed discriminatively, while the executable data processings "greater shaft diameter calculation" and "key way correcting calculation" are retrieved and display discriminatively in addition. Since the shaft diameter calculation a has been executed at this stage, this processing name is excluded from the names of the executable processings. Thus, the executable data processing names at this stage are the equivalent torsional moment calculation, the greater shaft diameter calculation and the key way correcting calculation, wherein there is selected as the data processing name to be actually executed the greater shaft diameter calculation required for the design of the stepped shaft. In the state illustrated in Fig. 40(e), the design data "shaft diameter d2" having the determined by executing the greater shaft diameter calculation is added and displayed distinctively. Since the greater shaft diameter calculation has been executed at this stage, this processing name is excluded from the names of the executable data processings. The design procedure processing under consideration them comes to an end since both the design data "shaft diameter d1" and "shaft diameter d2" required for the design of the stepped shaft of a fragile material have now been available. The data processing execution sequence stored in the data processing execution sequence storage means 2 is in the order of the equivalent bending moment calculation, the greater shaft diameter calculation and the shaft diameter calculation a. The above description of the instant example has been made on the assumption that the data processing names to be actually executed are selected through interaction with the designer. It should however be understood that such selection may be programmed as a procedure which can be executed automatically. By way of example, when the existing sequence already stored in the data processing execution sequence storage means 2 is adopted, detection of error in the existing sequence may be facilitated by providing a decision step for determining whether the data processing selected in accordance with the existing sequence is covered by the executable data processing name.

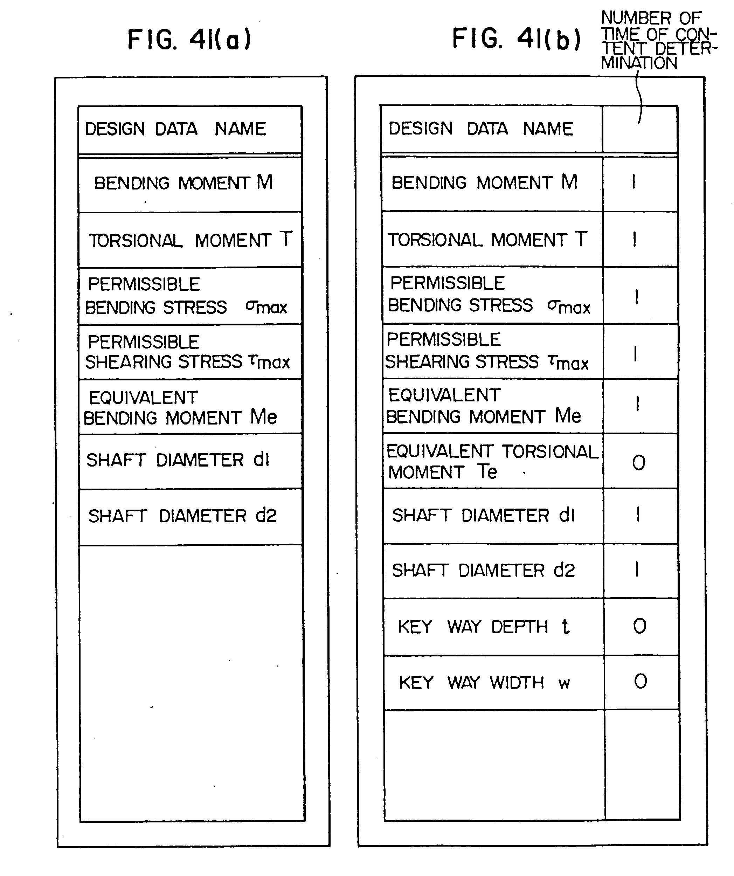

Figs. 41(a) and 41(b) show two exemplary methods of storing the design data names having the respective content determined in the content-determined design data name storage means shown in Fig. 12 on the assumption that the content-determined design data names in the state illustrated in Fig. 4(e) are stored. According to the method illustrated in Fig. 41(a), the content-determined data names are stored simply as the design data names of which contents have been determined. According to a method shown in Fig. 41(b), all the design data names are stored each in a pair with the number of times the content thereof has been determined. Accordingly, those design data names which are paired with more than one (inclusive) times of the content determinations indicate the design data names having the contents already determined.

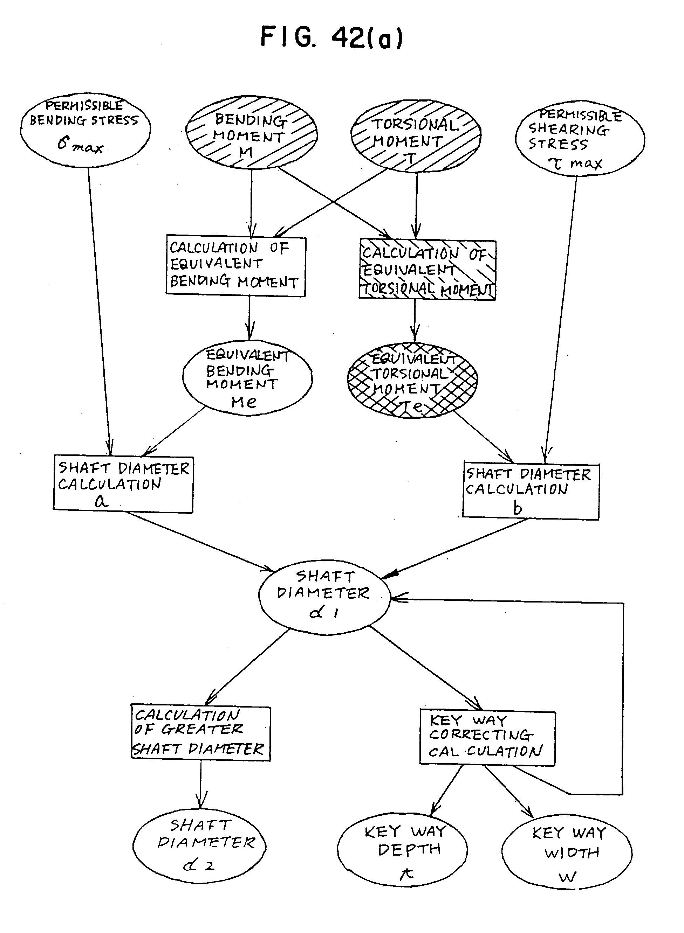

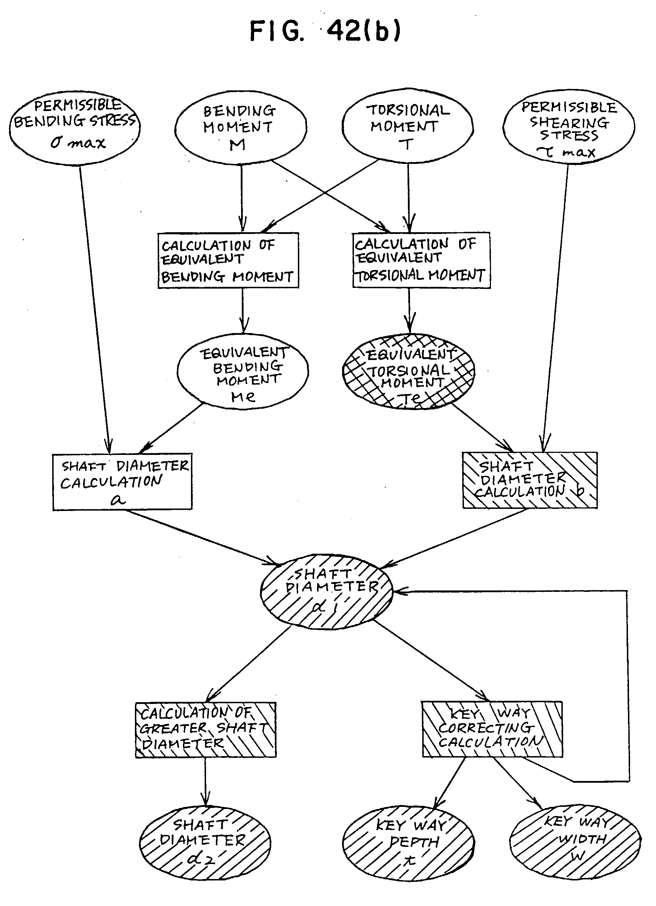

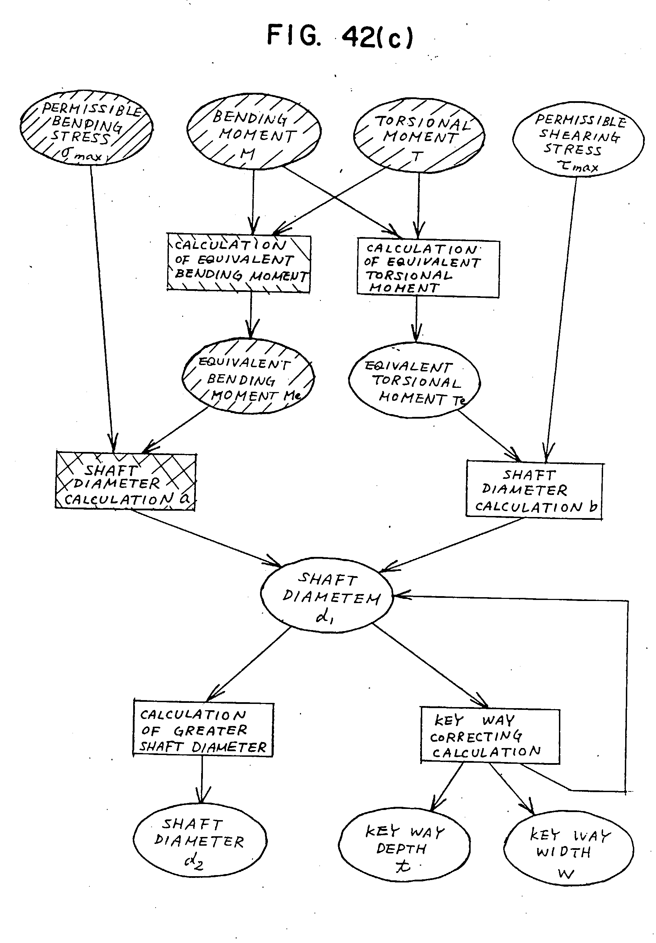

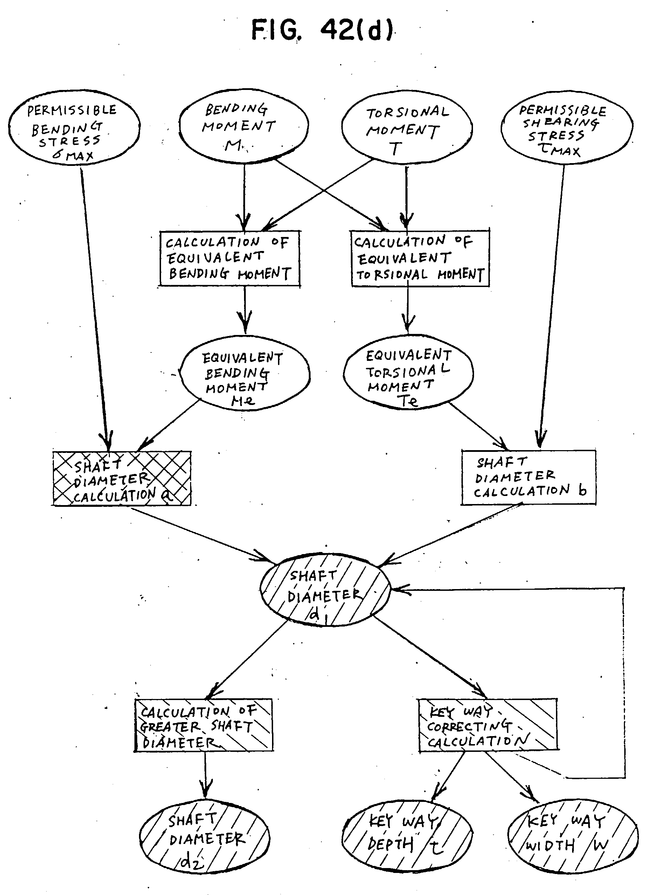

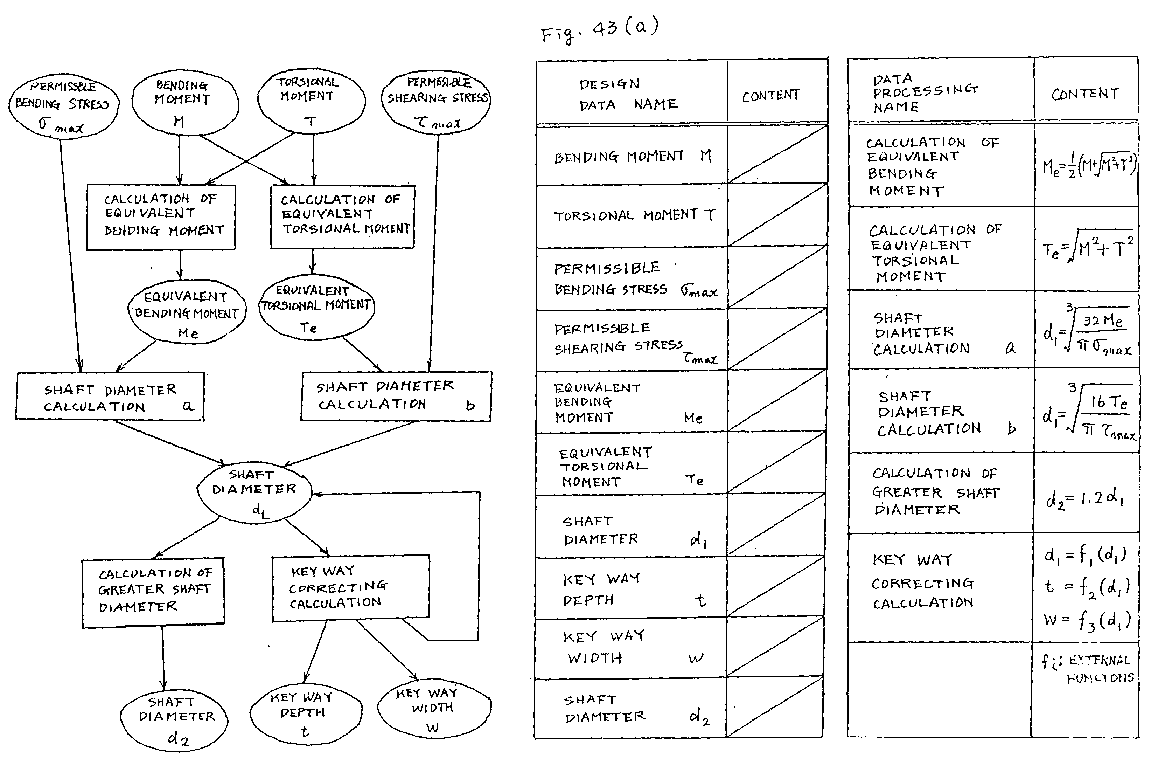

Figs. 42(a) to 42(d) are views illustrating, by way of example only, operation of the embodiment shown in Fig. 22 on the assumption that the processing is performed on the basis of the same network information as that shown in Fig. 38(a). In the state shown in Fig. 42(a), the design data "equivalent torsional (twisting) moment" has been selected, wherein the upstream retrieval required for determining the design data name "equivalent torsional moment" has been performed in accordance with the operation procedure shown in Fig. 23. The retrieved names are discriminatively displayed as indicted by hatching in the drawing. In the state shown in Fig. 42(b), the design data "equivalent torsional moment" has been selected and the downstream items susceptible to the influence of the design data are retrieved in accordance with the operation procedure shown in Fig. 23. The retrieved name is displayed distinctively as indicated by hatching in Fig. 42(b). In the state illustrated in Fig. 42(c), the data processing "shaft diameter calculation a" has been selected, wherein the upstream retrieval required for executing the shaft diameter calculation a has been performed in accordance with the operation procedure shown in Fig. 23. The retrieved name(s) is distinctively displayed as indicated by hatching in the figure. In the state shown in Fig. 42(d), the data processing "shaft diameter calculation" has been selected, wherein the downstream items susceptible to the influence of this data processing have been retrieved in accordance with the operation procedure shown in Fig. 23. The retrieved name(s) is distinctively displayed as indicated by hatching in the figure.

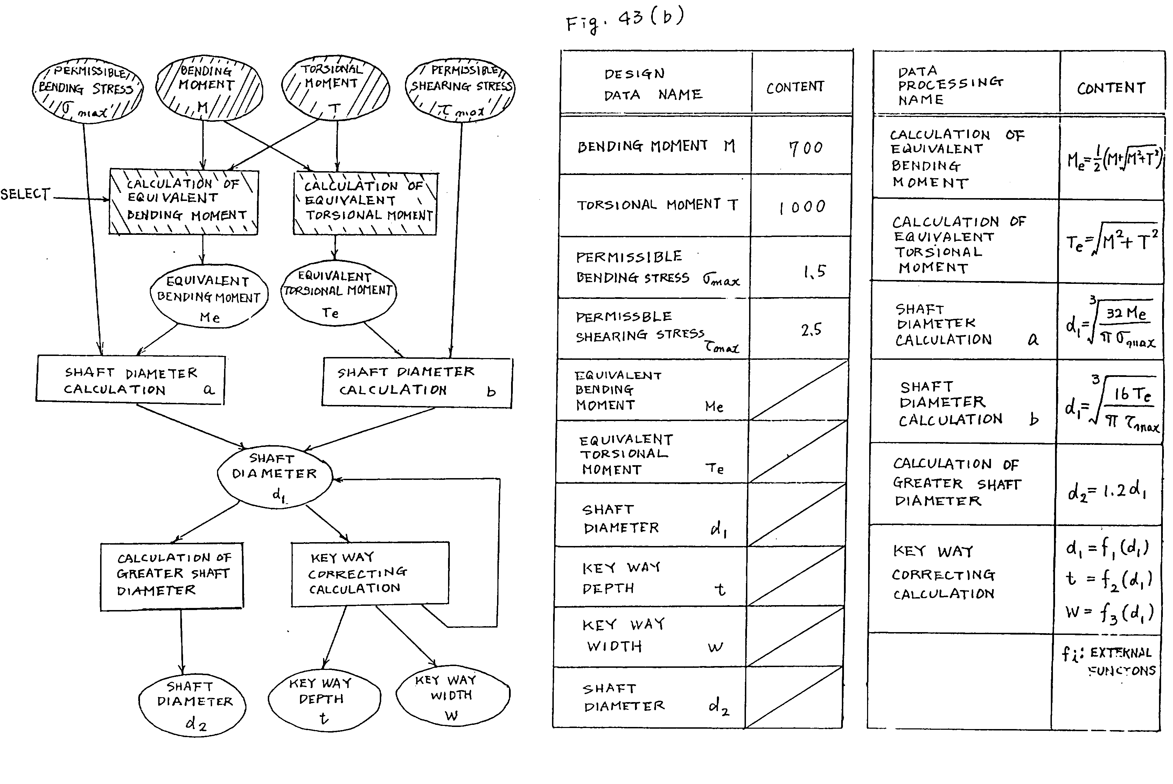

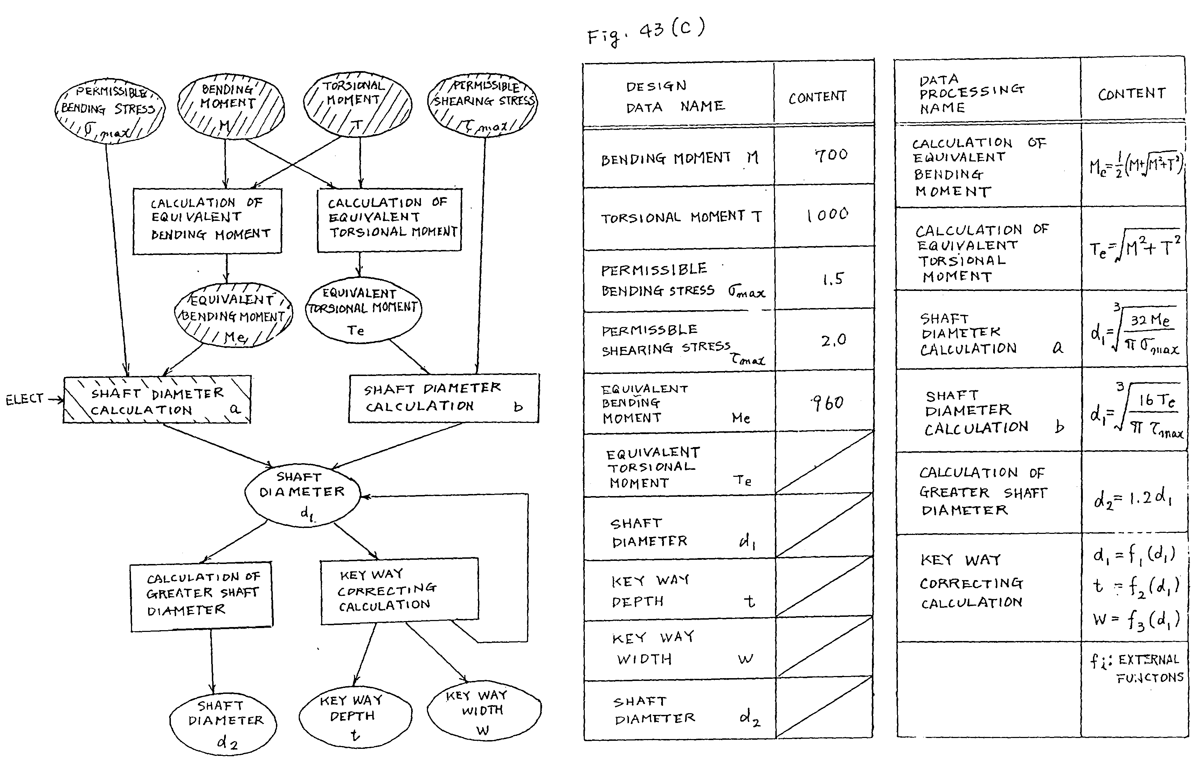

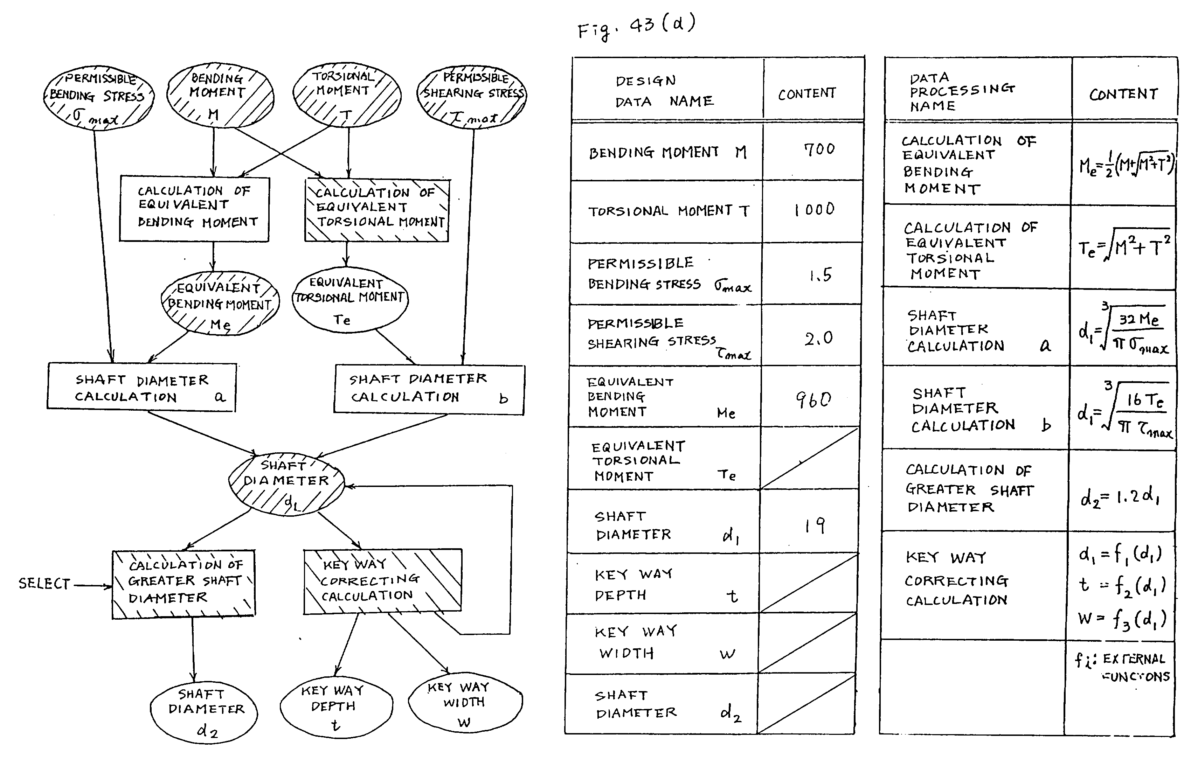

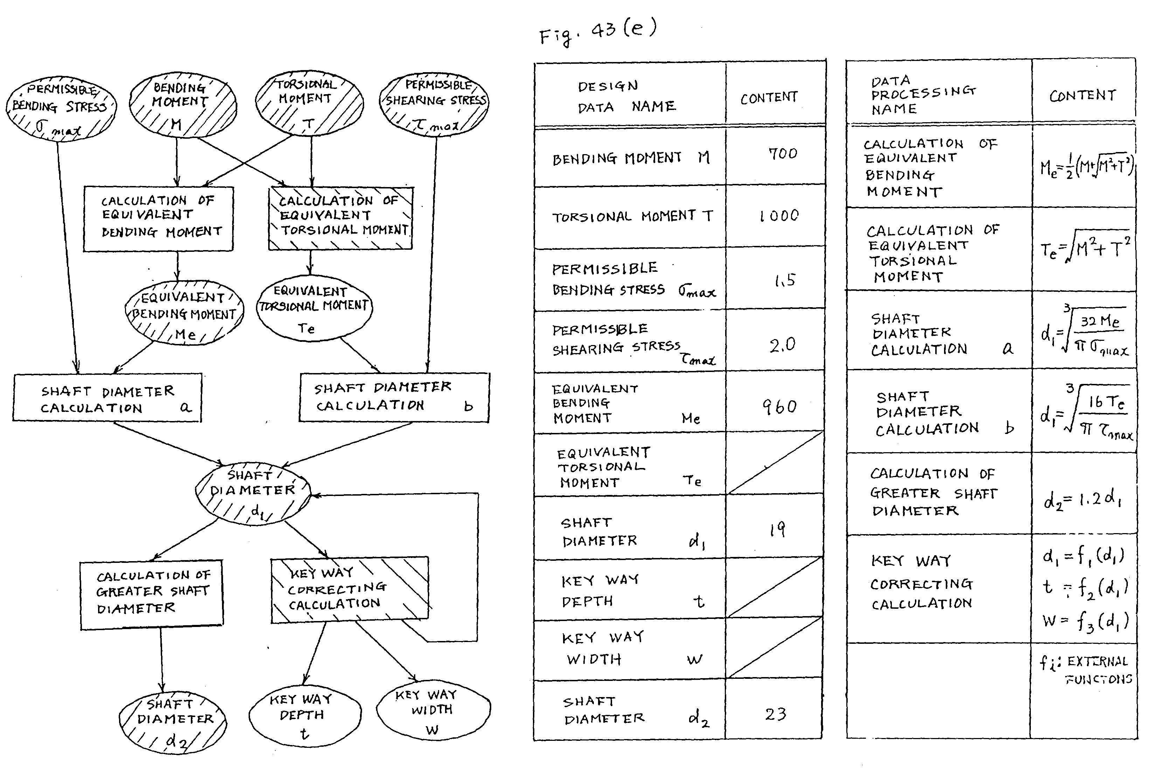

Figs. 43(a) to 43(e) are views for illustrating by way of example, operation involved in the design calculation procedure carried out by the embodiment shown in Fig. 16. More specifically, Figs. 43(a) to 43(e) show displays generated on the graphic terminal shown in Fig. 3, the contents in the design data content storage means 7 shown in Fig. 16 and the contents in the data processing content storage means 8 shown in Fig. 16. In the state shown in Fig. 43(a), the design data names, the data processing names and the input/output relation information have been inputted with the data processing contents being additionally inputted. In the state shown in Fig. 43(b), the initial values for the design data contents are inputted, as the result of which the data processings "equivalent bending moment calculation" and "equivalent torsional calculation" can be executed. In the state shown in Fig. 43(c), the equivalent bending moment calculation is selected and executed by the data processing executing means 9, whereby the content of the design data "equivalent bending moment" is determined, as the result of which the data processing "shaft diameter calculation a" can be executed. In the state shown in Fig. 43(d), there is selected the data processing "shaft diameter calculation a" which is executed by the data processing executing means 9 to thereby determine the content of the design data "shaft diameter d1", as the result of which the data processings "greater shaft diameter calculation" and "key way correcting calculation" can be executed. In the state illustrated in Fig. 43(e), the data processing "greater shaft diameter" is selected and executed by the data processing executing means 9, whereby the content of the design data "shaft diameter d2" is determined. The procedure then comes to an end.

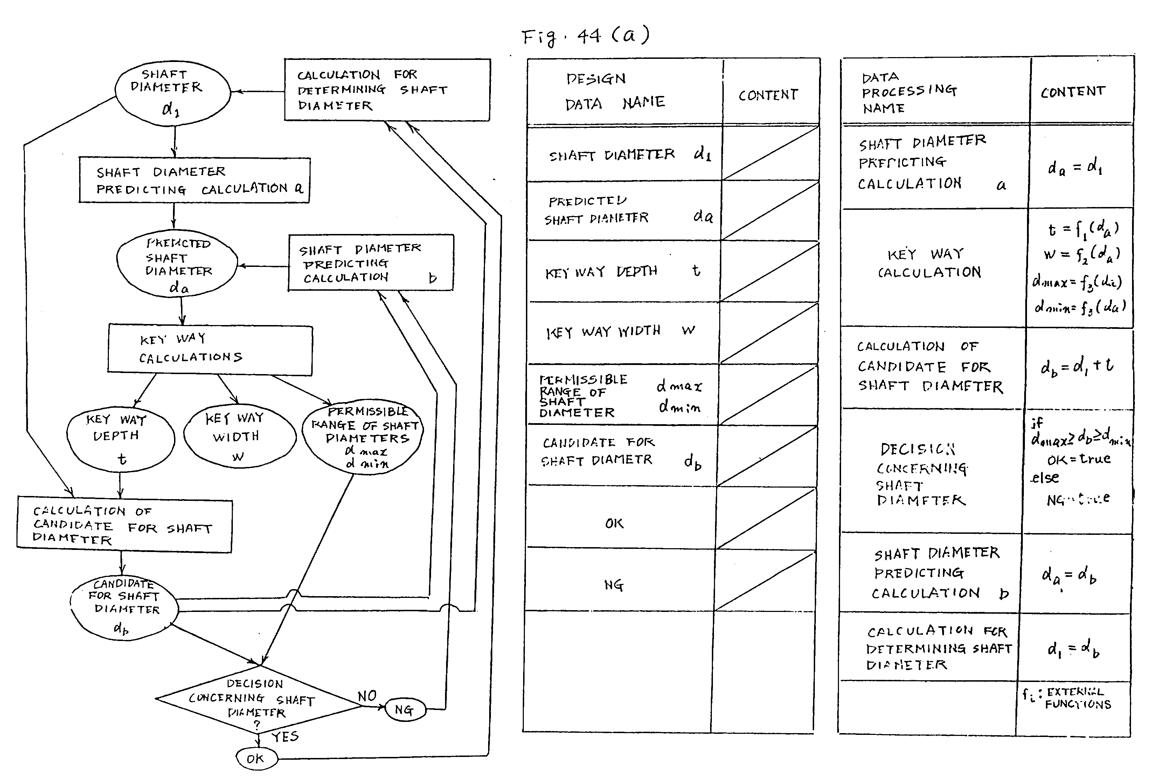

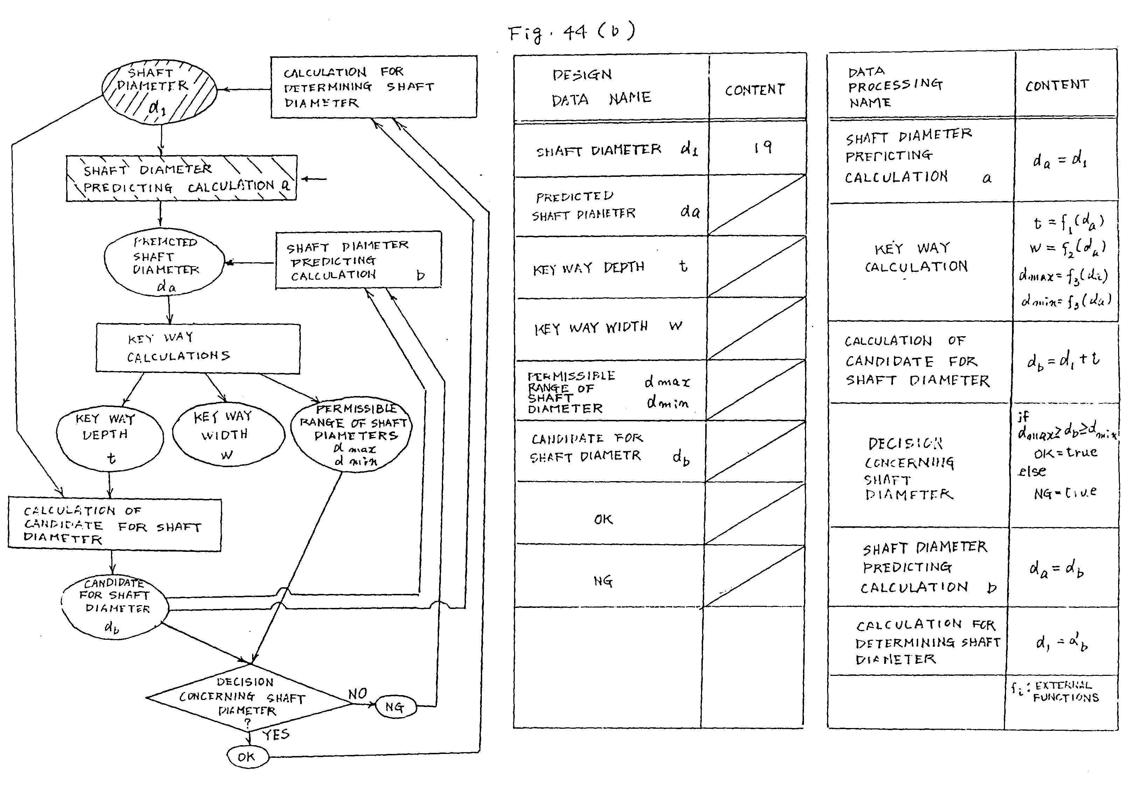

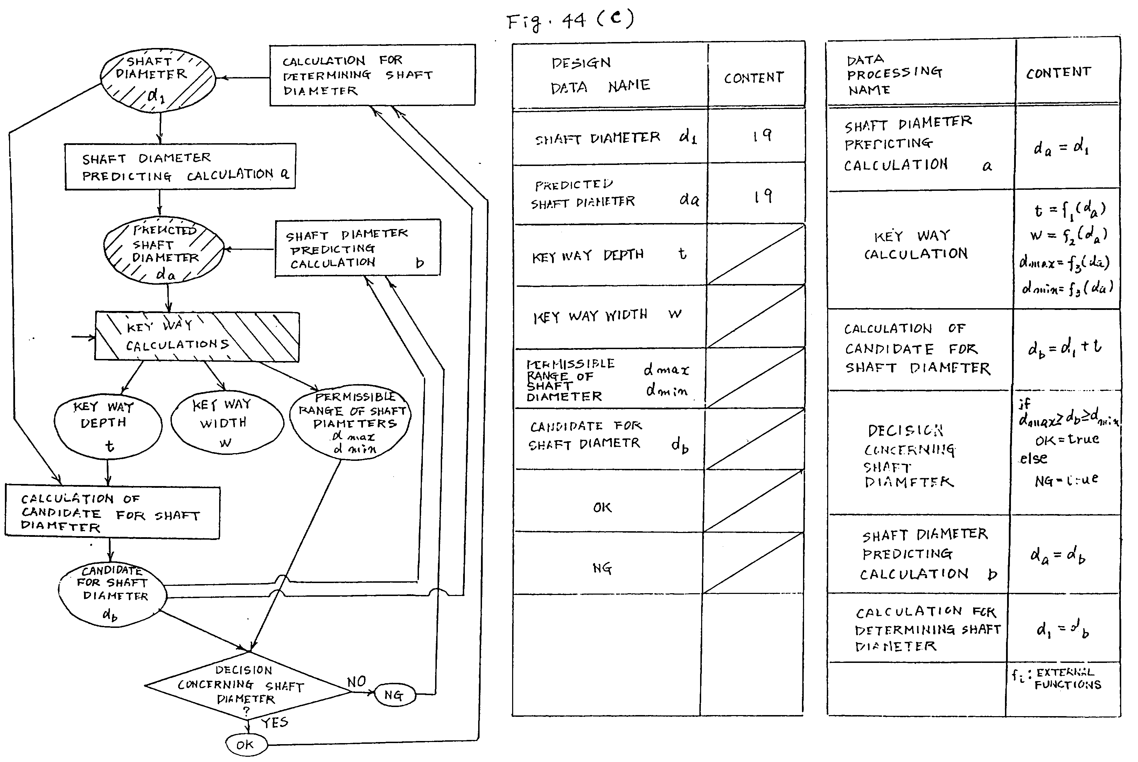

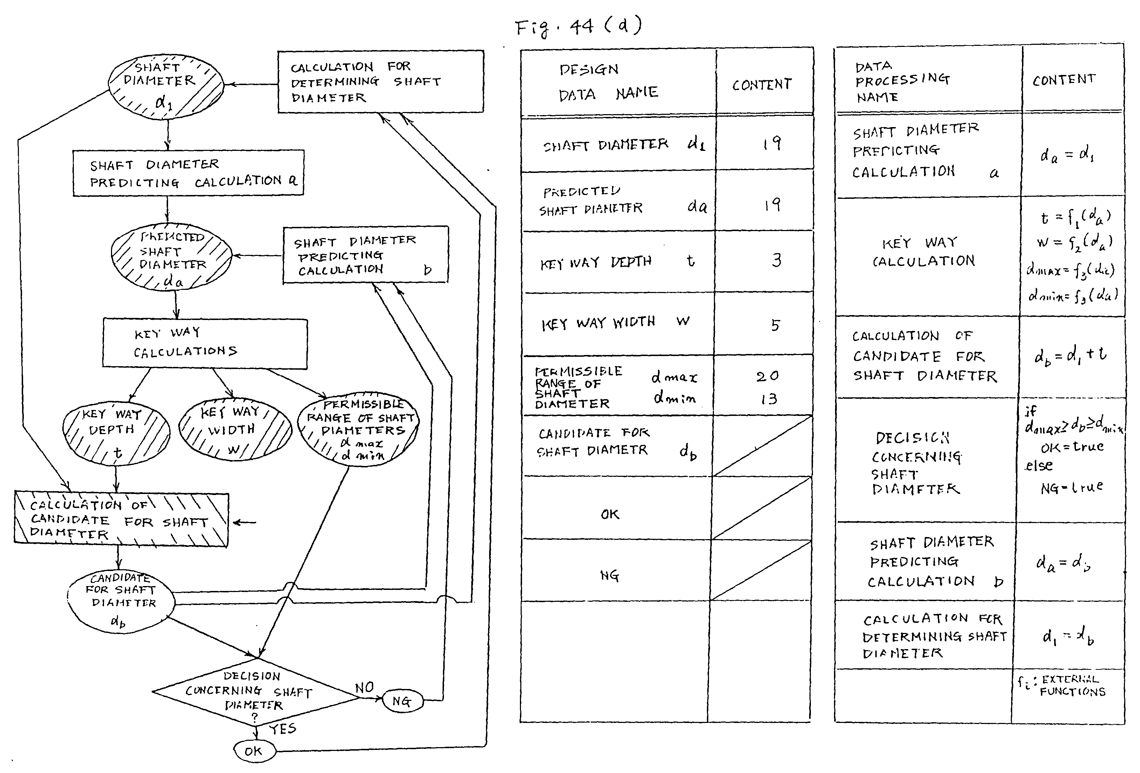

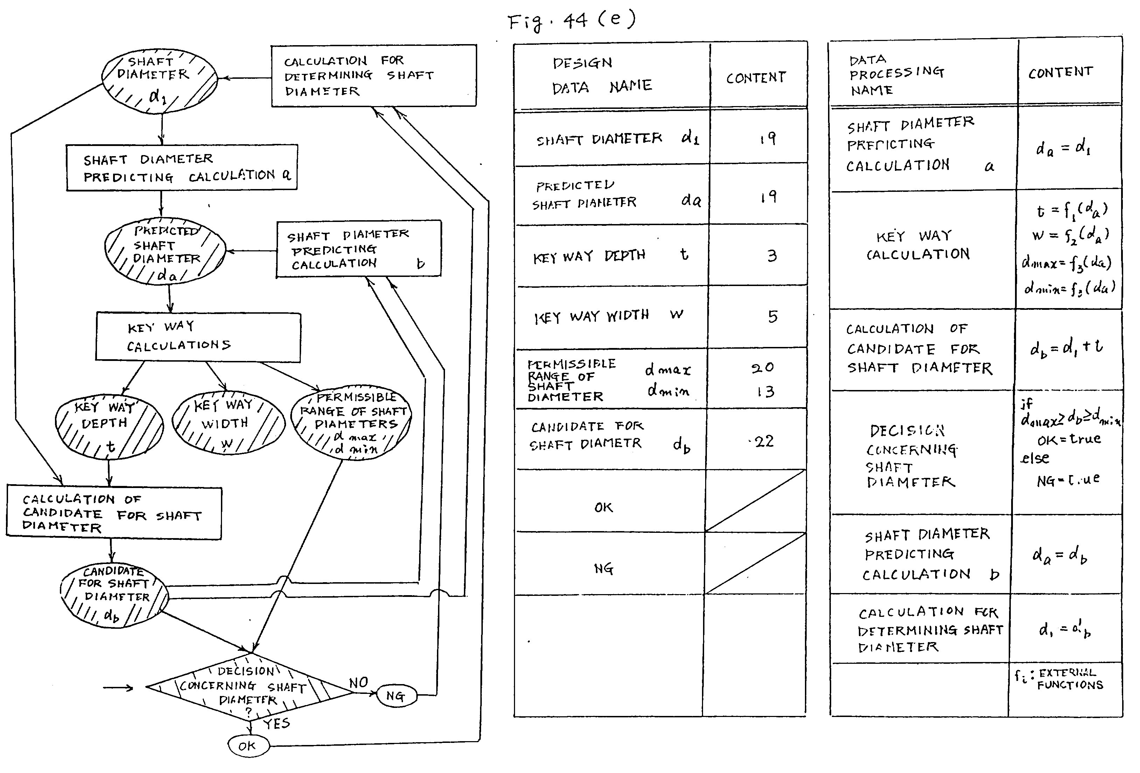

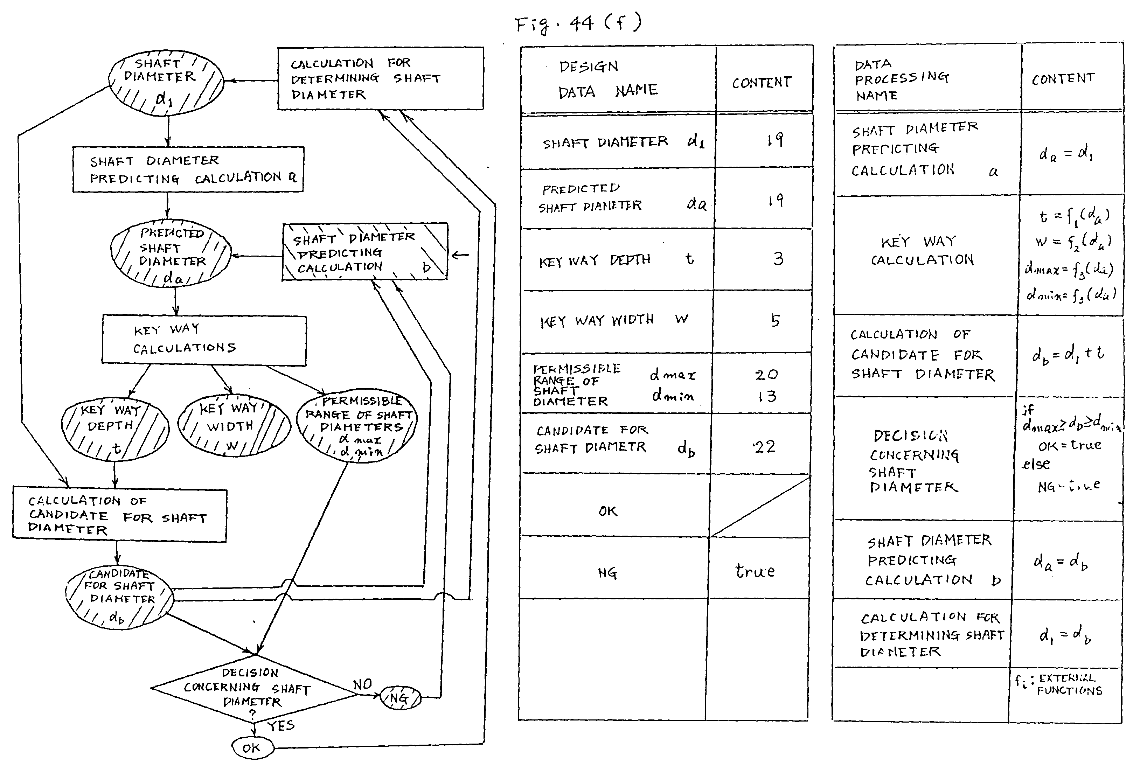

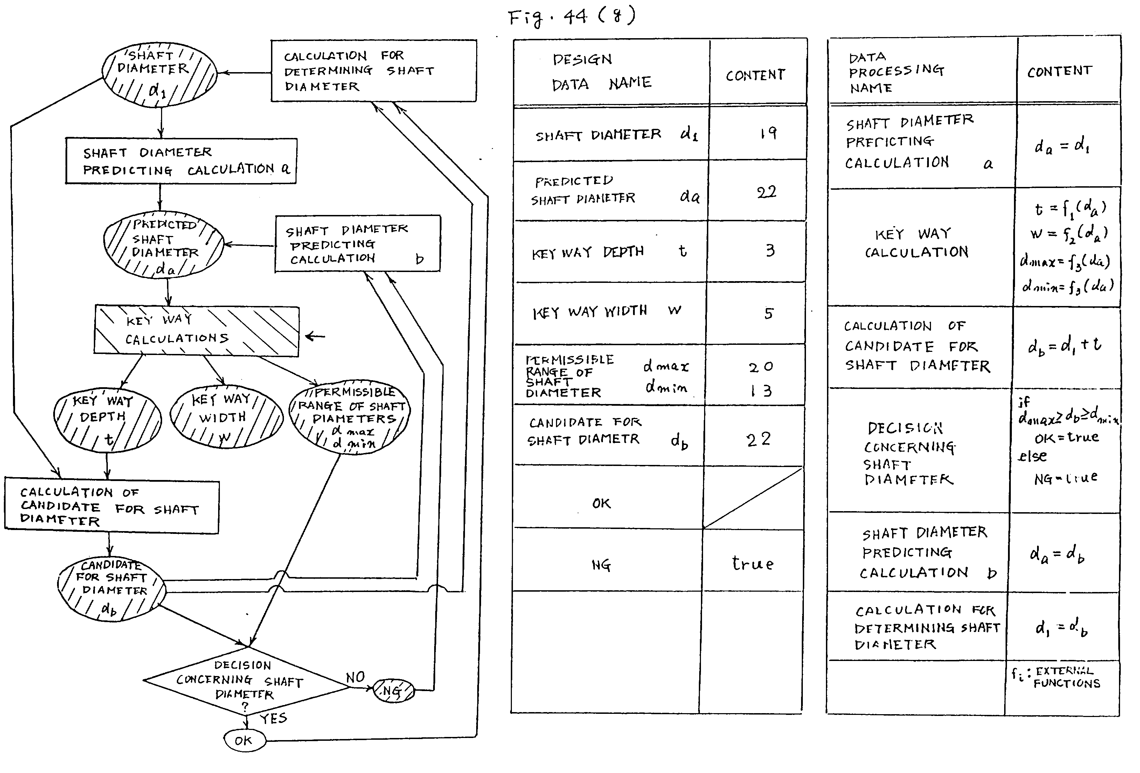

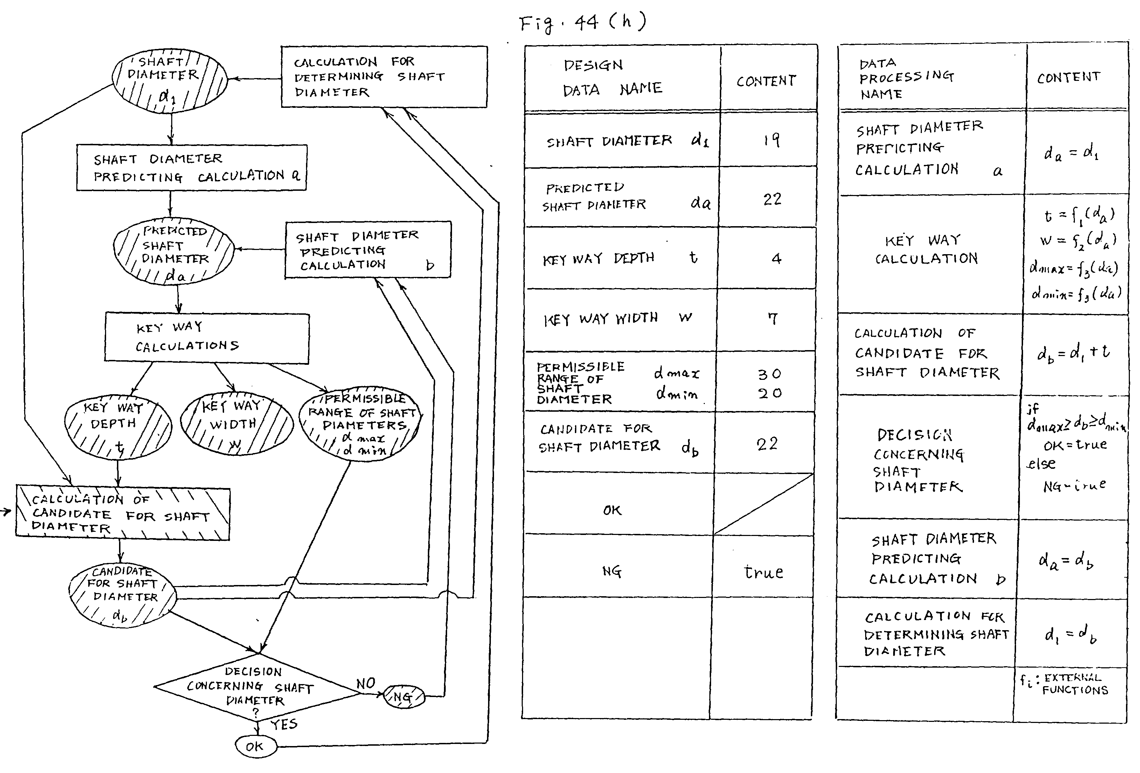

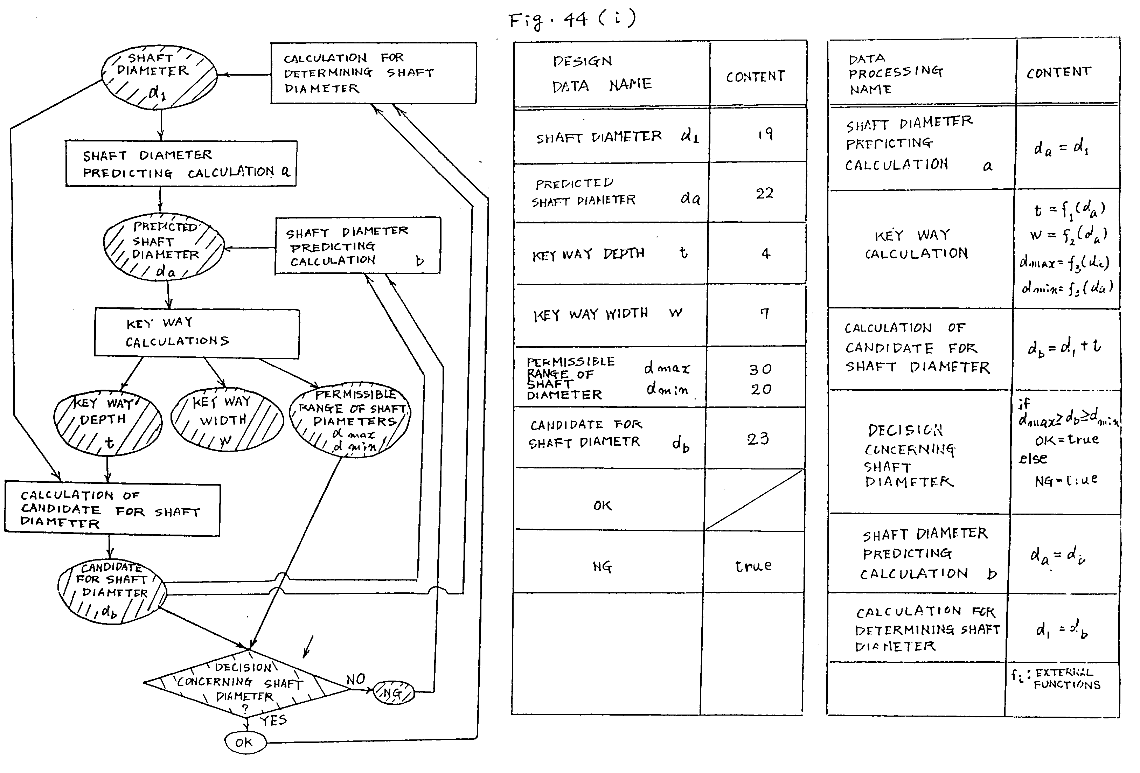

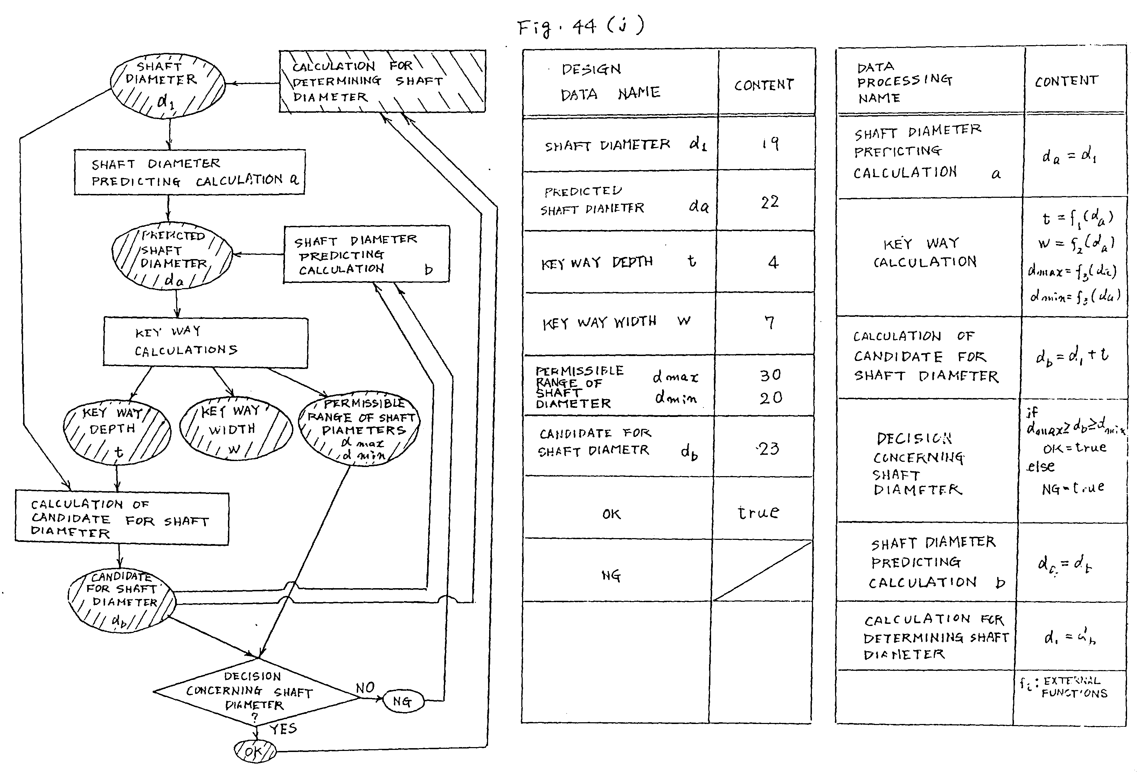

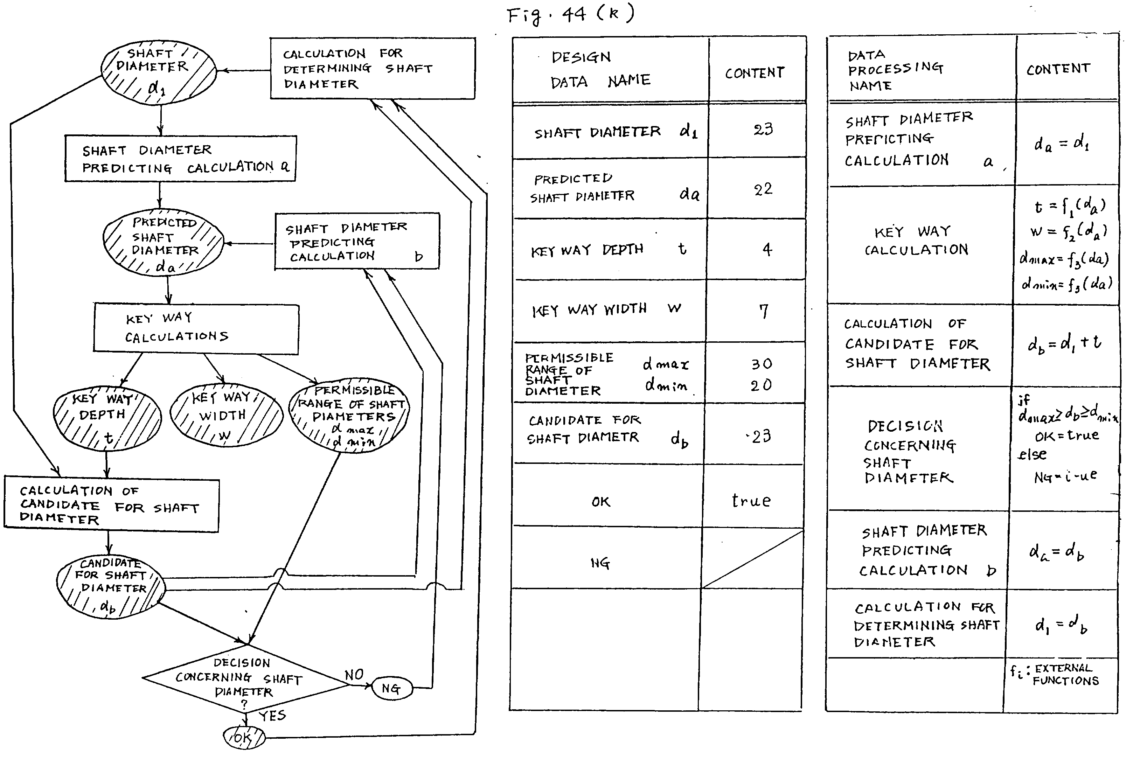

Figs. 44(a) to 44(k) are views for illustrating, by way of example, operation for the design calculation procedure including the decision processings executed by the embodiment shown in Fig. 16. More specifically, Figs. 44(a) to 44(k) show displays generated on the screen of the graphic terminal shown in Fig. 3, the contents stored in the design data content storage means 7 shown in Fig. 16 and the contents stored in the data processing content storage means 8 shown in Fig. 16. In Figs. 44(a) to 44(k), the names each enclosed by an ellipse represent the design data names, while the names each enclosed by a rectangle represent the data processing names, and the names each enclosed by a rectangule represent the discriminant processing names on the assumption that the same key way correcting calculation as that shown in Fig. 38(b) is performed. More specifically, on the basis of the shaft diameter d1 in which no consideration is paid to the key way, the shaft diameter for the shaft provided with the key way is predicted, wherein the depth and the width of the key way as well as the range of the applicable shaft diameters are determined on the basis of the predicted value of the shaft diameter. To this end, decision is made as to a candidate for the shaft diameter d1 corresponding to that of the shaft assumed to have no key way and added with the depth of the key way is within the range of the applicable shaft range. If the result of this decision is affirmative, the candidate for the shaft diameter is regarded as the corrected shaft diameter. Otherwise, the procedure mentioned above is repeated until the candidate falling within the range of the predicted values is found. In the state shown in Fig. 44(a), the design data names, the data processing names and the input/output relation information have been inputted with the data processing contents being additionally inputted. In the state shown in Fig. 44(b), the initial value of the content of the design data "shaft diameter d1" is inputted, as the result of which the data processing "shaft diameter predicting calculation a" is rendered executable. In the state illustrated in Fig. 44(c), the shaft predicting calculation a is executed by the data processing executing means 9, whereby the content of the design data "predicted value of the shaft diameter" is determined, as the result of which the data processing "key way calculation" is rendered to be executable. In the state illustrated in Fig. 44(d), the key way calculation (the content of which is not described in detail as an external function in the case of the instant example) is executed, whereby the contents of the design data "key way depth", "key way width" and "range of permissible shaft diameter" are determined, as the result of which the data processing "shaft diameter calculation" can be executed. In the state shown in Fig. 44(e), the shaft candidate calculation is executed by the data processing executing means 9, whereby the content of the design data "shaft diameter candidate" is determined, as the result of which the decision processing "shaft diameter decision" can be executed. In the state shown in Fig. 44(f), the shaft diameter decision step is executed by the data processing executing means 9, whereby the content of NG representing the design data out of the range of the shaft diameter candidates is determined, as the result of which the data processing "shaft diameter predicting calculation b" can be executed. In the state illustrated in Fig. 44(g), the shaft diameter predicting calculation is executed by the data processing executing means 9, whereby the content of the predicted shaft diameter is determined, as the result of which the data processing "key way calculation" is rendered to be executable. In the state shown in Fig. 44(h), the key way calculation is executed by the data processing executing means 9, whereby the design data "key way depth", "key way width" and "the permissible range of shaft diameter" are determined, as the result of which the data processing "shaft diameter candidate calculation" can be executed. In the state shown in Fig. 44(i), the shaft diameter candidate calculation is executed by the data processing executing means 9, whereby the content of the design data "shaft diameter candidate" can be determined, as the result of which the shaft diameter decision which is the result decision processing can be executed. In the state shown in Fig. 44(j), the shaft diameter decision is executed by the data processing executing means 9. Since the candidate for the shaft diameter lies with the permissible range, the content of the design data decided "OK" is determined, as the result of which the data processing "shaft diameter determining calculation" becomes executable. In the state shown in Fig. 44(k), the shaft diameter determining calculation is executed by the data processing executing means 9 to determine the content of the design data "shaft diameter", whereon the procedure processing is completed. According to the illustrated method, the results of the decision on processings can be explicitly expressed as the design data. By virtue of this feature, the decision as to the executability of the data processing can be made on the basis of only the design data inputted to that data processing to advantage.

## Claims

1. A design procedure supporting system, comprising: storage means (1) including a first storage part (52, 501) for storing names of design data, a second storage part (52, 502) for storing names of data processings and a third storage part (58, 503, 504) for storing information representing input/output relations between said design data and said data processings; and display means (111) for displaying a graph representing a plurality of design procedures including said design data names and said data processing names in the form of nodes and input/output relations between said design data and data processings in the form of arcs extending between said nodes.

2. A system according to claim 1, further comprising means (11) for inputting said design names, said data processing names and the information representing input/ output relations between said design data and said data processings.

3. A system according to any of claims 1 to 2, further comprising means (21) for selecting a particular one of said plurality of design procedures displayed on said display means.

4. A system according to claim 3, wherein the means for selecting a particular one of said plurality of design procedures is the means for selecting a particular one of a plurality of design procedures between two desired design data names in said graph including said plurality of the design procedures displayed on said display means.

5. A system according to any of claims 1 to 2, further comprising first operation means (9) for preparing network information including representations of said design data names and said data processing names in the form of nodes and representations of said input/output relations in the form of arcs extending between said nodes.

6. A system according to claim 5, further comprising: means (12) for inputting sequence relations among the plurality of data processings; and storage means (2) for storing said inputted sequence relations among the plurality of data processings.

7. A system according to claim 6, further comprising: second operation means for arithmetically determining sequence relations between particular design data and particular data processings or among particular design data or among particular data processings on the basis of the information representing input/output relations between the particular design data and the particular data processings or among the particular design data or among the particular data processings of said network information; and
third operation means for making a decision as to presence of a contradiction between the sequence relations among the data processings stored in said storage means and the sequence relations determined arithmetically by said operation means.

8. A system according to any of claims 1 to 2, further comprising retrieval means (3) for utilizing said design data names, said data processing names and information representing input/output relations between said design data and said data processings to thereby retrieve names of the data processings to be inputted with given design data on the basis of the name of said given design data, retrieve names of the data processings to be outputted by given design data on the basis of the name of said given design data, retrieve names of the design data to be inputted to a given data processing on the basis of the name of said given data processing and retrieve names of the design data to be outputted from a given data processing on the basis of the name of said given data processing.

9. A system according to claim 8, further comprising second storage means (2) for storing the names of the data processings to be executed on a time-serial basis.

10. A system according to claim 8, further comprising selecting means (21) for selecting the data processing to be executed from a plurality of the data processings which can be executed.

11. A system according to claim 6, further comprising: storage means for storing the contents of the design data in correspondence with the names of said design data,
third storage means (8) for storing the contents of the data processings in correspondence with the names of said data processings, and
means (9) for determining the content of the design data to be outputted from the data processing with the aid of the content of said data processing and the content of the design data to be inputted to said design processing.

12. A system according to any of claims 9 to 11, comprising means for expressing correspondence with a name of a given one of the data processings, detailed content of said given data processing by names of plural design data, names of plural data processings and information representing the input/output relations between said design data and said data processings, which is repeated to form a hierarchical structure.

13. A system according to any of claims 9 to 12, comprising means for discriminatively defining the data processing which outputs different design data in dependence on the contents of the design data as inputted as decision processing.

14. A system according to claim 6, further comprising selecting means for selecting only the names of the design data participating in the actually executed data processings, the names of said actually executed data processings and the input/output relations between said design data and said data processings.

15. A system according to any of claims 8 to 9, further comprising storage means for storing in correspondence with the names of the design data information representing whether or not the contents of said design data have been determined.

16. A design procedure supporting system for supporting a design procedure by using at least names of design data and names of data processings, comprising:
first storage means (1) for storing the names of the design data and the names of the data processings; second storage means (54) for storing attributes representing features of the design data in correspondence with the names of said design data;
third storage means (56) for storing attributes representing features of the design data inputted to and outputted from the data processings in correspondence with the names of said data processings; and
means (57) for establishing correspondences in terms of input/output relations between the names of said design data and the names of said data processings by making use of the attributes stored in said second storage means and attributes stored in said third storage means.

17. A design procedure supporting method for supporting a design procedure by storing at least names of design data, names of data processings and information representing the input/output relations between said design data and said data processings,
wherein the names of said design data, the names of said data processings and the information representing the input/output relations between said design data and said data processings are inputted and displayed on a graphic terminal in a graph expressing the names of said design data or the names of said data processings or both names of said design data and said data processings in the form of nodes while expressing said input/output relations in the form of arcs extending between said nodes.

18. A method according to claim 17, wherein the names of particular ones of said design data or the names of particular ones of said data processings are inputted on a graphic terminal.

19. A method according to claim 17 or 18, wherein the names of particular ones of said design data or the names of particular ones of said data processings are discriminatively displayed.

20. A method according to any of claims 17 to 19, wherein the names of said design data and said data processings expressed as the nodes are discriminated from each other by enclosing them with graphic patterns differing from each other.

## Patentansprüche

1. System zum Unterstützen eines Entwurfsvorganges mit: einer Speichereinrichtung (1) mit einem ersten Speicherteil (52, 501) zum Speichern von Namen von Entwurfsdaten, einem zweiten Speicherteil (52, 502) zum Speichern von Namen von Datenverarbeitungen und einem dritten Speicherteil (58, 503, 504) zum Speichern von Informationen, die Eingabe/Ausgabe-Beziehungen zwischen den Entwurfsdaten und den Datenverarbeitungen darstellen; und
einer Anzeigeeinrichtung (111) zum Anzeigen eines Graphs, der mehrere Entwurfsvorgänge darstellt einschließlich der Entwurfsdatennamen und der Datenverarbeitungsnamen in Form von Knoten sowie der Eingabe/ Ausgabe-Beziehungen zwischen den Entwurfsdaten und den Datenverarbeitungen in Form von Zweigen, die sich zwischen den Knoten erstrecken.

2. System nach Anspruch 1, das außerdem eine Einrichtung (11) zum Eingeben der Entwurfsnamen, der Datenverarbeitungsnamen und der die zwischen den Entwurfsdaten und den Datenverarbeitungen vorliegenden Eingabe/ Ausgabe-Beziehungen darstellenden Informationen aufweist.

3. System nach Anspruch 1 oder 2, das außerdem eine Einrichtung (21) zum Auswählen eines bestimmten der Entwurfsvorgänge, die auf der Anzeigeeinrichtung angezeigt werden, aufweist.

4. System nach Anspruch 3, bei dem die Einrichtung zum Auswählen eines bestimmten Entwurfsvorganges eine Einrichtung zum Auswählen eines bestimmten Entwurfsvorganges aus mehreren Entwurfsvorgängen zwischen zwei gewünschten Entwurfsdatennamen ist, die in dem Graph enthalten sind, der die auf der Anzeigeeinrichtung angezeigten mehreren Entwurfsvorgänge enthält.

5. System nach Anspruch 1 oder 2, das außerdem eine erste Ausführungseinrichtung (9) aufweist zum Erstellen einer Netzwerkinformation, die Darstellungen der Entwurfsdatennamen und der Datenverarbeitungsnamen in Form von Knoten aufweist sowie Darstellungen der Eingabe/Ausgabe-Beziehungen in Form von sich zwischen den Knoten erstreckenden Zweigen.

6. System nach Anspruch 5, das außerdem eine Einrichtung (12) aufweist zum Eingeben von Abfolgebeziehungen zwischen den mehreren Datenverarbeitungen; und eine Speichereinrichtung (2) zum Speichern der zwischen den verschiedenen Datenverarbeitungen herrschenden eingegebenen Abfolgebeziehungen.

7. System nach Anspruch 6, das außerdem aufweist:
eine zweite Ausführungseinrichtung zum arithmetischen Bestimmen von Abfolgebeziehungen zwischen bestimmten Entwurfsdaten und bestimmten Datenverarbeitungen oder zwischen bestimmten Entwurfsdaten oder zwischen bestimmten Datenverarbeitungen, auf der Grundlage der Information, die zwischen den bestimmten Entwurfsdaten und den bestimmten Datenverarbeitungen oder zwischen den bestimmten Entwurfsdaten oder zwischen den bestimmten Datenverarbeitungen der Netzwerkinformation herrschenden Eingabe/Ausgabe-Beziehungen darstellen; und
eine dritte Ausführungseinrichtung, die entscheidet, ob zwischen den in der Speichereinrichtung gespeicherten Abfolgebeziehungen unter den Datenverarbeitungen und den arithmetisch durch die Ausführungseinrichtung bestimmten Abfolgebeziehungen ein Widerspruch vorliegt.

8. System nach Anspruch 1 oder 2, das außerdem eine Wiedergewinnungseinrichtung (3) aufweist zum Verwenden der Entwurfsdatennamen, der Datenverarbeitungsnamen und der Informationen, die die Eingabe/Ausgabe-Beziehungen zwischen den Entwurfsdaten und den Datenverarbeitungen darstellen, um dadurch einzugebende Datenverarbeitungsnamen mit gegebenen Entwurfsdaten auf der Grundlage des Namens der gegebenen Designdaten wiederzugewinnen, um Namen von mittels gegebener Entwurfsdaten auszugebenden Datenverarbeitungen auf der Grundlage der Namen der gegebenen Entwurfsdaten wiederzugewinnen, um Namen von für eine gegebene Datenverarbeitung einzugebenden Entwurfsdaten auf der Grundlage des Namens der gegebenen Datenverarbeitung wiederzugewinnen, und um Namen von von einer gegebenen Datenverarbeitung auszugebenden Entwurfsdaten auf der Grundlage des Namens der gegebenen Datenverarbeitung wiederzugewinnen.

9. System nach Anspruch 8, das außerdem eine zweite Speichereinrichtung (2) zum Speichern der Namen der auszuführenden Datenverarbeitungen in zeitserieller Weise aufweist.

10. System nach Anspruch 8, das außerdem eine Auswahleinrichtung (21) aufweist, um aus mehreren ausführbaren Datenverarbeitungen die auszuführende Datenverarbeitung auszuwählen.

11. System nach Anspruch 6, das außerdem aufweist:
eine Speichereinrichtung zum Speichern der Inhalte der Entwurfsdaten entsprechend dem Namen der Entwurfsdaten,
eine dritte Speichereinrichtung (8) zum Speichern der Inhalte der Datenverarbeitungen entsprechend den Namen der Datenverarbeitungen, und
eine Einrichtung (9) zum Bestimmen des Inhalts der von der Datenverarbeitung auszugebenden Designdaten mit Hilfe des Inhalts der Datenverarbeitung und des Inhalts der in die Entwurfsverarbeitung einzugebenden Entwurfsdaten.

12. System nach einem der Ansprüche 9 bis 11, mit einer Einrichtung zum Ausdrücken einer Entsprechung mit einem Namen einer bestimmten Datenverarbeitung oder des genaueren Gehalts der bestimmten Datenverarbeitung mittels Namen mehrerer Entwurfsdaten, Namen mehrerer Datenverarbeitungen und Information, die die Eingabe/ Ausgabe-Beziehungen zwischen den Entwurfsdaten und den Datenverarbeitungen darstellt, was wiederholt wird, um eine hierarchische Struktur aufzubauen.

13. System nach einem der Ansprüche 9 bis 12, mit einer Einrichtung zum Definieren der Datenverarbeitung, die unterschiedliche Entwurfsdaten ausgibt in Abhängigkeit von den Inhalten der Entwurfsdaten, wie sie als Entscheidungsverarbeitung eingegeben wurden.

14. System nach Anspruch 6, das außerdem eine Auswahleinrichtung zum Auswählen lediglich derjenigen Namen von Entwurfsdaten aufweist, die an den gerade ausgeführten Datenverarbeitungen beteiligt sind, der Namen der gerade ausgeführten Datenverarbeitungen und der Eingabe/Ausgabe-Beziehungen zwischen diesen Entwurfsdaten und diesen Datenverarbeitungen.

15. System nach Anspruch 8 oder 9, das außerdem eine Speichereinrichtung aufweist, um entsprechend den Namen der Entwurfsdaten Informationen zu speichern, die darstellen, ob die Inhalte der Entwurfsdaten bestimmt wurden oder nicht.

16. System zum Unterstützen eines Entwurfsvorganges zum Unterstützen eines Entwurfsvorganges durch Verwendung zumindest von Namen von Entwurfsdaten und Namen von Datenverarbeitungen, mit:
einer ersten Speichereinrichtung (1) zum Speichern der Namen der Entwurfsdaten und der Namen der Datenverarbeitungen;
einer zweiten Speichereinrichtung (54) zum Speichern von Attributen, die Merkmale der Entwurfsdaten darstellen, entsprechend den Namen der Entwurfsdaten;
einer dritten Speichereinrichtung (56) zum Speichern von Attributen, die Merkmale der Entwurfsdaten darstellen, die in die Datenverarbeitungen eingegeben oder von diesen ausgegeben wurden, entsprechend den Namen der Datenverarbeitungen; und
einer Einrichtung (57) zum Ermitteln von Entsprechungen im Hinblick auf Eingabe/Ausgabe-Beziehungen zwischen den Namen der Entwurfsdaten und den Namen der Datenverarbeitungen, indem die in der zweiten Speichereinrichtung gespeicherten Attribute und die in der dritten Speichereinrichtung gespeicherten Attribute verwendet werden.

17. Verfahren zum Unterstützen eines Entwurfsvorganges zur Unterstützung eines Entwurfsvorganges, indem zumindest die Namen von Entwurfsdaten, die Namen von Datenverarbeitungen sowie Informationen gespeichert werden, die die Eingabe/Ausgabe-Beziehungen zwischen den Entwurfsdaten und den Datenverarbeitungen darstellen,
wobei die Namen der Entwurfsdaten, die Namen der Datenverarbeitungen und die Information, die die Eingabe/Ausgabe-Beziehungen zwischen den Entwurfsdaten und den Datenverarbeitungen darstellt, eingegeben werden und auf einem Graphikterminal angezeigt werden als Graph, der die Namen der Entwurfsdaten oder die Namen der Datenverarbeitungen oder beide Namen der Entwurfsdaten und der Datenverarbeitungen als Knoten darstellt, während die Eingabe/Ausgabe-Beziehungen in Form von sich zwischen den Knoten erstreckenden Zweigen dargestellt werden.

18. Verfahren nach Anspruch 17, bei dem die Namen bestimmter Entwurfsdaten oder die Namen bestimmter Datenverarbeitungen in ein Graphikterminal eingegeben werden.

19. Verfahren nach Anspruch 17 oder 18, bei dem die Namen bestimmter Entwurfsdaten oder die Namen bestimmter Datenverarbeitungen unterschiedlich dargestellt werden.

20. Verfahren nach einem der Ansprüche 17 bis 19, bei dem die als Knoten dargestellten Namen der Entwurfsdaten und der Datenverarbeitungen voneinander unterschieden werden, indem sie in unterschiedliche graphische Muster eingeschlossen werden.

## Revendications

1. Système d'aide à un processus de conception, comprenant :
un moyen de mémorisation (1) comportant une première partie de mémorisation (52, 501) servant à mémoriser des noms de données de conception, une deuxième partie de mémorisation (52, 502) servant à mémoriser des noms de traitements de données, et une troisième partie de mémorisation (58, 503, 504) servant à mémoriser des informations représentant des relations d'entrée/sortie entre lesdites données de conception et lesdits traitements de données ; et
un moyen d'affichage (111) servant à afficher un graphe qui représente une pluralité de processus de conception comportant lesdits noms de données de conception et lesdits noms de traitement de données sous la forme de noeuds et des relations d'entrée/sortie entre lesdites données de conception et lesdits traitements de données sous la forme d'arcs s'étendant entre lesdits noeuds.

2. Système selon la revendication 1, comprenant en outre un moyen (11) servant à appliquer en entrée lesdits noms de conception, lesdits noms de traitements de données et les informations représentant des relations d'entrée/sortie entre lesdites données de conception et lesdits traitements de données.

3. Système selon la revendication 1 ou 2, comprenant en outre un moyen (21) servant à sélectionner un processus de conception particulier parmi ladite pluralité de processus de conception affichés sur ledit moyen d'affichage.

4. Système selon la revendication 3, où le moyen de sélection d'un processus de conception particulier de ladite pluralité de processus de conception est le moyen servant à sélectionner un processus de conception particulier d'une pluralité de processus de conception entre deux noms de données de conception voulus dans ledit graphe comportant ladite pluralité des processus de conception affichés sur ledit moyen d'affichage.

5. Système selon la revendication 1 ou 2, comprennent en outre un premier moyen d'actionnement (9) servant à préparer des informations de réseau comportant des représentations desdits noms de données de conception et desdits noms de traitements de données sous la forme de noeuds et des représentations desdites relations d'entrée/sortie sous la forme d'arcs s'étendant entre lesdits noeuds.

6. Système selon la revendication 5, comprenant en outre :
un moyen (12) servant à appliquer en entrée des relations de succession entre les traitements de données de la pluralité de traitements de données ; et
un moyen de mémorisation (2) servant à mémoriser lesdites relations de succession appliquées en entrée qui existent entre les traitements de données de la pluralité de traitements de données.

7. Système selon la revendication 6, comprenant en outre :
un deuxième moyen d'actionnement servant à déterminer arithmétiquement des relations de succession entre des données de conception particulières et des traitements de données particuliers ou entre des données de conception particulières ou entre des traitements de données particuliers sur la base des informations représentant des relations d'entrée/sortie entre les données de conception particulières et les traitements de données particulières ou entre les données de conception particulières ou entre les traitements de données particuliers desdites informations de réseau ; et
un troisième moyen d'actionnement servant à prendre une décision relativement à la présence d'une contradiction entre les relations de succession qui sont formulées entre les traitements de données mémorisés dans ledit moyen de mémorisation et les relations de succession qui sont déterminées arithmétiquement par ledit moyen d'actionnement.

8. Système selon la revendication 1 ou 2, comprenant en outre un moyen d'extraction (3) servant à utiliser lesdits noms de données de conception, lesdits noms de traitements de données et des informations représentant des relations d'entrée/sortie entre lesdites données de conception et lesdits traitements de données afin d'extraire des noms des traitements de données à appliquer en entrée avec des données de conception données sur la base du nom desdites données de conception données, d'extraire des noms des traitements de données à délivrer par des données de conception données sur la base du nom desdites données de conception données, d'extraire des noms des données de conception à appliquer en entrée à un traitement de données donné sur la base du nom dudit traitement de données donné et d'extraire des noms des données de conception à délivrer à partir d'un traitement de données donné sur la base du nom dudit traitement de données donné.

9. Système selon la revendication 8, comprenant en outre un deuxième moyen de mémorisation (2) servant à mémoriser les noms des traitements de données à exécuter en série dans le temps.

10. Système selon la revendication 8, comprenant en outre un moyen de sélection (21) servant à sélectionner le traitement de données devant être exécuté parmi une pluralité des traitements de données qui peuvent être exécutés.

11. Système selon la revendication 6, comprenant en outre :
un moyen de mémorisation servant à mémoriser les contenus des données de conception en correspondance avec les noms desdites données de conception,
un troisième moyen de mémorisation (8) servant à mémoriser les contenus des traitements de données en correspondance avec les noms desdits traitements de données, et
un moyen (9) servant à déterminer le contenu des données de conception à délivrer à partir du traitement de données à l'aide du contenu dudit traitement de données et du contenu des données de conception à appliquer en entrée audit traitement de conception.

12. Système selon l'une quelconque des revendications 9 à 11, comprenant un moyen qui sert à exprimer la correspondance entre un nom d'un traitement donné parmi les traitements de données, le contenu détaillé dudit traitement de données donné par les noms de plusieurs données de conception, les noms de plusieurs traitements de données et des informations représentant les relations d'entrée/sortie entre lesdites données de conception et lesdits traitements de données, qui sont répétées de manière à former une structure hiérarchique.

13. Système selon l'une quelconque des revendications 9 à 12, comprenant un moyen servant à définir de manière distinctive le traitement de données qui délivre des données de conception différentes en fonction des contenus des données de conception tels qu'introduits au titre de traitement de décision.

14. Système selon la revendication 6, comprenant en outre un moyen de sélection qui ne sélectionne que les noms des données de conception participant aux traitements de données réellement exécutés, les noms desdits traitements de données réellement exécutés et les relations d'entrée/sortie entre lesdites données de conception et lesdits traitements de données.

15. Système selon la revendication 8 ou 9, comprenant en outre un moyen de mémorisation servant à mémoriser, en correspondance avec les noms des données de conception, des informations représentant le fait que les contenus desdites données de conception ont ou non été déterminés.

16. Système d'aide à un processus de conception permettant d'aider un processus de conception en utilisant au moins des noms de données de conception et des noms de traitements de données, comprenant :
un premier moyen de mémorisation (1) servant à mémoriser les noms des données de conception et les noms des traitements de données ;
un deuxième moyen de mémorisation (54) servant à mémoriser des attributs représentant des particularités des données de conception en correspondance avec les noms desdites données de conception ;
un troisième moyen de mémorisation (56) servant à mémoriser des attributs représentant des particularités des données de conception appliquées en entrée aux traitements de données et délivrées par ceux-ci en correspondance avec les noms desdits traitements de données ; et
un moyen (57) servant à établir des correspondances, en termes de relations d'entrée/sortie, entre les noms desdites données de conception et les noms desdits traitements de données en faisant usage des attributs mémorisés dans ledit deuxième moyen de mémorisation et des attributs mémorisés dans ledit troisième moyen de mémorisation.

17. Procédé d'aide à un processus de conception servant à aider un processus de conception par mémorisation d'au moins des noms de données de conception, des noms de traitements de données et des informations représentant les relations d'entrée/sortie entre lesdites données de conception et lesdits traitements de données,
où les noms desdites données de conception, les noms desdits traitements de données et les informations représentant les relations d'entrée/sortie entre lesdites données de conception et lesdits traitements de données sont appliqués à l'entrée d'un terminal graphique et affichés sur celui-ci selon un graphe exprimant les noms desdites données de conception ou les noms desdits traitements de données ou bien à la fois les noms desdites données de conception et ceux desdits traitements de données sous la forme de noeuds tout en exprimant lesdites relations d'entrée/sortie sous la forme d'arcs s'étendant entre lesdits noeuds.

18. Procédé selon la revendication 17, où les noms de données de conception particulières parmi lesdites données de conception ou les noms de traitements de données particuliers parmi lesdits noms de traitements de données sont appliqués en entrée sur un terminal graphique.

19. Procédé selon la revendication 17 ou 18, où les noms de données de conception particulières parmi lesdites données de conception ou les noms de traitements de données particuliers parmi lesdits traitements de données sont affichés de manière distinctive.

20. Procédé selon l'une quelconque des revendications 17 à 19, où les noms desdites données de conception et desdits traitements de données exprimés sous la forme des noeuds sont distingués les uns des autres par le fait qu'ils sont entourés par des motifs graphiques qui sont naturellement différents.
